(19) Europäisches Patentamt
European Patent Office
Office européen des brevets

(11) Publication number: **0 663 697 A1**

(12) **EUROPEAN PATENT APPLICATION published in accordance with Art. 158(3) EPC**

(21) Application number: **94921817.6**

(22) Date of filing: **26.07.94**

(86) International application number: **PCT/JP94/01229**

(87) International publication number: **WO 95/03629 (02.02.95 95/06)**

(51) Int. Cl.[6]: **H01L 29/786**, H01L 21/205, G02F 1/136

(30) Priority: **26.07.93 JP 184134/93**
**03.06.94 JP 122838/94**

(43) Date of publication of application: **19.07.95 Bulletin 95/29**

(84) Designated Contracting States: **DE FR GB IT NL**

(71) Applicant: **SEIKO EPSON CORPORATION**
**4-1, Nishishinjuku 2-chome**
**Shinjuku-ku**
**Tokyo 163 (JP)**

(72) Inventor: **MIYASAKA, Mitsutoshi**
**Seiko Epson Corporation**
**3-5, Owa 3-chome**
**Suwa-shi**
**Nagano 392 (JP)**
Inventor: **MATSUEDA, Yojiro**
**Seiko Epson Corporation**
**3-5, Owa 3-chome**
**Suwa-shi**
**Nagano 392 (JP)**
Inventor: **TAKENAKA, Satoshi**
**Seiko Epson Corporation**
**3-5, Owa 3-chome**
**Suwa-shi**
**Nagano 392 (JP)**

(74) Representative: **Hoffmann, Eckart, Dipl.-Ing.**
**Patentanwalt**
**Bahnhofstrasse 103**
**D-82166 Gräfelfing (DE)**

(54) **THIN FILM SEMICONDUCTOR DEVICE, ITS MANUFACTURE, AND DISPLAY SYSTEM.**

(57) A high-performance thin film semiconductor device and a simple method for manufacturing the device. After depositing a silicon film at a rate of deposition of 6 Å/min at 580°C, the film is thermally oxidized. As a result, a high-performance thin film semiconductor device can be easily and stably manufactured. A thin film semiconductor device which can be driven at a high speed under a low voltage is also provided. By using a short-channel TFT circuit having an LDD structure, the device can be operated at a high-speed under a low voltage. In addition, the power consumption of the device can be suppressed and the breakdown voltage of the device can be increased. By optimizing the highest impurity concentration LDD part and the highest impurity concentration, LDD length, and channel length of the source-drain part, the operating speed of the device can be further increased. When a display device or display system uses such a thin film semiconductor device, the driving signal can be at a TTL level or lower.

EP 0 663 697 A1

FIG. 3

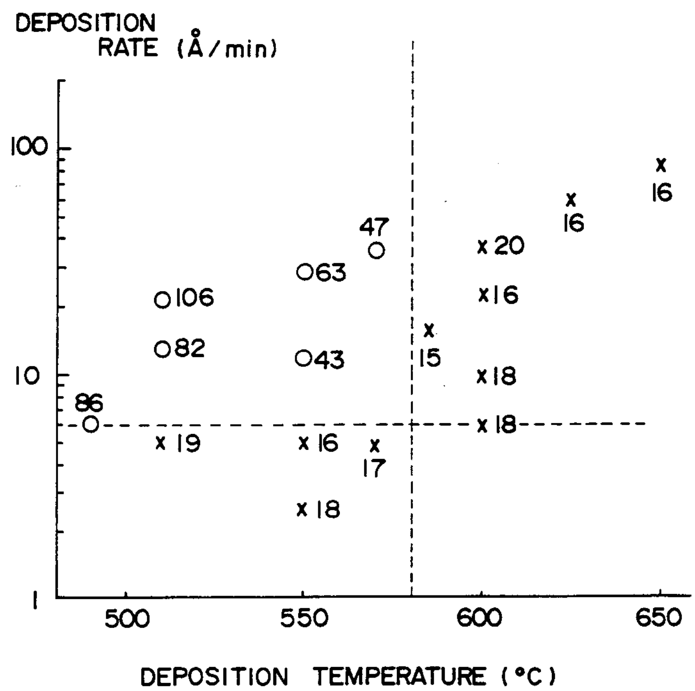
DEPOSITION RATE (Å/min)
100
10
1
500
550
600
650
DEPOSITION TEMPERATURE (°C)
47
O63
O106
O82
O43
86
x 19
x 16
x 17
x 18
x 15
x 20
x 16
x 18
x 18
x 16
x 16

## FIELD OF THE INVENTION

The present invention relates to a thin-film semiconductor device comprising a non-single-crystal semiconductor film, a method of fabricating such a thin-film semiconductor device, and a display system in which this thin-film semiconductor device is used.

## BACKGROUND OF THE INVENTION

Thin-film semiconductor devices that comprise non-single-crystal semiconductor films (including polycrystalline and amorphous semiconductor films) have recently come to be used in the display portions and peripheral circuitry of active matrix liquid crystal display devices. They are also used in image sensors and SRAM devices. Note that, in this context, "thin-film semiconductor device" is a generic term that could refer to a semiconductor film in itself, a thin-film transistor (TFT), or a CMOS type of TFT having a p-channel TFT and an n-channel TFT. In this document, it is sometimes referred to as a "thin-film semiconductor device" and sometimes simply as "TFT," as required.

When thin-film semiconductor devices are used in peripheral circuitry such as that of a liquid crystal display device, they are required to operate at high speed. If the operation speed of the thin film semiconductor devices is high enough to use them as the peripheral circuitry, they work as the switching thin-film semiconductor devices of the display portion and all the peripheral circuitry such as shift registers and analog switches can be simultaneously integrated onto the liquid crystal substrate with them.

If an increase in speed could be implemented for thin-film semiconductor devices, the range of applications of such thin-film semiconductor devices would be much wider than in the prior art. In other words, the application of such thin-film semiconductor devices is limited in the prior art to liquid crystal display devices, and it has been impossible to extend the application thereof to digital and analog circuits in which single-crystal MOSFETs are used. This is because a thin-film semiconductor device has a smaller carrier mobility than does a single-crystal MOSFET, and thus it is slower. However, if it is possible to plan a faster thin-film semiconductor device which operates at a speed comparable to that of a single-crystal MOSFET, thin-film semiconductor devices may be used in digital and analog circuits where only single-crystal MOSFETs are used in the prior art. A thin-film semiconductor device differs from a single-crystal MOSFET in that it is formed on an insulating substance. This means that it is not affected by the problems with the single-crystal MOSFET, such as noise being transmitted through the substrate or latch-up being caused by current flowing through the substrate. This also means that increasing the speed of a thin-film semiconductor device is a technical objective.

In order to implement an increase in speed of a thin-film semiconductor device, the problem described below must first be solved. An example of the configuration of such a thin-film semiconductor device is shown in Fig. 56A, with an equivalent circuit diagram of this thin-film semiconductor device being shown in Fig. 56B. In Fig. 56B, Rc1 and Rc2 denote the contact resistances of a contact portion 412 (a contact between wiring 408 and a source portion 404) and a contact portion 414 (a contact between wiring 410 and a drain portion 406). Rs is the source resistance of the source portion 404, Rch is the channel resistance of a channel portion 402, and Rd is the drain resistance of the drain portion 406. In order to increase the speed of this thin-film semiconductor device, it is first necessary to reduce the total value of the serially connected resistances Rc1, Rs, Rch, Rd, and Rc2 when the transistor is in ON state. If the total resistance when the transistor is in ON state is denoted by Ron, Ron is the sum of the on-state channel resistance Rch(on) and the overall parasitic resistance Rp of the rest of the components. In other words:

$$\begin{aligned} Ron &= Rch(on) + Rp \\ &= Rch(on) + (Rc1 + Rs + Rd + Rc2) \end{aligned}$$

Therefore, in order to achieve a faster thin-film semiconductor device, it is preferable that both the on-state channel resistance Rch(on) and the overall parasitic resistance Rp are reduced. In order to reduce Rch(on) it is necessary to find new fabrication methods of the semiconductor films which form the thin-film semiconductor device. More specifically, it would be advantageous to increase the carrier mobility of the semiconductor films and it would also be effective to shorten the channel portion 402. The resistances Rs and Rd may be reduced by either increasing the impurity concentration of the source portion and the drain portion, or improving the quality of the semiconductor films forming the source and drain portions. In order to reduce Rc1 and Rc2, it is possible to put barrier metal at the contact portion. It is, however, more effective to simply increase the impurity concentration of the source and drain portions rather than putting barrier metal, in view of simplifying the fabrication process.

In increasing the carrier mobility of the semiconductor films, it is preferable to employ a thin-film semiconductor device of polycrystalline silicon (polysilicon). A polycrystalline silicon thin-film semiconductor device generally has carrier mobility of at least approximately 10 $cm^2/V.s$, which is far higher than that of an amorphous silicon thin-film semiconductor device.

Three fabrication methods are known in the prior art as methods of fabricating a polycrystalline silicon thin-film semiconductor device of this type, as described below by way of example. With the first fabrication method, a polycrystalline silicon film is first deposited by a low-pressure chemical vapor deposition (LPCVD) method at a deposition temperature of approximately 600 °C or more. The size of the regions (islands) of which the polycrystalline silicon is composed ranges approximately from 20 nm to 80 nm. The polycrystalline silicon film surface is then thermally oxidized to form the semiconductor layer and gate insulation layer of the thin-film semiconductor device. The boundary surface roughness (center line average height, Ra) between the gate insulation film and gate electrode in this case is at least approximately 3.1 nm. One example of an n-channel type thin-film transistor made through this fabrication method has the carrier mobility of approximately 10 $cm^2/V.s$ to 20 $cm^2/V.s$. The average grain area (average area of the grains) of the semiconductor film is approximately 4,000 to 6,000 $nm^2$.

With the second fabrication method, an amorphous silicon film is first formed by plasma-enhanced CVD (PECVD). The amorphous silicon film is then annealed in a nitrogen atmosphere at the temperature of 600 °C for about from 20 hours to 80 hours. This annealing process converts the amorphous silicon film into a polycrystalline silicon film (solid-phase crystallization method). The surface of this polycrystalline silicon film is thermally oxidized to form a semiconductor layer and gate insulation layer of the thin-film semiconductor device. After the thin-film semiconductor device is structured, it is finally applied by a hydrogen plasma. In this case, an n-channel type thin-film transistor has the carrier mobility of approximately 150 $cm^2/V.s$ (refer to S. Takenaka, et al., Jpn. J. Appl. Phys. 29, L2380 (1990)).

With the third fabrication method, a polycrystalline silicon film is first deposited by LPCVD at a deposition temperature of 610 °C. $Si^+$ is implanted into this polycrystalline silicon film at a dose of approximately $1.5 \times 10^{15}$ $cm^{-2}$, which converts the polycrystalline silicon film into an amorphous film. The film is then annealed at 600 °C in a nitrogen atmosphere for several tens of hours to several hundreds of hours, so that the amorphous silicon recrystallizes to obtain a polycrystalline silicon film. The surface of this polycrystalline silicon film is then thermally oxidized to form a semiconductor layer and gate insulation layer of the thin-film semiconductor device. After the basic structure of the thin-film semiconductor device is completed, a hydrogenated silicon nitride (p-Si N:H) film is deposited by PECVD over the device, and then the device is annealed in a furnace at 400 °C to hydrogenate the device. In this case, an n-channel type thin-film transistor has the carrier mobility of approximately 100 $cm^2/V.s$ (refer to T. Noguchi, et al., J. Electrochemical Soc., 134, page 1771 (1987)).

However, each of the above described first to third fabrication methods has various inherent problems. The second fabrication method, which involves several tens of hours of furnace annealing after the amorphous silicon film is deposited, can provide a thin-film semiconductor device with high carrier mobility. This process is, however, remarkably long and causes serious fall in the productivity. In addition, since the initial semiconductor film is deposited by PECVD in this second fabrication method, very many particles are generated in the reaction chamber. These particles cause many defects of the devices, because they fall on the substrate during the deposition. Therefore, the yield is very poor. The third fabrication method, which involves the implantation of silicon atoms after the polycrystalline silicon film has been deposited and requires even longer furnace annealing, has an even longer and more complicated process than the above second fabrication method. If the process increases by even one step, that alone is sufficient to reduce the product yield. The need for several tens of hours to several hundreds of hours of furnace annealing is unrealistic from the mass-production point of view, and is thus not practicable.

On the other hand, the first fabrication method, which involves simple method of depositing a polycrystalline silicon film by LPCVD then the formation of a thin-film semiconductor device by thermal oxidation, is extremely useful from the points of view of mass production and stability, with an extremely simple process. However, as described previously, the first fabrication method has problems in that the average grain area of the polycrystalline silicon produced by this method is small at approximately 4,000 to 6,000 $nm^2$, and the carrier mobility is as low as at 10 $cm^2/V.s$ to 20 $cm^2/V.s$.

The description now turns to a consideration of how to reduce the contact resistance Rc and the resistances Rs and Rd. TFTs include a TFT of an ordinary structure and a lightly doped drain (hereinafter abbreviated to LDD) type of TFT. In order to reduce the overall parasitic resistance Rp, which is the sum of the resistances Rc1, Rc2, Rs, and Rd, and also in order to reduce the total resistance Ron in the transistor ON state, the present inventors consider that it is most preferable to use an LDD-type TFT.

A method of fabricating TFTs of an ordinary structure will first be described simply, with reference to Fig. 27. In this fabrication method, a gate insulation film 25 is first formed on thin semiconductor films 22 that have been patterned into islands on an insulating substrate 21, and gate electrodes 26 are formed thereover. Next, impurity ions that work as donors in the semiconductor films are implanted at high concentration into the thin semiconductor film which will be the source and drain regions of the n-channel TFT, to form thin $n^+$ semiconductor films 23. In the same manner, impurity ions that work as acceptor in the semiconductor film are implanted at high concentration into the thin semiconductor film, which will be the source and drain regions of the p-channel TFT, to form thin $p^+$ semiconductor films 24. Since this method implants the impurities by using the gate electrode as a channel mask, the resultant TFT is called a self-aligned TFT. A non-self-aligned TFT could equally well be produced by the first formation of thin $n^+$ semiconductor islands and thin $p^+$ semiconductor islands, containing appropriate impurities. These TFTs are covered with interlayer insulation film 27, and then wiring is patterned of thin metal films 28 to complete the TFTs of an ordinary structure.

Single-crystal MOSFETs possessing LDD structure are widely used in semiconductor integrated circuits which are made on single-crystal substrates. The MOSFETs with LDD structure can restrain the device from generating hot carriers and can also increase its reliability. The prior art techniques of LDD-type MOSFETs are described in, for example, Japanese Patent Application Laid-Open Nos. 2-58274 and 2-45972. Prior art fabrication methods for LDD-type MOSFETs are described in, for example, Japanese Patent Application Laid-Open Nos. 62-241375 and 62-234372. Since the diffusion coefficient of the impurities in the single-crystal semiconductor material is low, the LDD length can be shorten to approximately one-tenth of the channel length. Therefore, the source-drain current of the transistor on-state (ON-current) of an LDD-type MOSFET is reduced to only about one-tenth of that of an ordinary-structure MOSFET. In contrast, since TFTs use non-single-crystal thin semiconductor films, the impurity ions acceleratingly diffuse along the grain boundaries of the semiconductor films. This means the actual diffusion coefficient in poly-Si films increases with the amount of at least one order of magnitude over that in the single-crystal semiconductor. Therefore, the LDD length of the LDD-type TFT should be long, and the high electric resistance of this LDD portion causes a problem in that the ON current becomes one-half or less than that of a TFT of an ordinary structure. That is why the prior art LDD-type TFT has not been used in circuits that are required to operate at high speeds.

In the self-aligned TFTs of the ordinary structure shown in Fig. 27, impurities are implanted at high concentration into the source and drain portions. Therefore, the parasitic resistance at the source and drain regions is low, while another problem occurs to prevent increase in operation speed of the circuits. The previously described accelerated diffusion increases parasitic capacitance of the TFT between gate and source/drain overlapped regions, resulting in the increase of MOS capacitance. Taking the example shown in Fig. 27, an overlapping portion of the n-channel TFT indicated by Yjn and an overlapping portion of the p-channel TFT indicated by Yjp each form parasitic capacitance. The effective n-channel channel length Leffn and the effective p-channel channel length Leffp are the lengths obtained by subtracting twice the corresponding overlapping portion Yjn or Yjp from the n-channel gate electrode length (see Fig. 27; note that this is sometimes called the gate electrode width) Lgaten or the p-channel gate electrode length Lgatep. Taking a polysilicon TFT as an example, when we want an effective channel length of 4 $\mu$m, a gate electrode length of at least 6 $\mu$m is required because these overlapping portions are at least 1 $\mu$m long. This means the increase in the load capacitance of the TFTs by at least a factor of 1.5 compared to the originally desired device, resulting in the reduction of the operating speed to two-thirds or less of the original speed. For this reason, it has not been advisable to increase the operating speed with an ordinary self-aligned TFT of the prior art.

As described above, it has been impossible to use the prior art LDD-type TFT in a circuit that is required to operate at high speed. A prior art technique for integrating TFTs into the peripheral circuitry of a liquid crystal display device that is required to operate at high speed is known from Japanese Patent Application Laid-Open No. 5-173179, but even this prior art technique uses TFTs of the ordinary structure shown in Fig. 27 in the peripheral circuitry. This is because prior art LDD-type TFTs are not suitable for high-speed operation, as described above. On the other hand, LDD-type TFTs are used in the display portion. This is because the liquid crystal of this display portion is a high-resistance material, so it is necessary to restrain the OFF current of the pixel TFTs.

A further prior art technique for using LDD-type TFTs in peripheral circuitry, not just a display portion, is disclosed in Japanese Patent Application Laid-Open No. 6-102531. However, even this prior art technique operates on the premise that the ON current of each LDD-type TFT is small. This ON current is increased by adding novel processing steps such as solid-phase crystallization and hydrogenation (refer to lines 26 to 36 of the left column of page 7 of Japanese Patent Application Laid-Open No. 6-102531). In other words, although the utilization of an LDD structure in the prior art has the advantage of preventing leakage currents, it has to have additional novel processing steps in order to compensate for the low ON-current which is one bad results from the utilization of the LDD structure. This patent discloses, for example, that the impurity dose implanted into the LDD region by this prior art technique should be $1 \times 10^{14}$ $cm^{-2}$ or less (refer to lines 45 to 48 of the left column of page 5). However, this numerical limit is not intended for optimizing the ON/OFF current ratio; it is nothing more than a numerical limit for simply reducing the OFF current and restraining leakage currents. Therefore, the ON current cannot be increased with the above limit even though the OFF current can be reduced. This is because, as the impurity dose implanted into the LDD region becomes smaller, the resistance of this LDD region increases and the ON current decreases. Similarly, with this prior art technique, the impurity dose implanted into the source and drain portions is disclosed to be in the range of between $1 \times 10^{14}$ and $1 \times 10^{17}$ $cm^{-2}$ (refer to lines 11 to 14 of the right column of page 5). However, this numerical limit is neither intended for optimizing the diffusion length due to accelerated diffusion, nor reducing the resistances Rc, Rs, and Rd. Furthermore, the description of this prior art technique concerns a channel length that is set to 6 $\mu$m; it discloses nothing about a technique of reducing the channel length of a TFT by making the channel length 5 $\mu$m or less.

As described above, with this prior art example of an LDD-type TFT, it is impossible to increase the ON current, and to design a reduction in the parasitic resistances Rc, Rs, and Rd while optimizing the diffusion length, and further it is impossible to design a reduction in channel length. This means that there is a problem in that it is impossible to apply these TFTs to high-speed circuit without adding novel processing steps such as solid-phase crystallization. It is therefore desirable to provide an LDD-type TFT which can operate at high speed but which does not require the addition of such novel processing steps, or an LDD-type TFT which can operate at even higher speeds by the addition of such novel processing steps.

The present invention is designed with the intention of solving the above described technical problems, and has an objective thereof the provision of a thin-film semiconductor device which can be fabricated by a simple, effective process and which also has good characteristics. The present invention is also intended to provide a method of fabricating such a thin-film semiconductor device and a display device using this thin-film semiconductor device.

Another objective of the present invention is to provide an LDD-type thin-film semiconductor device that is capable of operating at high speed without requiring the addition of any novel processing steps. The present invention is also intended to provide a method of fabricating such a thin-film semiconductor device and a display device using this thin-film semiconductor device.

A further objective of the present invention is to implement higher speeds for thin-film semiconductor devices, and provide a thin-film semiconductor device that can be used in the digital and analog circuits that used single-crystal MOSFETs in the prior art, thus broadening the field of application of such thin-film semiconductor devices, and a method of fabricating this thin-film semiconductor device.

## DISCLOSURE OF THE INVENTION

In order to achieve the above described objectives, a first aspect of the present invention concerns a method of fabricating a thin-film semiconductor device comprising a non-single-crystal semiconductor film formed on an insulating material portion which covers at least one portion of a surface of a substrate, comprising the step of: depositing a semiconductor film by a chemical vapor deposition method under conditions that retard the generation rate of nuclei that act as seeds for film formation and accelerate the growth rate of islands formed from the nuclei.

This first aspect of the present invention takes account of the fact that nucleus generation and island growth are competing. Retarding the nucleus generation rate while accelerating the island growth rate during the deposition of a semiconductor film ensures that the islands grow fast to cover the insulating substance before a large number of nuclei are generated on the insulating substance. This ensures that the island regions are large, so that it is possible to enlarge the area of the grains which appear after the semiconductor film is annealed. This enables an increase in the carrier mobility of the thin-film semiconductor device. Another effect of making the island regions large is the way in which the semiconductor film surface becomes smooth. Thus the present invention enables a dramatic improvement in the characteristics of a thin-film semiconductor device only using an extremely simple process, in which a silicon film is formed by a chemical vapor deposition method alone, and without using complicated and unnecessary processes such as silicon ion implantation, lengthy furnace annealing, or hydrogenation. Note that the semiconductor film deposited by the method in accordance with the present invention is not limited to an amorphous film. It was unknown that amorphous films are composed of these island regions, until the inventors verified the presence of these, using an atomic force microscope (AFM).

In this case, the present invention further specifies that it is preferable that the nucleus generation rate is controlled in accordance with the deposition temperature and the island growth rate is controlled in accordance with the deposition rate. It is also preferable that the deposition temperature is 580 °C or less and the deposition rate is 6 Å/minute or more. In other words, the island regions can be made extremely large by setting the deposition temperature and deposition rate to within the above ranges. The nucleus generation rate could be controlled by means such as a suitable choice of the type of substrate. The deposition rate could be determined by, for example, the flow rate of the reactant gas or the deposition pressure.

According to a second aspect of the present invention, the deposition temperature is preferably 550 °C or less. In other words, it is possible to maximize the average grain area by setting the deposition temperature to 550 °C or less.

According to a third aspect of the present invention, the deposition temperature is more preferably 530 °C or less. In other words, it is possible to reduce defects within the crystals by setting the deposition temperature to 530 °C or less. Note that the lower limit of the deposition temperature can be set to suit the type of reactant gas such that, for example, it is 460 °C for mono-silane or 370 °C for di-silane.

According to a fourth aspect of the present invention, either mono-silane ($SiH_4$) or di-silane ($Si_2H_6$) could be used as at least one type of reactant gas while the semiconductor film is being deposited by the chemical vapor deposition method. The basic principle of the present invention is not much affected by the type of reactant gas used, and thus other reactant gases may be used.

A fifth aspect of the present invention further comprises a step of subjecting a surface of the semiconductor film to thermal oxidation, after the semiconductor film deposition step. This thermal oxidation provides an oxide film and also, if the semiconductor film is in an amorphous state, for example, converts it into a polycrystalline state.

A sixth aspect of the present invention further comprises a step of irradiating the semiconductor film with optical energy or electromagnetic-wave energy, after the semiconductor film deposition step, wherein the maximum processing temperature after the irradiation step is 350 °C or less. The use of such a low-temperature process in accordance with this aspect of the present invention means that inexpensive glass can be used as the substrate, and also warping of the substrate under its own weight can be prevented.

In this case, a step of annealing the semiconductor film at a temperature of 600 °C or less could be included after the semiconductor film deposition step, and the maximum processing temperature after the annealing step could be held to 600 °C or less. By combining this low-temperature process with solid-phase crystallization, it is possible to obtain a semiconductor film of an even higher quality. Note that the maximum processing temperature after the annealing step in this case is more preferably 350 °C or less.

A seventh aspect of the present invention further comprises a step of annealing the semiconductor film at a temperature in the range of between 500 °C and 700 °C, after the semiconductor film deposition step. Annealing the semiconductor film in such a manner in accordance with the present invention ensures that, for example, a semiconductor film in an amorphous state, can be converted it into a polycrystalline state at a comparatively low temperature. This makes it possible to obtain a thin-film semiconductor device having even better quality characteristics. Note that the temperature range for the annealing in this case is more preferably between 550 °C and 650 °C.

A eighth aspect of the present invention concerns a thin-film semiconductor device comprising a non-single-crystal semiconductor film formed on an insulating material portion which covers at least one portion of a surface of a substrate, wherein the average grain area when the semiconductor film is in a polycrystalline state is at least 10,000 $nm^2$.

Since the average grain area in accordance with the present invention is large, the carrier mobility can be increased, thus enabling an increase in speed of the thin-film semiconductor device.

A ninth aspect of the present invention concerns a thin-film semiconductor device comprising a non-single-crystal semiconductor film formed on an insulating material portion which covers at least one portion of a surface of a substrate, wherein the average area of islands grown from nuclei that act as seeds for forming the semiconductor film is at least 10,000 $nm^2$.

Since the average island area in accordance with the present invention is large, the average grain area appeared after annealing, for example, can also be made large, thus enabling an increase in speed of the thin-film semiconductor device. In addition, the present invention has the further advantage that it makes the surface of the semiconductor film smooth.

A tenth aspect of the present invention concerns a thin-film semiconductor device comprising a non-single-crystal semiconductor film formed on an insulating material portion which covers at least one portion of a surface of a substrate, wherein the boundary surface roughness (center line average height, Ra) between a gate insulation film formed by thermal oxidation of the semiconductor film and a gate electrode formed on the gate insulation film is no more than 2.00 nm.

Since the center line average height, Ra, in accordance with the present invention is no more than 2.00 nm, when the gate insulation film is formed on the semiconductor film, the gate insulation film has a smooth surface, resulting in high breakdown voltage between source and gate. This reduces the number of faults such as pixel defects. In addition, the thermal oxidation temperature can be reduced, enabling the implementation of both lower costs and more fine and high-density processing. Also, the low oxidation temperature extend the lifetime of the fabrication apparatus as well as makes their maintenance easier.

An eleventh aspect of the present invention concerns a thin-film semiconductor device comprising a non-single-crystal semiconductor film formed on an insulating material portion which covers at least one portion of a surface of a substrate, wherein:

the semiconductor film comprises a first impurity-doped semiconductor film located in source and drain portions of a thin-film transistor and a high-resistance second impurity-doped semiconductor film located in at least one area between drain and channel portions or between source and channel portions of the thin-film transistor, and

the maximum impurity concentration of the second impurity-doped semiconductor film is in the range of between $1 \times 10^{18}$ $cm^{-3}$ and $1 \times 10^{19}$ $cm^{-3}$.

In accordance with this aspect of the present invention, the use of an LDD structure enables the implementation of a thin-film semiconductor device that has a shorter channel, that works with a higher speed, and that heighten a breakdown voltage between source and drain. In order to achieve this, the maximum impurity concentration of the second impurity-doped semiconductor film, that is, the LDD portion, should be optimized. In other words, the breakdown voltage can be heightened by setting this maximum impurity concentration to be $1 \times 10^{19}$ $cm^{-3}$ or less. On the other hand, the sheet resistance of the LDD portion can be reduced and consequently the ON current can be prevented from dropping by setting this maximum impurity concentration to $1 \times 10^{18}$ $cm^{-3}$ or more. In this case, to achieve further optimization, it is preferable to set the maximum impurity concentration to be in the range of between $2 \times 10^{18}$ $cm^{-3}$ and $5 \times 10^{18}$ $cm^{-3}$, since this enables an optimum ratio between ON current and OFF current.

A twelfth aspect of the present invention concerns a thin-film semiconductor device comprising a non-single-crystal semiconductor film formed on an insulating material portion which covers at least one portion of a surface of a substrate, wherein:

the semiconductor film comprises a first impurity-doped semiconductor film located in source and drain portions of a thin-film transistor and a high-resistance second impurity-doped semiconductor film located in at least one area between drain and channel portions or between source and channel portions of the thin-film transistor, and

the maximum impurity concentration of the first impurity-doped semiconductor film is in the range of between $5 \times 10^{19}$ $cm^{-3}$ and $1 \times 10^{21}$ $cm^{-3}$.

In accordance with this aspect of the present invention, the maximum impurity concentration of the first impurity-doped semiconductor film, that is, the source and drain portions, is optimized. In other words, diffusion of impurities from the source and drain portions into the LDD portion can be restrained and the breakdown voltage between the source and drain portions of the thin-film semiconductor device can be heightened by setting this maximum impurity concentration to be $1 \times 10^{21}$ $cm^{-3}$ or less. On the other hand, both the contact resistance and the source and drain resistance can be reduced, that can result in the fast work of the thin-film semiconductor device by setting this maximum impurity concentration to be $5 \times 10^{19}$ $cm^{-3}$ or more. In this case, to achieve further optimization, it is preferable to set the maximum impurity concentration to be in the range of between $1 \times 10^{20}$ $cm^{-3}$ and $3 \times 10^{20}$ $cm^{-3}$, since this enables the implementation of faster operation of the devices and even further miniaturization of components, while making the breakdown voltage high.

A thirteenth aspect of the present invention concerns a thin-film semiconductor device comprising a non-single-crystal semiconductor film formed on an insulating material portion which covers at least one portion of a surface of a substrate, wherein:

the semiconductor film comprises a first impurity-doped semiconductor film located in source and drain portions of a thin-film transistor and a high-resistance second impurity-doped semiconductor film located in at least one area between drain and channel portions or between source and channel portions of the thin-film transistor, and

an LDD length in the drain portion or the source portion is in the range of between 0.6 $\mu$m and 4 $\mu$m.

The present invention implements miniaturization of components by setting the LDD length to be 4 $\mu$m or less. Setting the LDD length to 0.6 $\mu$m or more would prevent the effective LDD length from disappearing, which is caused from the diffusion of impurities from the source and drain portions, thus prevents further any lowering of the breakdown voltage. In this case, to achieve further optimization, it is preferable that this LDD length is in the range of between 1 μm and 2 μm.

A fourteenth aspect of the present invention concerns a thin-film semiconductor device comprising a non-single-crystal semiconductor film formed on an insulating material portion which covers at least one portion of a surface of a substrate, wherein:

the semiconductor film comprises a first impurity-doped semiconductor film located in source and drain portions of a thin-film transistor and a high-resistance second impurity-doped semiconductor film located in at least one area between drain and channel portions or between source and channel portions of the thin-film transistor, and

the length of a gate electrode formed on the semiconductor film with a gate insulation film in between is 5 μm or less.

In accordance with this aspect of the present invention, the channel can be decreased in length as the gate electrode length is set to 5 μm or less, so that some reduction in the ON current caused by the use of the LDD structure can be sufficiently compensated for, thus enabling faster operation of the devices. In this case, the gate electrode length is preferably 3 μm or less. This is not only because such a short channel length can further increase the operation speed of the device, but also because the supply voltage to the device can be reduced.

A fifteenth aspect of the present invention concerns a thin-film semiconductor device comprising a non-single-crystal semiconductor film formed on an insulating material portion which covers at least one portion of a surface of a substrate, wherein:

the semiconductor film comprises a first impurity-doped semiconductor film located in source and drain portions of a thin-film transistor and a high-resistance second impurity-doped semiconductor film located in at least one area between drain and channel portions or between source and channel portions of the thin-film transistor, and

when an LDD length of a drain portion is Llddd and the distance from an edge thereof on a channel portion side of a contact hole in the drain portion to a gate electrode is Lcontd, the following relationship applies:

$$0.8 \times \text{Llddd} \leqq \text{Lcontd} \leqq 1.2 \times \text{Llddd}.$$

In accordance with this aspect of the present invention, Lcontd can be set to a range of ± 20% of Llddd. This makes it possible to prevent any excessive increase in the contact resistance, and also to reduce the parasitic resistance based on factors such as the resistance of the LDD portion.

In a similar manner, when the LDD length of a source portion is Lldds and the distance from an edge thereof on a channel portion side of a contact hole in the source portion to a gate electrode is Lconts, the following relationship is preferable:

$$0.8 \times \text{Lldds} \leqq \text{Lconts} \leqq 1.2 \times \text{Lldds}.$$

A sixteenth aspect of the present invention concerns a p-type thin-film transistor having first and second impurity-doped semiconductor films in which the implanted impurities are p-type and an n-type thin-film transistor having first and second impurity-doped semiconductor films in which the implanted impurities are n-type. This CMOS configuration enables an apparatus that is faster but consumes less power, so that it can provide the optimum thin-film semiconductor device for use in the peripheral circuitry of a liquid crystal display device, for example.

In this case, the gate electrode length of the p-type thin-film transistor is preferably shorter than the gate electrode length of the n-type thin-film transistor. This enables a balance between the ON currents of the p-type and n-type thin-film transistors, and also, because circuits can be configured with the same channel width, the implementation of high-density circuits.

It is also preferable that the channel width of the n-type thin-film transistor is smaller than the channel width of the p-type thin-film transistor. This enables an even further increase in speed because of balancing the ON currents. If, for example, all the gate electrode lengths could be set to the minimum dimensions of the design rules, management of the fabrication process would become easier.

In the above described case, the gate electrode length of the p-type thin-film transistor and the gate electrode length of the n-type thin-film transistor are each preferably 5 μm or less, because this implements a further increase in speed of the TFTs.

A seventeenth aspect of the present invention concerns a method of fabricating a thin-film semiconductor device comprising a non-single-crystal semiconductor film formed on an insulating material portion which covers at least one portion of a surface of a substrate, comprising the steps of:

implanting an impurity by using a gate electrode as a mask and implanting an impurity by using a photoresist as a mask, wherein:

an impurity dose implanted by using the gate electrode as a mask is in the range of between $1 \times 10^{13}$ $cm^{-2}$ and $1 \times 10^{14}$ $cm^{-2}$, and an impurity dose implanted by using the photoresist as a mask is in the range of between $5 \times 10^{14}$ $cm^{-2}$ and $1 \times 10^{16}$ $cm^{-2}$.

In accordance with this aspect of the present invention, impurities can be implanted at a low energy but with a high throughput. Moreover, the LDD length can be freely set, so that the LDD structure can be formed only as necessary in required areas, thus increasing the degree of freedom of circuit design. Optimization of the implanted impurities is also facilitated.

In this case, the sequence could be such that an impurity is at first implanted using the gate electrode as a mask, secondly an insulation film is formed on the surface of the gate electrode, and finally an impurity is again implanted to the semiconductor film.

It is preferable that the method in accordance with this aspect of the present invention further comprises a step of forming an impurity-doped semiconductor film in the shape of an island shape in source and drain portions of a thin-film transistor, then forming an intrinsic semiconductor film on the impurity-doped semiconductor film formed in the shape of an island. This enables an improvement in the TFT characteristics by making the channel portion thin, and lowers the contact resistance by making the source and drain portions thick. Since a sufficiently large margin against overetching is obtained by this method, even when dry etching is used to open contact holes, yield is improved.

In this case, an insulation film formed on the gate electrode surface layer portion could be formed by thermal oxidation or anodic oxidation of the material of the gate electrode, or by some deposition methods. A deposition method such as a chemical vapour deposition method forms an insulation film at a low temperature with a high throughput. Suitable combinations of these methods could be used to form a multi-layer insulation film, which would enable a further reduction in defects.

An eighteenth aspect of the present invention concerns a display system using a thin-film semiconductor device comprising a non-single-crystal semiconductor film formed on an insulating material portion which covers at least one portion of a surface of a substrate, wherein:

the display system further comprises an active matrix portion formed on the insulating material and data and scan driver portions formed on the insulating material and also formed of the thin-film semiconductor device,

the semiconductor film comprises a first impurity-doped semiconductor film located in source and drain portions of a thin-film transistor and a high-resistance second impurity-doped semiconductor film located in at least one area between drain and channel portions or between source and channel portions of the thin-film transistor, and

the maximum impurity concentration of the second impurity-doped semiconductor film is in the range of between $1 \times 10^{18}$ $cm^{-3}$ and $1 \times 10^{19}$ $cm^{-3}$.

In accordance with this aspect of the present invention, since a data driver portion and a scan driver portion that use LDD-type TFTs are provided, high-speed operation is enabled at a low voltage, and current consumption is also low.

Note that the maximum impurity concentration of the first impurity-doped semiconductor film and/or LDD length can be optimized by the present invention, to enable a further reduction in the length of the channel.

According to a nineteenth aspect of the present invention, the data driver portion or the scan driver portion may comprise a clocked gate bidirectional shift register circuit. This enables a simple method of reversing a screen image either horizontally or vertically, thus broadening the range of applications of the display device.

According to a twentieth aspect of the present invention, the data driver portion or the scan driver portion may comprise a plurality of shift register circuits each of which has a different clock signal phase, and gate-circuits to which outputs from the plurality of shift register circuits are input. This enables the generation of various different timing pulses at high speed. For example, it enables the serial input of data driver signals for the Japanese high-definition television (HDTV) system, which is impossible in the prior art.

According to a twenty-first aspect of the present invention, the data driver portion or the scan driver portion may comprise a level-shifter circuit and a shift register circuit, where the shift register circuit is driven at or below the TTL level. This ensures that the entire interface for external signals operates at or below the TTL level, enabling the implementation of smaller, less expensive, less power-consuming external circuits.

According to a twenty-second aspect of the present invention, an input portion of the level-shifter circuit may comprise a p-type thin-film transistor and an n-type thin-film transistor connected in series. This enables stable operation even when the difference between input and output voltages is large.

According to a twenty-third aspect of the present invention, the data driver portion comprises at least one shift register circuit, at least one video line, and analog switches; and one of outputs of the shift register circuit is input to a gate terminal of the analog switch, either directly or through a level-shifter circuit; whereby an analog signal is supplied to each of picture elements in a dot-sequential manner. This enables the construction of an extremely compact data driver that has a low power consumption, enabling the implementation of a compact display device.

According to a twenty-fourth aspect of the present invention, the data driver portion comprises first-stage analog latches, each of which is connected to at least one video line, second-stage analog latches, each of which has at least one input to which an output from the first-stage analog latch enters, and analog buffers, each of which is connected to one of signal lines to which outputs from the second-stage analog latches are input; whereby an analog signal is supplied to each of picture elements in a line-sequential manner. This enables a large active-matrix type of LCD to be driven.

According to a twenty-fifth aspect of the present invention, the data driver portion comprises a group of n first-stage latches connected to n digital signal input lines, a group of n second-stage latches to which outputs of the first-stage latches are input, and a decoder connected to $2^n$ analog switch gates to which outputs of the second-stage latches are input; whereby digital signals are supplied to picture elements. This enables the construction of a large-scale digital data driver, which interfaces a digital signal with a multimedia display system using latches and decoders.

According to a twenty-sixth aspect of the present invention, the display system further comprises a video signal amplification circuit for amplifying video signals output from a video signal generator and a timing controller for generating timing signals in synchronization with video signals output from the video signal generator, wherein the data driver portion and the scan driver portion are driven by the timing signals. This enables suppression of the power consumption of the entire system, thus making this display system suitable for use in portable electronic equipment.

According to a twenty-seventh aspect of the present invention, the timing controller, the data driver portion, and the scan driver portion are driven at levels equal to or below the TTL level. This makes the external circuits extremely simple.

According to a twenty-eighth aspect of the present invention, the timing controller is made from the thin-film semiconductor device. This enables a system that is even more compact and inexpensive.

According to a twenty-ninth aspect of the present invention, the video signal amplification circuit comprises a signal frequency conversion circuit for converting a video signal into a plurality of low-frequency signals or a gamma correction circuit. This improves the horizontal resolution and also increase grayscale levels.

According to a thirtieth aspect of the present invention, the video signal amplification circuit is made from the thin-film semiconductor device. When the video signal amplification circuit is formed integrally of the thin-film semiconductor device of the present invention in this manner, the display system can be made much more compact and inexpensive.

A thirty-first aspect of the present invention concerns a thin-film semiconductor device comprising a non-single-crystal semiconductor film formed on an insulating material portion which covers at least one portion of a surface of a substrate, wherein:

the semiconductor film is deposited by a chemical vapor deposition method under conditions that retard the generation rate of nuclei that act as seeds for film formation and accelerate the growth rate of islands formed from the nuclei, and also the semiconductor film comprises a first impurity-doped semiconductor film located in source and drain portions of a thin-film transistor and a high-resistance second impurity-doped semiconductor film located in at least one area between drain and channel portions or between source and channel portions of the thin-film transistor.

In accordance with this aspect of the present invention, the semiconductor film is formed under the principle that the nucleus generation rate is retarded and the island growth rate is accelerated, thus enabling the implementation of an LDD-type TFT circuit comprising this semiconductor film. This has further advantages such as enabling an increase in carrier mobility, a reduction in contact resistance and in the channel length of the transistor, and an increase in the breakdown voltage, thus enabling the implementation of a high-speed thin-film semiconductor device that is not inferior to a single-crystal MOSFET. In particular, since the island regions forming the semiconductor film in accordance with the present invention are extremely large, the resultant polycrystalline configuration after annealing has an extremely low level of crystal defects. Therefore, the electric resistance of the LDD portion can be reduced and the ON current can be further improved.

Note that the maximum impurity concentration of the first and second impurity-doped semiconductor films and/or LDD length can be optimized by the present invention, to enable a further reduction in the length of the channel.

In particular, to optimize the maximum impurity concentration of the second impurity-doped semiconductor film, the range of the maximum impurity concentration can be set in the range of between $2 \times 10^{17}$ $cm^{-3}$ and $1 \times 10^{19}$ $cm^{-3}$, thus broadening the setting range of the maximum impurity concentration. In other words, since the semiconductor film is formed under the principle of the present invention that the nucleus generation rate is retarded and the island growth rate is accelerated, the number of crystal defects is reduced and, thus, the electric resistance of the LDD portion can be lowered. Therefore, the sheet resistance of the LDD portion is still low, even if the maximum impurity concentration of the LDD portion is set low. This is why the lower limit of the maximum impurity concentration of the LDD portion can be set as low as $2 \times 10^{17}$ $cm^{-3}$.

To optimize the LDD length, the LDD length can be set to be in the range of between 0.3 $\mu$m and 4 $\mu$m, thus enabling a broadening of the setting range of the LDD length. In other words, since the semiconductor film is formed under the principle of the present invention that the nucleus generation rate is retarded and the island growth rate is accelerated, the semiconductor film has rather little grain boundary, restraining impurities from acceleratingly diffusing along the grain boundaries. Therefore, the minimum LDD length can be shortened to approximately 0.3 $\mu$m. This enables a further reduction in the parasitic resistance of the LDD portion.

According to a thirty-second aspect of the present invention, the second impurity-doped semiconductor film is arranged over the entire region of source and drain portions of a p-type thin-film transistor having an impurity-doped semiconductor film in which the implanted impurity is p-type.

In other words, the sheet resistance of the second impurity-doped semiconductor film in which an impurity is implanted at low concentration in accordance with the present invention can be reduced. Thus the step of implanting an impurity to high concentration in the p-type thin-film transistor can be omitted, and the entire region of the source and drain portions can be made from the low-concentration second impurity-doped semiconductor film. This enables reduction of one processing step, such as a photoprocessing step, and also makes it easier to increase the density of the integrated circuits.

## BRIEF DESCRIPTION OF THE DRAWINGS

Figs. 1A to 1D show the process of fabricating a thin-film semiconductor device according to a first embodiment of the present invention;
Fig. 2 is a graph of the transistor characteristics of n-channel TFT and p-channel TFTs in accordance with the first embodiment;
Fig. 3 is a characteristic diagram showing the relationships among deposition temperature, deposition rate, and carrier mobility;
Fig. 4 is a scanning electron microscope (SEM) photograph of the crystal structure of a silicon film (after thermal oxidation, deposition temperature = 510°C) which is used in a thin film semiconductor device;
Fig. 5 is a scanning electron microscope (SEM) photograph of the crystal structure of a silicon film (after thermal oxidation, deposition temperature = 600°C) which is used in a thin film semiconductor device;
Figs. 6A and 6B show the distributions of grain areas;
Figs. 7A to 7E are diagrams used to illustrate the principle of the present invention;
Figs. 8A to 8H are further diagrams used to illustrate the principle of the present invention;
Fig. 9 is a scanning electron microscope (SEM) photograph of the amorphous state of a silicon film (before thermal oxidation, deposition temperature = 510°C) which is to be used in a thin film semiconductor device;
Fig. 10 is an atomic force microscope (AFM) photograph of the amorphous state of the amorphous state of a silicon film (before thermal oxidation, deposition temperature = 510°C) which is to be used in a thin film semiconductor device;
Fig. 11 is an atomic force microscope (AFM) photograph of the amorphous state of a silicon film (before thermal oxidation, deposition temperature = 570°C) which is to be used in a thin film semiconductor device;
Fig. 12 is a scanning electron microscope (SEM) photograph of the crystal structure of a silicon film (after thermal oxidation, deposition temperature = 570°C) which is used in a thin film semiconductor device;
Fig. 13 is a scanning electron microscope (SEM) photograph of the crystal structure of a silicon film (before thermal oxidation, deposition temperature = 600°C) which is to be used in a thin film semiconductor device;
Fig. 14 is a characteristic diagram showing the relationship between deposition temperature and average grain area;
Fig. 15 shows the data that determines the characteristic diagram of Fig. 14;
Fig. 16 is a characteristic diagram showing the relationship between deposition temperature and leakage current when the transistor is in off state;
Fig. 17 lists breakdown voltages between source and gate of the comparative example;
Fig. 18 is a characteristic diagram showing the relationship between thermal oxidation temperature and ON current;
Fig. 19 is a scanning electron microscope (SEM) photograph of the state of a MOS boundary surface of the thin-film semiconductor device of the present embodiment, when the thermal oxidation temperature is 1160 °C;
Fig. 20 is a scanning electron microscope (SEM) photograph of the state of a MOS boundary surface of the thin-film semiconductor device of the present embodiment, when the thermal oxidation temperature is 1050 °C;
Fig. 21 is a scanning electron microscope (SEM) photograph of the state of a MOS boundary surface of the thin-film semiconductor device of the present embodiment, when the thermal oxidation temperature is 900 °C;
Fig. 22 is a scanning electron microscope (SEM) photograph of the state of a MOS boundary surface of a thin-film semiconductor device acting as a comparative example, when the thermal oxidation temperature is 1160 °C;
Fig. 23 is a scanning electron microscope (SEM) photograph of the state of a MOS boundary surface of a thin-film semiconductor device acting as a comparative example, when the thermal oxidation temperature is 1050 °C;
Fig. 24 is a scanning electron microscope (SEM) photograph of the state of a MOS boundary surface of a thin-film semiconductor device acting as a comparative example, when the thermal oxidation temperature is 900 °C;
Figs. 25A to 25D show the process of fabricating a thin-film semiconductor device according to a fifth embodiment of the present invention;
Fig. 26 is a cross-section through an LDD-type TFT;
Fig. 27 is a cross-section through a TFT of an ordinary structure;
Fig. 28 is a characteristic diagram showing the relationship between gate electrode length and breakdown voltage between source and drain in an LDD-type TFT and a TFT of an ordinary structure;
Fig. 29 is a characteristic diagram showing the relationship between gate electrode length and ON current in an LDD-type TFT and a TFT of an ordinary structure;
Figs. 30A to 30C are diagrams used to describe the operation of a CMOS inverter circuit;
Figs. 31A and 31B are graphs of the transfer characteristics of thin-film transistors;
Fig. 32 is a graph of the maximum operating frequency of a shift register circuit;
Figs. 33A, 33B, and 33C are a circuit diagram, a pattern diagram, and a wafer cross-sectional view, respectively, when a CMOS inverter circuit is made from single-crystal MOSFETs;
Fig. 34 is a pattern diagram when a CMOS inverter circuit is made from TFTs;
Fig. 35 is a characteristic diagram showing the relationship between dose of the LDD portion and ON and OFF currents;
Fig. 36 is a characteristic diagram showing the relationship between dose of the LDD portion and ON/OFF ratio;
Fig. 37 is a characteristic diagram showing the relationship between dose of the LDD portion and sheet resistance;
Fig. 38 is a characteristic diagram showing the relationship between dose of the source and drain portions and diffusion length ;
Fig. 39 is a characteristic diagram showing the relationship between dose of the source and drain portions and contact resistance;
Fig. 40 is a characteristic diagram showing the relationship between LDD length and ON and OFF currents;
Fig. 41 is a characteristic diagram showing the relationship between LDD length and breakdown voltage between source and drain;
Figs. 42A to 42D show the fabrication process according to an eighth embodiment of the present invention;

Fig. 43 is a graph of the transistor characteristics of an LDD-type TFT in accordance with the ninth embodiment;

Fig. 44 is a graph of the maximum operating frequency of a shift register circuit using the LDD-type TFT of the ninth embodiment;

Fig. 45 lists the contact resistance, source and drain resistance, and LDD resistance of TFTs of the ninth embodiment and comparative examples;

Fig. 46 shows a model used for calculating parasitic resistance and others;

Fig. 47 is a circuit diagram of a type of active matrix LCD with integral peripheral drive circuits;

Figs. 48A and 48B are a pixel pattern diagram and cross-sectional view of an active matrix LCD;

Figs. 49A and 49B are a circuit diagram and timing chart of a bidirectional shift register circuit;

Figs. 50A and 50B are a circuit diagram and timing chart of a single-direction shift register circuit,

Figs. 51A and 51B are a circuit diagram and timing chart of a level-shifter circuit;

Fig. 52 is a circuit diagram of an analog line-sequential data driver;

Fig. 53 is a circuit diagram of a digital data driver;

Fig. 54 is a block diagram of a display system using an active matrix LCD;

Fig. 55 lists examples of the carrier mobility and ON current of an amorphous TFT, prior art polycrystalline TFTs, TFTs of a twelfth embodiment, and a single-crystal MOSFET;

Fig. 56A shows an example of the configuration of a thin-film semiconductor device, and Fig. 56B is an equivalent circuit diagram of this thin-film semiconductor device.

## BEST MODE OF CARRYING OUT THE INVENTION

Preferred embodiments of the present invention will now be described with reference to the accompanying drawings. Note that the first to fifth embodiments described below provide a high-speed thin-film semiconductor device in which a method of fabricating a semiconductor film is improved.

### First Embodiment

The process of fabricating a thin-film semiconductor device according to a first embodiment of the present invention is shown in Figs. 1A to 1D. These figures illustrate the process of fabricating an n-channel TFT as an example, but the present invention can equally well be applied to the fabrication of a p-channel TFT or a CMOS type of TFT which consists of an n-channel TFT and a p-channel TFT (see Fig. 26). The present invention can also be applied to the TFT which has two gate electrodes.

In this first embodiment, quartz glass is used as a substrate 201. However, it should be noted that any type or size of substrate could be used, provided the substrate is capable of withstanding the maximum temperature achieved within the process of fabricating the thin-film semiconductor device. A semiconductor film such as silicon that is to form the active layer is first deposited on the substrate 201. At this point, if the substrate is of a conductive material such as a silicon wafer or of ceramic and includes impurities, an underlying protective film such as a silicon dioxide film or silicon nitride film could be deposited before the semiconductor film is deposited (see Fig. 25).

In a thin-film semiconductor device fabricated in accordance with this first embodiment, an intrinsic silicon film is deposited by LPCVD on the substrate 201. The thickness of the film after this deposition is 1000 Å. The LPCVD apparatus is hot-wall type, having volume of 184.5 L. The total reactive area in the LPCVD chamber when substrates are set is approximately 44,000 $cm^2$. The deposition temperature is 510 °C, mono-silane ($SiH_4$) of purity of at least 99.99% is used as the reactant gas, and the gas is supplied to the reaction chamber at a flow rate of 100 sccm. The deposition pressure is 0.8 Torr and a silicon film is deposited under these conditions at a deposition rate of 21.5 Å/minute. The thus-deposited silicon film is subjected to patterning to obtain a silicon film 202 (see Fig. 1A).

The patterned silicon film 202 is then thermally oxidized to form a silicon dioxide film 203 on the surface of the silicon film 202. Thermal oxidation is performed for 23 minutes, 36 seconds at one atmospheric pressure in a 100% oxygen environment at 1160 °C. This process thins the silicon film to 400 Å, to obtain a silicon dioxide film with film thickness of 1200 Å (see Fig. 1B). In order to adjust the threshold voltage of this thin-film semiconductor device, $^{11}B^+$ ions are next implanted into the semiconductor film at a dose of $2 \times 10^{12}$ $cm^{-2}$ with an acceleration voltage of 40 kV.

A gate electrode 204 is then formed from a silicon film containing donors or acceptors. In this embodiment, the gate electrode is formed of a 3500 Å-thick layer of polycrystalline silicon containing phosphorus. The sheet resistance of the thus-obtained gate electrode is 25 Ω/□. The gate electrode is then used as a mask for the implantation of impurity ions 205 that will become donors or acceptors, so as to form source and drain portions 206 and a channel region 207 (see Fig. 1C). In this first embodiment, phosphorus is selected as the impurity ion, and this impurity is implanted at a dose of $2 \times 10^{15}$ $cm^{-2}$ with an acceleration voltage of 90 kV.

An interlayer insulation film 208 is next deposited by means such as an atmospheric pressure CVD method. This interlayer insulation film is formed of a silicon dioxide film with film thickness of 5000 Å. After the interlayer insulation film is deposited, furnace annealing is performed for 20 minutes in a nitrogen atmosphere at 1000 °C to both anneal the interlayer insulation film and activate the impurity ions that have been added to the source and drain portions. Contact holes are then opened and wires 209 of a material such as aluminum are passed therethrough to complete the thin-film semiconductor device (see Fig. 1D).

The transistor characteristics of the n-channel TFT of the thus-formed thin-film semiconductor device are measured, with the results being as shown in Fig. 2. The length and width of the channel are both 10 µm, and measured at room temperature. When the source-drain voltage (Vds) is 4 V and the gate voltage (Vgs) is 10 V (under this condition, the transistor is in ON state), the source-drain current (Ids) is 75.6 µA, as shown in Fig. 2. When Vds is 4 V and Vgs is 0 V (under this condition, the transistor is in OFF state), Ids is 0.203 pA. From the above, it is clear that an extremely good thin-film semiconductor device is obtained, with an ON/OFF ratio of more than eight orders of magnitude for a change in gate voltage of 10 V. The carrier mobility calculated from the saturation region of this transistor is the very good value of 106 $cm^2$/V.s. Thus this embodiment of the present invention shows that thin-film semiconductor devices having outstanding characteristics are very simply fabricated, neither requiring any lengthy furnace annealing nor hydrogenation, but involving only silicon film deposition by LPCVD.

Note that equivalent transistor characteristics for a p-channel TFT are also shown in Fig. 2. The only difference of fabricating p-channel TFT from the above mentioned n-channel TFT fabrication is that an acceptor-type impurity such as boron is implanted for forming the source and drain portions.

If hydrogenation is performed on this thin-film semiconductor device by subjecting it to a hydrogen plasma for two hours, then both the ON current and the OFF current will improve to the values of 102 µA and 0.0318 pA, respectively, under the same measurement condition as those described above. The resultant carrier mobility is 129 $cm^2$/V.s.

This first embodiment demonstrates that a high-performance thin-film semiconductor device can be fabricated in a simple manner, without requiring troublesome processing steps such as the implantation of silicon atoms or (re-)crystallization of the semiconductor film by lengthy furnace annealing, merely by using the deposition conditions of the present invention while the silicon film is being deposited by LPCVD.

**Second Embodiment**

A variety of thin-film semiconductor devices were fabricated by the fabrication process described in the first embodiment, except that the deposition conditions of the silicon film that is to form the active layer were varied. Note, however, that no hydrogenation is performed in this second embodiment.

In this second embodiment, silicon films were deposited under various conditions to investigate the relationship between transistor characteristics and deposition conditions. The silicon films are deposited by the LPCVD apparatus described in the section on the first embodiment. The reactant gas is mono-silane of purity of at least 99.99%. The deposition temperature for the silicon film is varied between 490 °C and 650 °C, the mono-silane flow rate for the deposition is varied in the range of between 10 sccm and 100 sccm, and the deposition pressure is set as appropriate in the range of between 1 m Torr and 0.8 Torr. In this manner, various silicon films were deposited under differing deposition conditions. The film thickness of all the deposited silicon films was in 1000 ± 50 Å. After the silicon film deposition, the thin-film semiconductor devices were completed by exactly the same fabrication process as that of the first embodiment. The film thickness of all the silicon films after the thermal oxidation is 400 ± 50 Å, and the film thickness of the silicon dioxide film that acts as the gate insulation film is 1200 ± 50 Å.

If silicon film deposition conditions are changed, the resultant deposition rate will also change. Also, as presented in the first embodiment, the different deposition conditions of silicon film lead the different electrical properties of the resultant thin-film semiconductor devices. Therefore, Fig. 3 shows the relationships between the carrier mobility of each of the thin-film semiconductor devices obtained by the above described method and the deposition temperature and deposition rate of the silicon film. The horizontal axis of the Fig. 3 shows the silicon film deposition temperature while the vertical axis shows the deposition rate. The carrier mobilities of the corresponding thin-film semiconductor devices are expressed numerically in Fig. 3. The units of carrier mobility are $cm^2$/V.s. The dotted lines in the figure show boundary lines indicating a deposition temperature of 580 °C and a deposition rate of 6 Å/minute. In order to easily recognize the relationship between deposition conditions and transistor characteristics, transistors having good electrical properties are indicated by circles in the figure, while transistors having nearly the same electrical properties as those of thin-film semiconductor devices produced as comparative examples (by the first fabrication method described in the section on the background of the invention) are indicated by crosses. The temperature for depositing directly the polycrystalline silicon films of the comparative examples is approximately 600 °C or more. All of the thin-film semiconductor devices fabricated as comparative examples have carrier mobilities of between approximately 15 $cm^2/V.s$ and approximately 20 $cm^2/V.s$. Clearly, when the silicon film deposition temperature is approximately 580 °C or less, the characteristics of thin-film semiconductor devices are strongly dependent on the deposition rate of the silicon films. When the deposition rate is 6 Å/minute or more, the correspondent thin-film semiconductor devices have extremely good electrical characteristics, even without applying the hydrogenation process described in the section on the first embodiment. In contrast, when the deposition rate is less than 6 Å/minute, the carrier mobility ranges from approximately 16 $cm^2/V.s$ to approximately 19 $cm^2/V.s$, which is about the same as the devices produced as comparative examples. An extremely high-performance thin-film semiconductor device can be obtained only when the thin-film semiconductor device is fabricated under conditions such that the deposition temperature is 580 °C or less and the deposition rate is 6 Å/minute or more.

The silicon films forming the active layers of the thin-film semiconductor devices in accordance with the present invention (the circles in Fig. 3) are investigated by a scanning electron microscope (SEM). After the thermal oxidation, each silicon dioxide film is removed by a 10% aqueous solution of hydrogen fluoride, then the exposed polycrystalline silicon surface is observed by the SEM. SEM observation shows that the grain area distribute in accordance with an exponential distribution and both the average grain area and the standard deviation of the grain area are in the range of between 10,000 $nm^2$ and 20,000 $nm^2$ for all silicon films. Fig.4 shows a scanning electron microscope (SEM) photograph, as an example, of the crystal structure of the silicon film deposited at 510 °C with the deposition rate of 12.9 Å/minute, which has carrier mobility of 82 $cm^2/V.s.$ when it is used as the active layer of thin film transistors. The grain area distribution verified by Fig. 4 is shown in Fig. 6A. The average grain area (grain size) is 15,600 $nm^2$ with a standard deviation of 15,300 $nm^2$. Each silicon film formed by the method in accordance with this embodiment contains large grains and some grains have their area of more than 55,000 $nm^2$ (see the range of 55,000 $nm^2$ to 60,000 $nm^2$ in Fig. 6A).

On the other hand, Fig. 5 is a scanning electron microscope (SEM) photograph showing the crystal structure of a silicon film of a thin-film semiconductor device obtained as a comparative example (produced by the first fabrication method) as an example. The grain area distribution of this comparative example is shown in Fig. 6B. The testpiece used for Figs. 5 and 6B is deposited at a deposition temperature of 600 °C and a deposition rate of 37.7 Å/minute. Fig. 5 shows the state of the silicon film after thermal oxidation. The carrier mobility of this silicon film is 20 $cm^2/V.s$. The average grain area of the film is 3,430 $nm^2$, with a standard deviation of 4,210 $nm^2$. Both the average and standard deviation of the grain size of a silicon film are always less than 5,000 $nm^2$, either if the silicon film is deposited at the temperature of 600 °C or more, or if the silicon film is deposited at the deposition rate of less than 6 Å/minute. The films deposited at the temperature of 580 °C or less with the deposition rate of less than 6 Å/minute also consist of small grains such as less than 5,000 $nm^2$.

As described above, if a silicon film is deposited at a deposition temperature of 580 °C or less and a deposition rate of 6 Å/minute or more, and that silicon film is subjected to thermal oxidation, the average grain area of the polycrystalline film forming the active layer of transistor is at least 10,000 $nm^2$, by far greater than that of the prior art, and the characteristics of the thin-film semiconductor device are also greatly improved.

**A. Principle of the Present Invention**

The present invention forms a semiconductor film with superior characteristics by depositing a semiconductor film under conditions such that the nucleus generation rate is retarded and the island growth rate is accelerated. The principle of the present invention is described below with reference to Figs. 7A to 7E and Figs. 8A to 8H.

In general, when a thin film is deposited by the low-pressure chemical vapor deposition (LPCVD) method, a number of nuclei (points which act as seeds or centers for film growth) 30 and 31 appear first on the insulating substance, regardless of whether the deposited film is amorphous or polycrystalline (Fig. 7A). Reactant molecules forming the reactant gas are transferred from the gaseous phase to the substrate. These molecules are subjected to heat from the substrate and undergo a chemical reaction, causing a number of these molecules to gather to form nuclei. The chemical reaction at this point, taking mono-silane as an example, is as follows:

$SiH_4 \rightarrow Si + 2H_2 \uparrow$

These nuclei 30 and 31 grow to become islands 34 and 35, and, at the same time, more nuclei 32 and 33 form in vacant regions on the substrate (Fig. 7B). These nuclei 32 and 33 also grow into islands 36 and 37, while the other islands 34 and 35 also grow further (Fig. 7C). As the vacant regions between islands disappear in this manner, no more new nuclei appear. The islands 34 to 37 continue to grow until they combine to form a thin film 38 (Fig. 7D). This thin film 38 grows further until a thin film 40 of preferred film thickness is complete (Fig. 7E). Fig. 7E shows that the thin film 40 is made up of regions (which will be called "islands" in the final stage of deposition process) 51, 52, 53, and 54 that correspond to the original islands formed in the initial stage of deposition process, regardless of whether the silicon film is amorphous or polycrystalline. Island growth and nucleus generation compete with each other up until the insulating substance surface is completely covered by the deposited film. Therefore, if the nucleus generation rate is retarded and the island growth rate is accelerated, then the islands would become extremely large. As a result, the regions (which will be called "islands" in the final stage of deposition process) 51 to 54 that make up the thin film also becomes large. This point is clear from reference to Figs. 8A to 8H. Figs. 8A to 8D show the effects of the present invention by which the nucleus generation rate is retarded and the island growth rate is accelerated. In contrast, Figs. 8E to 8H show a comparative example in which the nucleus generation rate is faster, and the island growth rate is slower as compared to the present invention. From these figures it is apparent that, for example, three nuclei are generated in Fig. 8A, whereas five nuclei are generated in Fig. 8E. The growth rate of the resultant islands is faster in Fig. 8B than in Fig. 8F. When the island growth rate is fast, vacant regions on the substrate lessen as shown in Fig. 8C, and thus the number of nuclei which will be generated is further restricted. In contrast, since the island growth rate in Fig. 8G is slower, there are still many vacant regions on the substrate, so that the number of nuclei which will be generated is not as restricted as it is in Fig. 8C. Thus, in contrast to the islands of the comparative example that grow small (Fig. 8H), the islands in accordance with the present invention grow to be extremely large (Fig. 8D). When a semiconductor film made up of islands (regions) grown large in this manner is subjected to annealing such as thermal oxidation, so as to change the film from an amorphous state to a polycrystalline state, a polycrystalline semiconductor film made up of large grains is formed, as shown in Fig. 4. The islands (regions) that make up the semiconductor film are generally called "grains" when the semiconductor film is in the polycrystalline state.

The principle of the present invention as described above is not only applicable to as-deposited amorphous films, but also applicable to as-deposited polycrystalline films. It has never been thought that there are regions called islands in an amorphous film. In other words, it has been widely believed that an amorphous film is in random state so that it does not have any orders such as the directions of growth, which are observed in a simple-crystal or polycrystalline film. Therefore, no one has ever thought that there are dividing regions (boundaries) between one such random shape and another in an amorphous film. Fig. 9 is a scanning electron microscope (SEM) photograph of an amorphous silicon film deposited at the temperature of 510°C with the deposition rate of 12.9 Å/minute, showing a typical amorphous state. This photograph in Fig. 9 is an as-deposited amorphous film (before thermal oxidation). If this film is thermally oxidized, it will change the crystalline structure from an amorphous state to polycrystalline one that is shown in Fig. 4. As can be seen from Fig. 9, no regions that can be termed islands can be discerned by SEM in this amorphous film before thermal oxidation. Therefore, it has been believed that regions called islands do not exist in an amorphous film.

However, the present inventors have verified the presence of islands in an amorphous film with atomic force microscope (AFM). For example, Fig. 10 shows an atomic force microscope (AFM) photograph of an as-deposited amorphous silicon film, that is, a silicon film in an amorphous state immediately after the deposition, deposited at a deposition temperature of 510°C and a deposition rate of 12.9 Å/minute. The presence of islands that can not be verified by SEM, as shown in Fig. 9, is verified with AFM, as shown in Fig. 10. Fig. 11 shows an atomic force microscope (AFM) photograph of an as-deposited amorphous silicon film (a silicon film just after deposition in an amorphous state) deposited at 570°C, and Fig. 12 is a scanning electron microscope (SEM) photograph showing the silicon film in a polycrystalline state after thermal oxidation of this film. As is clear from a comparison of Figs. 10 and 11, the size of the islands decreases as the deposition temperature rises. It is also clear from a comparison of Fig. 4 (equivalent to Fig. 10, of the film after thermal oxidation) and Fig. 12 (equivalent to Fig. 11, of the film after thermal oxidation) that, since the islands which consist of as-deposited film become smaller as the deposition temperature rises, the grain area (grain size) of the polycrystalline film, which is obtained after thermal oxidation will also diminishes. Thus, the size of the islands (regions), which make up the as-deposited film, clearly has a strong correlation with the size of the grains, which make up the polycrystalline film obtained by thermal oxidation of the as-deposited film. In other words, when the as-deposited film being made up of large islands (regions) is thermally oxidized, thermal oxide film and a polycrystalline film which is made up of large grains are obtained.

In practice, all the silicon films of the thin-film semiconductor device in accordance with the present invention (the circles in Fig. 3) are in an amorphous state immediately after they are deposited by LPCVD. Further, the size (diameter) of the islands (regions) that make up these amorphous films is within a distribution range of 100 nm to approximately 400 nm, for the case shown in Fig. 10, for example. The average island area of the as-deposited amorphous film is roughly the same as the average grain area of the polycrystalline film after thermal oxidation, or maybe slightly smaller, and it is more than 10,000 $nm^2$ when the deposition temperature and deposition rate are optimized.

In contrast, the silicon films of the comparative examples that are used in thin-film semiconductor device in prior art are normally deposited at a temperature of higher than 580 °C. These films are in a polycrystalline state immediately after they are deposited by LPCVD, and the size (diameter) of the regions that make up these polycrystalline films is within a distribution range of 20 nm to approximately 80 nm. The average area of the regions in this case is no more than 10,000 $nm^2$. Note that Fig. 13 is a scanning electron microscope (SEM) photograph showing a silicon film in a polycrystalline state before thermal oxidation (an as-deposited polycrystalline silicon film), when the deposition temperature is 600 °C. When a silicon film is deposited at 580 °C or less and at a deposition rate of less than 6 Å/minute, the as-deposited film is in an amorphous state, the size of the regions making up the amorphous film is, as expected, between 20 nm and approximately 80 nm. As these examples show, if the sizes of the regions making up the as-deposited semiconductor film are distributing in the range of more than 100 nm in diameter, then the average grain size of the polycrystalline semiconductor film obtained after thermal oxidation will be increased to 10,000 $nm^2$ or more in area, and thus a high-performance thin-film semiconductor device will be fabricated.

Although this second embodiment has been described with reference to an intrinsic silicon film as an example, it is obvious to those skilled in the art and universally valid that a large-grained polycrystalline semiconductor film could be obtained by firstly controlling the semiconductor film deposition process to deposit a thin film having large regions and by secondly subjecting the film to thermal oxidation, thus creating a high-performance thin-film semiconductor device. This means that the present invention is effective not only with an intrinsic silicon film, but also with an impurity-doped silicon film or with other semiconductor films, such as a silicon germanium film, regardless of their nature of containing donors or acceptors. Similarly, the method of depositing the semiconductor film is not limited to LPCVD, the film can equally well be deposited by plasma-enhanced CVD or sputtering. Provided the average area of the islands (regions) making up the semiconductor film immediately after the film formation by one of these methods is at least 10,000 $nm^2$, a large-grained polycrystalline film can be obtained by thermal oxidation, thus fabricating a high-performance thin-film semiconductor device.

**B. Deposition Temperature and Deposition Rate**

As described above, the present invention deposits a semiconductor film under conditions such that the nucleus generation rate is retarded and the island growth rate is accelerated. In this case, the point is how to control both the nucleus generation rate and the island growth rate simultaneously. In accordance with this second embodiment, the nucleus generation rate is controlled by the deposition temperature (temperature of the substrate surface) and the island growth rate is controlled by the deposition rate, by way of example. The nucleus generation rate is retarded by lowering the deposition temperature and the island growth rate is accelerated by increasing the deposition rate. Note, however, that the methods used to control the nucleus generation rate and the island growth rate are not limited to the above methods; for example, the nucleus generation rate may be retarded by means such as a change in the material of the substrate. One possible way of changing the material of the substrate is to use a special silicon dioxide film.

When the deposition temperature is fixed, the deposition rate may be increased either by increasing the flow rate of the reactant gas, such as mono-silane or di-silane, or by increasing deposition pressure. Generally the deposition rate is also related to the deposition temperature, such that the deposition rate increases as the deposition temperature rises. However, if the deposition temperature rises, the nucleus generation rate will be further accelerated as described above, and thus the principle of the present invention cannot be implemented. With this embodiment of the present invention, the deposition temperature is fixed low, thereby retarding the nucleus generation rate. At the same time, since the deposition rate that has been retarded by this lowered temperature has to be now accelerated, the flow rate of the reactant gas is increased or the deposition pressure is raised. This enables the implementation of a control method that does not contradict the principle of the present invention.

In contrast, the deposition temperature of the semiconductor film used for TFTs in prior art (the comparative examples) is within a customary range of 600 °C to 650 °C. It is clear from Fig. 3 that it is impossible to obtain a good-quality semiconductor film with high carrier mobility under these conditions, namely the high deposition temperature, even if the flow rate of reactant gas and deposition pressure are controlled to accelerate the deposition rate, because the high temperature accelerates the nucleus generation rate faster than the flow rate or pressure increases the island growth rate, and thus the islands making up the as-deposited film would be too small.

Strictly speaking, the deposition rate does not depend only on the deposition temperature, the flow rate of the reactant gas, and the deposition pressure; it is also related to factors such as the volume of the LPCVD apparatus and the total reactive area when substrates are inserted into the LPCVD chamber. For example, if the total reactive area is large, the deposition rate is retarded even with the same flow rate of reactant gas. The factors that determine the deposition rate are discussed in detail in, for example, J. Appl. Phys. 74 (4), August 15, 1993, pp. 2870-2885. In summary, when the deposition temperature is fixed, the deposition rate is a function of the concentration of the reactant gas in vapour phase, with the deposition rate accelerating as this concentration increases. The concentration of the reactant gas is a function of the partial pressure and temperature of the reactant gas, with the concentration increasing as the partial pressure of the reactant gas increases, and the concentration decreasing as the temperature of the reactant gas increases. The temperature of the reactant gas is determined by the pumping speed of the pump exhausting from the chamber and the flow rate of the reactant gas. The deposition pressure is also related to the functions of the pump, or to factors such as the flow rate of the reactant gas. In any case, the deposition rate can be controlled by the flow rate of the reactant gas and the deposition pressure, if parameters such as the deposition temperature, volume of the LPCVD apparatus, and total reactive area are fixed.

The nucleus generation rate is also weak function of the flow rate of the reactant gas and the deposition pressure. However, the stronger factor affecting the nucleus generation rate is the deposition temperature. Increasing the flow rate of the reactant gas and raising the deposition pressure have a stronger effect on accelerating the deposition rate than on accelerating the nucleus generation rate.

The deposition rate generally corresponds to the value that the deposited film thickness divided by the deposition time, where the deposition time is equivalent to the sum of the time required for the nuclei to be generated and the time required for the islands to grow. On the other hand, the island growth rate is equivalent to the value that the deposited film thickness differentiated by the deposition time. Therefore, strictly speaking, the deposition rate is related to the island growth rate but in fact they are not equal. However, the time required for the nuclei to be generated is usually sufficiently smaller than the time taken to deposit a film of several hundreds of Å that the deposition rate and the island growth rate are almost the same. In fact, in all of the experimental data shown in Fig. 3, the deposition time (T) and deposited film thickness (tsi) satisfy the following equation (linear equation passing through the origin):

$$tsi = DR \times T$$

In other words, the deposition rate DR coincides with the island growth rate within experimental errors.

## C. Optimizing the Deposition Temperature

As described with reference to Fig. 3 the deposition temperature is preferably 580 °C or less. Nevertheless, even at 580 °C or less there are special temperatures that act as critical points. Fig. 14 is a characteristic diagram showing the relationship between deposition temperature and average grain area after thermal oxidation. Note that in Fig. 14, the points indicated by squares are the average values calculated from the data listed in Figs. 15 and 6A. As shown in Fig. 14, a deposition temperature of 580 °C acts as the first boundary below which the average grain area becomes extremely large. However, as also shown in this figure, the maximum value of the average grain area can be utilized by setting this temperature below the second boundary, ie. preferably 550 °C or less. Similarly, Fig. 16 is a characteristic diagram showing the relationship between deposition temperature and leakage current when the transistor is in off state. As this figure shows, the leakage current when the transistor is in off state is dramatically reduced at a deposition temperature of 530 °C or less. In general, the leakage current when the transistor is in off state will be large, if the active layer of the transistor consists of the crystals containing many defects.

Thus it can be concluded from the characteristic diagram of Fig. 16 that, when a semiconductor film is deposited at a temperature of 530 ° C or less then subjected to thermal oxidation, not only does the grain area become greater, but also the defects within the crystals decrease.

A lower limit to the deposition temperature is determined by factors such as the type of reactant gas, so that if the reactant gas is mono-silane, for example, the lower temperature limit is 460 ° C; if it is di-silane, the lower temperature limit is 370 ° C.

In Fig. 14, if the deposition temperature is less than 500 ° C, the grain area becomes less, but this is when the reactant gas is mono-silane. This does not occur with di-silane or other reactant gases. This is because, if the deposition temperature is less than 500 ° C with mono-silane, it will be hard to keep the deposition rate high. However, this is not the case for di-silane.

**D. Roughness of Semiconductor Film and Gate Insulation film Surfaces**

In general, when an oxide film is formed by a thermal oxidation method, the finished thermal oxide film inherits the surface configuration of the original pre-oxidation semiconductor film. Since a gate electrode is formed over such an oxide film in a MOS field-effect transistor (FET), the surface configuration of the as-deposited semiconductor film (immediately after its deposition by a method such as LPCVD) is reflected in the surface configuration of the boundary between the gate insulation film and the gate electrode. In other words, if the as-deposited semiconductor film is smooth, the boundary surface between the gate insulation film and the gate electrode will also be smooth; if the as-deposited semiconductor film surface has a certain amount of roughness, the boundary surface between the gate insulation film and the gate electrode will also have that roughness. The roughness of the boundary surface between the gate insulation film and the gate electrode has an effect on the breakdown voltage between source and gate or between drain and gate after the thin-film semiconductor device is fabricated. If the boundary surface is rough, electric field easily focuses on the peak of the gate electrode, making the electric field locally and extremely high on the peak, which can easily cause avalanche breakdown between the source and the gate or the drain and the gate.

Since the as-deposited semiconductor film surfaces of the thin-film semiconductor devices in accordance with this embodiment (the circles in Fig. 3) are extremely smooth, so are the gate insulation film surface after thermal oxidation, such that they have center line average height (Ra) of 1.995 nm with the interval estimation value of 0.323 nm at the 95% confidential level. In contrast, the as-deposited semiconductor film surfaces of the thin-film semiconductor devices in accordance with the comparative examples (the crosses in Fig. 3) are rough, regardless of the deposition temperature, with the gate insulation film surfaces after thermal oxidation having center line average height (Ra) of 3.126 nm with the interval estimation value of 0.784 nm at the 95% confidential level. The reason why the as-deposited semiconductor films deposited in accordance with this embodiment have smooth surfaces is that the island regions which make up the as-deposited films in the amorphous state are large, as shown in Fig. 10. The definition of "center line average height" is the value that the total area of sections obtained by reflecting the roughness curve by the center line, divided by the measured length.

The breakdown voltage between source and gate has been measured for all the six thin-film semiconductor devices in accordance with the present invention (the circles in Fig. 3). Each of the six devices supplies three samples for the measurement. (Therefore, eighteen devices have been measured in their breakdown voltage.) The measurement has been done under the condition that the source of each sample is electrically grounded and the negative voltage is applied to the gate. Reflecting the above mentioned fact and principle, all the eighteen samples have very good characteristics in the breakdown voltage, having the value of more than 100 V (equivalent to a breakdown electric field of more than 8.333 Mv/cm). In contrast, eleven testpieces of each of three samples of the thin-film semiconductor devices of the comparative examples (the crosses in Fig. 3) have also been measured in the breakdown voltage between source and gate of the thin-film semiconductor devices under the same condition as the above, that is, the sources are grounded and the gates are in negative voltage. Twenty-eight of the thirty-three thin-film semiconductor devices are found to have breakdown voltages of 100 V or more, while the other have lower breakdown voltage. One sample formed at a deposition temperature of 585 ° C and with carrier mobility of 15 $cm^2/V.s$, for example, is found to experience avalanche breakdown at 65 V (see Fig. 17). When a thin-film semiconductor device is used in a liquid crystal panel, the maximum applied voltage between the source and the gate is approximately 20 V. Nevertheless, several millions of these thin-film semiconductor devices are present in one panel. Since avalanche breakdown between the source and the gate is a stochastic process, it is clear that the thin-film semiconductor device of the present invention is less susceptible to pixel defects due to short-circuiting between source and gate, in comparison with the comparative examples.

**Third Embodiment**

Thin-film semiconductor devices have been fabricated by the fabrication process described in the first embodiment, except that the reactant gases used in the LPCVD has been varied. With this third embodiment, semiconductor films have been deposited using di-silane ($Si_2H_6$) of purity of at least 99.99% as reactant gas, using the LPCVD apparatus described previously with respect to the first embodiment. The deposition temperature is 450°C and di-silane is introduced at 100 sccm into the reaction furnace. Helium of purity of at least 99.9995% is used as the dilution gas introduced at 100 sccm into the reaction chamber. During the silicon film deposition, the pressure is 0.3 Torr and the deposition rate is 19.97 Å/minute. The thus-obtained silicon films are in an amorphous state and have film thickness of 1000 Å. The islands (regions) making up each amorphous film are of sizes with a distribution of 150 nm to approximately 450 nm. After being patterned, these amorphous films have been subjected to thermal oxidation at 1160°C in a 100% oxygen environment at one atmospheric pressure for 23 minutes, 36 seconds. The surface roughness of the gate insulation film after thermal oxidation is 1.84 nm in center line average height (Ra). If the gate insulation film is removed by a 10% aqueous solution of hydrogen fluoride to have a SEM observation of the surface of the polycrystalline silicon film after the oxidation, it will show that the average area and standard deviation of area of the grains which consist of the polycrystalline silicon films are 14,110 $nm^2$ and 15,595 $nm^2$ respectively.

The transistor characteristics of these thin-film semiconductor devices formed by the fabrication process described with reference to the first embodiment have been measured, with the results as given below. The measurement conditions and the definitions of ON and OFF currents and carrier mobility are the same as those of the first embodiment. The result is that the thin-film semiconductor devices show good characteristics, having high ON-current of 53.5 $\mu$A and low OFF-current of 0.154 pA with carrier mobility of 78.5 $cm^2$/V.s, even when absolutely no hydrogenation has been performed. The breakdown voltage between source and gate has been measured for these three thin-film semiconductor devices, and is at least 100 V for all the devices. If these thin-film semiconductor devices are subjected to exposure to a hydrogen plasma for two hours, then the ON-current will be improved to 77.7 $\mu$A, the OFF-current be improved to 0.137 pA, and the carrier mobility be improved to 107 $cm^2$/V.s.

As illustrated by this third embodiment, if a semiconductor film is deposited at 580°C or less with a deposition rate of 6 Å/minute or more, then subjected to thermal oxidation, the average grain area of the resultant polycrystalline silicon film is at least 10,000 $nm^2$, the boundary surface between the gate insulation film and the gate electrode is smooth, and thus a high-performance thin-film semiconductor device is provided, without being limited by the use of mono-silane as the type of reactant gas. The fundamental concept of the present invention is based on the principle that the nucleus generation rate can be retarded by lowering the deposition temperature and the island growth rate can also be accelerated, so that the regions (islands) making up the semiconductor film are large and have smooth surface. Therefore, the present invention is completely valid for any means of reducing the nucleus generation rate and increasing the island growth rate.

Di-silane is used as the reactant gas in this third embodiment, but the present invention is effective with any reactant gas that provides a suppression of the nucleus generation rate by keeping the deposition temperature to 580°C or less and accelerates the island growth rate by a deposition rate of 6 Å/minute or more, such as tri-silane ($Si_3H_6$), a fluoro-silane ($Si_nH_xF_y$: where n, x, and y are integers), or a chloro-silane ($Si_nH_xCl_y$: where n, x, and y are integers).

**Fourth Embodiment**

Thin-film semiconductor devices are fabricated by the fabrication process described in the section on the first embodiment, except that the thermal oxidation temperature used for forming the gate isolation layer is varied. In this fourth embodiment, intrinsic silicon films are deposited to film thickness of 1000 Å by LPCVD on quartz substrates. The deposition conditions are the same as those of the first embodiment. That is, the deposition temperature is 510°C, mono-silane of purity of at least 99.99% is used as the reactant gas, and the gas is supplied to the reaction chamber at a flow rate of 100 sccm. The deposition pressure is 0.8 Torr and a silicon film is formed on each substrate under these conditions at a deposition rate of 21.5 Å/minute. The thus-deposited silicon films are subjected to patterning, then a silicon dioxide film forming a gate insulation layer is formed by thermal oxidation on the silicon film surface. During this final process, the thermal oxidation temperature is varied to be 1160°C, 1100°C, 1050°C, 1000°C, 950°C, and 900°C, respectively. The thermal oxidation furnace is initially held at 800°C with an 100% oxygen environment at one atmospheric pressure. After substrates are inserted in the thermal oxidation furnace in this state, the temperature is increased to the desired oxidation temperature at a heating rate of 10 °C/minute. After the oxidation temperature has been reached, that state is maintained for the time appropriate to that particular temperature, as the thermal oxidation proceeds. For a temperature of 1160 °C, this time is 23 minutes, 36 seconds. Similarly, for a temperature of 1100 °C it is 51 minutes, 59 seconds; for a temperature of 1050 °C it is one hour, 38 minutes, 33 seconds; for a temperature of 1000 °C it is 3 hours, 17 minutes, 15 seconds; for a temperature of 950 °C it is 6 hours, 49 minutes, 40 seconds; and for a temperature of 900 °C it is 14 hours, 48 minutes, 23 seconds. After this thermal oxidation is completed, nitrogen replaces the atmosphere in the reaction furnace. The nitrogen environment at the thermal oxidation temperature stretches for 15 minutes, and then the substrates are removed.

The thickness of the thermal oxidation film obtained by this process is 1200 Å at all of the thermal oxidation temperatures, and the thickness of the polycrystalline silicon film acting as the active layer of the thin-film semiconductor device is 400 Å. The thin-film semiconductor devices are completed by exactly the same fabrication process as that of the first embodiment, except that final hydrogenation is not performed by this fourth embodiment. The transistor characteristics of the thus-obtained thin-film semiconductor devices are shown at A in Fig. 18, where ON current is plotted along the Y-axis, thermal oxidation temperature is plotted along the upper X-axis, and the inverse of the absolute thermal oxidation temperature is plotted along the lower X-axis. Fig. 18 shows that the transistor characteristic deteriorates as the thermal oxidation temperature is reduced, but this deterioration is comparatively small in the thin-film semiconductor devices formed in accordance with the present invention.

For comparison, B in Fig. 18 shows the dependency on thermal oxidation temperature of the transistor characteristics of thin-film semiconductor devices formed as comparative examples. Each of the comparative-example thin-film semiconductor devices is formed by the above described fabrication method after the silicon film which is to act as the active layer is deposited with a deposition temperature of 600 °C, a monosilane flow rate of 100 sccm, a deposition pressure of 40 m Torr, and a deposition rate of 38.1 Å/minute. It is clear from the figure that the characteristic of the thin-film semiconductor devices of the comparative examples deteriorates dramatically as the thermal oxidation temperature is reduced, so that in fact it becomes impossible to reduce the thermal oxidation temperature. In contrast, it is also clear from the figure that the thin-film semiconductor devices of the present invention have superior characteristics, such that even devices obtained with a thermal oxidation temperature of 900 °C have better characteristics than the thin-film semiconductor device obtained as comparative examples with a thermal oxidation temperature of 1160 °C. This is because, with the thin-film semiconductor devices of the comparative examples, the surface roughness of the MOS boundary surface (boundary surface between the semiconductor layer and gate insulation layer) deteriorates when the thermal oxidation temperature is approximately 1100 °C or less, and the degree of this surface roughness becomes even worse as the thermal oxidation temperature is reduced. In contrast, with the thin-film semiconductor devices in accordance with this embodiment, the MOS boundary surface is extremely stable so that the roughness of the MOS boundary surface does not become too bad even if the thermal oxidation temperature is reduced..

Figs. 19, 20, and 21 are scanning electron microscope (SEM) photographs showing the state of a MOS boundary surface of the thin-film semiconductor device of this embodiment when the thermal oxidation temperature is 1160 °C, 1050 °C, and 900 °C, respectively. Similarly, Figs. 22, 23, and 24 are scanning electron microscope (SEM) photographs showing the state of a MOS boundary surface of the thin-film semiconductor device of the comparative example, when the thermal oxidation temperature is 1160 °C, 1050 °C, and 900 °C, respectively. These photographs show clearly that the roughness of the MOS boundary surface of this embodiment does not become too bad in comparison with the comparative example, even when the thermal oxidation temperature is reduced. For example, from a comparison of Figs. 19 (this embodiment) and 22 (comparative example), which show the results of a thermal oxidation temperature of 1160 °C, it is clear that both MOS boundary surfaces are smooth and the surface state is nearly the same between them. However, a comparison of Figs. 20 (this embodiment) and 23 (comparative example), which show the results of a thermal oxidation temperature of 1050 °C, illustrates a significant difference between the roughness of the MOS boundary surfaces. This difference becomes even more dramatic if Figs. 21 (this embodiment) and 24 (comparative example), showing the results of a thermal oxidation temperature of 900 °C, are compared.

Thin-film semiconductor devices are often formed on high-melting-point quartz glass. However, regardless of the type of substrate on which such devices are formed, if the thermal oxidation temperature is reduced, deformation such as expansion, contraction, or warping of the substrate can be reduced, enabling the fabrication of high-density, highly integrated devices. A lower temperature is also preferable from the viewpoints of apparatus lifetime and maintenance. Thus there are many advantages to be obtained by lowering the temperature, but it was impossible to reduce the oxidation temperature in the comparative examples, as shown in Fig. 18B. It is clear that the present invention is superior than the prior art in this point, too.

**Fifth Embodiment**

This fifth embodiment shows how the present invention can be applied to low-temperature process.

Recently, as the screens of liquid crystal displays (LCDs) have grown larger and their resolutions have increased, the method used to drive them has changed from a simple matrix method to an active matrix method, and these LCDs are becoming more capable of displaying large quantities of information. The active matrix method enables an LCD with several hundreds of thousands of pixels, with a switching transistor formed for each pixel. A transparent insulating substrate of a material such as fused quartz plate or glass is used as the substrate for various types of LCD, because it enables a transparent display. A semiconductor film of a material such as amorphous silicon or polycrystalline silicon is generally used as the active layer of each thin-film transistor (TFT), but polycrystalline silicon is preferable to amorphous one for integrating a driver circuit with the TFTs. This is because the polycrystalline silicon operates faster in speed than does amorphous one. If the active layer is made of a polycrystalline silicon film, a fused quartz plate is used as the substrate and the TFT is fabricated by a method called high-temperature process where the maximum processing temperature usually exceeds 1000 °C. On the other hand, if the active layer is an amorphous silicon film, an ordinary glass substrate is used. To further increase the size of the LCD screen and reduce its price, it would be necessary to use inexpensive ordinary glass as the insulating substrate. However, as described above, an amorphous silicon film has such inherent problems like its electrical characteristics are inferior to those of a polycrystalline silicon film and it has a slower operating speed. For a polycrystalline silicon TFT produced by high-temperature process, it is difficult to produce a larger, but less expensive, LCD because a fused quartz plate must be used. Thus there is a strong demand for a technique of forming a thin-film semiconductor device in which a semiconductor film such as a polycrystalline silicon film acting as an active layer is formed on an ordinary glass substrate. This means that the use of large ordinary glass substrates, which are apt to mass production, places a large restriction on the maximum processing temperature required to avoid deformation of the substrate, to no more than approximately 600 °C. In other words, under the above mentioned restriction, techniques are required for forming a high quality active layer of thin-film transistors, which work as switching elements in a liquid crystal display and which make up driver circuits that work fast. These techniques are currently called a low-temperature processed poly-Si TFT.

A prior art type of low-temperature poly-Si TFT is described in the Society for Information Display (SID) '93 Digest (1993): p. 387. According to this article, 50-nm amorphous silicon (a-Si) film is first deposited by LPCVD at a deposition temperature of 550 °C, using mono-silane ($SiH_4$) as the reactant gas. Then the a-Si film is subjected to laser irradiation to convert the a-Si film into a poly-Si film. After the poly-Si film is patterned, an $SiO_2$ film is deposited as a gate insulation film by electron cyclotron resonance chemical vapor deposition (ECR-PECVD) at a substrate temperature of 100 °C. A gate electrode is then formed of tantalum (Ta) on the gate insulation film, and the gate electrode is used as a mask for the ion implantation of a donor or acceptor impurity into the silicon film to form the source and drain of the transistor in a self-aligned manner. A non-mass-separated type of implantation apparatus is used for this ion implantation, with phosphine ($PH_3$) or diborane ($B_2H_6$) diluted with hydrogen as the reactant gas. The implantation ions are activated at 300 °C. An interlayer insulation film is then deposited and electrodes and wiring of indium tin oxide (ITO) or aluminum (Al) are formed to complete the thin-film semiconductor device.

However, the low-temperature poly-Si TFT of this prior art technique has various inherent problems. The fifth embodiment of the present invention described below is intended to solve these problems and to enable a practicable and simple method of fabricating a good thin-film semiconductor device. This fifth embodiment also fabricates a thin-film semiconductor device stably at a low enough processing temperature to use an ordinary large glass substrate.

This fifth embodiment will now be described in detail. A process of fabricating a thin-film semiconductor device that can form an MIS type of field-effect transistor is shown in Figs. 25A to 25D.

In this fifth embodiment, a 235 mm□ (235 mm × 235 mm) plate of non-alkaline glass (OA-2, produced by Nippon Electric Glass Co., Ltd.) is used as a substrate 101, but any type and size of the substrate will be used if the substrate can withstand the maximum processing temperature. A silicon dioxide film ($SiO_2$ film) 102 to act as an underlying protective film is first formed by a method such as ordinary atmospheric-pressure chemical vapor deposition (APCVD), PECVD, or sputtering on the substrate 101. The $SiO_2$ film can be deposited by APCVD with a substrate temperature of 250 °C to approximately 450 °C and using mono-silane ($SiH_4$) and oxygen as the reactant gas. PECVD or sputtering can also deposit the $SiO_2$ film at

a substrate temperature of room temperature to 400 ° C. With this fifth embodiment, a 2000 Å $SiO_2$ film is deposited by APCVD at a temperature of 300 ° C using $SiH_4$ and $O_2$ as the reactant gas.

Next, an intrinsic silicon film that is to act as an active layer of the thin-film semiconductor device is deposited to thickness of approximately 500 Å. This intrinsic silicon film is deposited by an infralow-pressure CVD (ILPCVD) apparatus with a flow of 200 sccm of mono-silane ($SiH_4$) as reactant gas, at a deposition temperature of 495 ° C, for 31 minutes. The ILPCVD apparatus used for the fifth embodiment has a volume of 184.5 L. Seventeen substrates are inserted face-downward in a reaction chamber held at 300 ° C. After the substrates are inserted, a turbo-molecular pump is turned on. After it reaches to stable rotation state, a leakage test is performed for 2 minutes. During this time, the leakage rate, which is mainly due to the desorption of gases, is $3.3 \times 10^{-5}$ Torr/minute. The temperature is then raised over one hour from the insertion temperature of 300 ° C to the deposition temperature of 495 ° C. During the initial 10 minutes of the temperature rise, absolutely no gas is introduced into the reaction chamber and the temperature is increased in a vacuum state. Ten minutes after the start of the temperature rise, the background pressure achieved by the reaction chamber is $5.4 \times 10^{-7}$ Torr. During the remaining 50 minutes of the temperature rise, a 300-sccm flow of nitrogen gas of purity of at least 99.9999% is introduced to lead the equilibrium pressure in the reaction chamber of $3.0 \times 10^{-3}$ Torr. After the deposition temperature has been achieved, a 200-sccm flow of $SiH_4$ as reactant gas is introduced to deposit a silicon film for 31 minutes, 00 seconds. The pressure in the reaction chamber is held at 1.3 Torr by a pressure controller. Since the thus-obtained silicon film has thickness of 514 Å, the deposition rate is 16.6 Å/minute. Thus, since the deposition temperature in accordance with this fifth embodiment is 495 ° C and the deposition rate is 16.6 Å/minute, both the deposition temperature and the deposition rate are within the respective ranges, which is shown in Fig. 3, of 580 ° C or less and 6 Å/minute or more. Therefore, as described with respect to the first to fourth embodiments, the fifth embodiment can form a semiconductor film with good characteristics.

The thus-obtained silicon film is a high-purity a-Si film. This a-Si film is then subjected to irradiation with optical energy or electromagnetic-wave energy for a short time to crystallize the a-Si, and thus converted into polycrystalline silicon (poly-Si). In this fifth embodiment, a xenon chloride (XeCl) excimer laser (wavelength of 308 nm) performs the irradiation. The full width at half maximum value of the laser pulses is 45 ns. Since the irradiation time is so short, the substrate is not heated during the crystallization of the a-Si to poly-Si, and thus problems such as deformation of the substrate do not occur. The laser irradiation is performed with the substrate at room temperature (25 ° C), in an air. The area irradiated by a single laser irradiation is an 8 mm□ square-shaped area, and each irradiation is shifted by 4 mm. After scanning first in the horizontal direction (Y direction), the irradiation is then shifted to the vertical direction (X direction) by 4-mm, then it scans again in the horizontal direction at the 4-mm intervals. This scanning is repeated until the entire surface of the substrate has been subjected to this first laser irradiation. The first laser irradiation energy density is 160 $mJ/cm^2$.

After the first laser irradiation is completed, the entire surface is subjected to a second laser irradiation at an energy density of 275 $mJ/cm^2$. The scanning method is the same as that of the first laser irradiation; an 8 mm□ square-shaped irradiation region being shifted by 4 mm in the Y direction and then the X direction. The entire substrate is crystallized uniformly from a-Si into poly-Si by this two-stage laser irradiation.

In this fifth embodiment, an XeCl excimer laser is used as the means of irradiating optical energy or electromagnetic-wave energy, but any suitable energy source can be used provided the time taken to irradiate the energy is within a few tens of seconds. For example, the irradiation can be from any of various types of laser, such as an ArF excimer laser, an XeF excimer laser, a KrF excimer laser, a YAG laser, a carbon dioxide gas laser, an Ar laser, or a dye laser, or from a lamp such as an arc lamp or tungsten lamp. If the irradiation is performed by an arc lamp, improvement of the film quality from a-Si to poly-Si can be achieved by a lamp output of at least approximately 1 $kW/cm^2$ with an irradiation time of approximately 45 seconds. Since the energy irradiation time is so short, even during this crystallization, there is no deformation or cracking of the substrate due to heat. This silicon film is then patterned to form a channel-portion semiconductor film 103 that acts as the active layer of the transistor (Fig. 25A).

Note that the improvement of an a-Si film to a poly-Si film by energy irradiation can be replaced by furnace annealing at a temperature of approximately 600 ° C or less. This method is called the solid-phase crystallization, and crystallization thereby is completed by between about 8 hours and 24 hours if the temperature is approximately 600 ° C. This can also be used to implement a method of fabricating a thin-film semiconductor device in which a low-temperature process and the solid-phase crystallization are combined.

A gate insulation film 104 is then formed by ECR-PECVD or PECVD. A $SiO_2$ film is used as the gate insulation film of this fifth embodiment, deposited to thickness of 1200 Å by PECVD (Fig. 25B). Mono-silane ($SiH_4$) and "laughing gas" ($N_2O$) are used as the reactant gas for the PECVD and the substrate temperature is 300 °C. Conditions are established such that a plasma is formed by rf waves at 13.56 MHz, the output is 900 W, and the degree of vacuum is 1.50 Torr. The flow rate of $SiH_4$ is 250 sccm and that of $N_2O$ is 7000 sccm. The deposition rate of the $SiO_2$ film is 48.3 Å/s. Immediately before and after the $SiO_2$ is formed under the above conditions, the silicon film and as-deposited oxide film are exposed to an oxygen plasma to improve the MOS boundary surface and the oxide film. Mono-silane and laughing gas are used as the reactant gas in this fifth embodiment, but the present invention is not limited thereto. An organic silane such as TEOS ($Si\text{-}(O\text{-}CH_2\text{-}CH_3)_4$) or an oxidizing gas such as oxygen could be used instead. Similarly, an extremely ordinary PECVD apparatus is utilized, but the insulation film can equally well be formed by an ECR-PECVD apparatus. Regardless of the type of CVD apparatus and reactant gas used, the temperature at which the insulation film is formed is preferably 350 °C or less. This condition is important for preventing thermal deterioration of the MOS boundary surface and gate insulation film, and it also applies for all the subsequent steps described below. The temperature of all processing steps after the formation of the gate insulation film must be held to 350 °C or less. This ensures that a high-performance thin-film semiconductor device can be fabricated easily and stably.

A thin film that is to become a gate electrode 105 is next deposited by a method such as sputtering, vapor deposition, or CVD. In this fifth embodiment, tantalum (Ta) is selected as the gate electrode material, and it is deposited by sputtering to thickness of 5000 Å. The substrate temperature during the sputtering is 180 °C, and argon (Ar) containing 6.7% of nitrogen (N2) is used as the sputtering gas. The content of nitrogen in the argon is optimally between 5.0% and 8.5%. The crystal structure of the tantalum film obtained under these conditions is mainly the $\alpha$-structure, with a resistivity of 40 $\mu\Omega$cm. Therefore, the sheet resistance of the gate electrode in accordance with the fifth embodiment is 0.8 Ω/□.

Post-deposition patterning is performed on the thin film that is to be the gate electrode, then ion implantation 106 of an element such as phosphorus is performed into the intrinsic silicon film, using a bucket type of mass non-mass-separated ion implantation apparatus (ion doping), to form source and drain portions 107 and a channel region 108 (Fig. 25C). Since this fifth embodiment aims to produce an n-channel TFT, 5% phosphine ($PH_3$) diluted with hydrogen is used as the reactant gas, and the implantation is at dose concentration of $5 \times 10^{15}$ $cm^{-2}$ with a high-frequency output power of 38 W and an acceleration voltage of 80 kV. The phosphorus concentration in the silicon film in this case is approximately $5 \times 10^{20}$ $cm^{-3}$. The optimum value of the high-frequency output power is in the range of between 20 W and approximately 150 W.

To form a p-channel TFT, 5% diborane ($B_2H_6$) diluted with hydrogen is used as the reactant gas, with the implantation being at dose concentration of approximately $5 \times 10^{15}$ $cm^{-2}$ with a high-frequency output power of 20 W to 150 W and an acceleration voltage of 60 kV. To form a CMOS TFT, a suitable masking material such as a polyimide resin is used alternately to cover one of the p-channel or n-channel TFTs at a time, while the appropriate ion implantation is performed by the corresponding method described above.

An interlayer insulation film 109 is then deposited to thickness of 5000 Å. In this fifth embodiment, $SiO_2$ is formed by PECVD as the interlayer insulation film. The reactant gas used in the PECVD is TEOS ($Si\text{-}(O\text{-}CH_2\text{-}CH_3)_4$) and oxygen ($O_2$), and the film is formed at a substrate temperature of 300 °C. The plasma is formed by 13.56 MHz rf waves under conditions of an output power of 800 W and a degree of vacuum of 8.0 Torr. The flow rate of the TEOS is 200 sccm and that of the $O_2$ is 8000 sccm. The formation rate of the $SiO_2$ film is 120 Å/s. After this ion implantation and interlayer insulation film formation, the substrate is subjected to furnace annealing for one hour at 300 °C in an oxygen environment to activate the implanted ions and anneal the interlayer insulation film. The temperature of this furnace annealing is preferably 300 °C to 350 °C. Contact holes are then opened and source/drain extraction electrodes 110 are formed by a method such as sputtering to complete the thin-film semiconductor device (Fig. 25 D). Indium tin oxide (ITO) or aluminum (Al) is used as the source/drain extraction electrodes. The substrate temperature while these conductors are formed by sputtering is 100 °C to approximately 250 °C.

The transistor characteristics of the thus-obtained thin-film semiconductor device are measured. When the transistor is in on-state with the source-drain voltage Vds being 4 V and the gate voltage Vgs being 10 V, the source-drain current Ids is defined to be an ON current ION, and ION is found to be $(20.6 + 1.67, -1.48) \times 10^{-6}$ A with 95% confidential level. Similarly, when the transistor is in off-state with Vds being 4 V and Vgs being 0 V, the OFF current IOFF is found to be $(2.27 + 0.40, - 0.31) \times 10^{-12}$ A. These measurements are performed at a temperature of 25 °C, on a transistor in which the length L and width W of the channel portion are both 10 $\mu$m. The effective electron carrier mobility obtained from a saturation region of channel current is given by $\mu = 47.54 \pm 3.53$ cm/V.s (J. Levinson et al., J. Appl. Phys. 53, 1982:

p. 1193).

Thus the present invention easily implements an immensely good and uniform thin-film semiconductor device that have high carrier mobility, that vary the Ids for nearly ten to the seventh order in response to a 10-V change in the gate voltage, and that also have very little variation, by a low-temperature process wherein the maximum processing temperature is set to 600 °C or less. Moreover, the present invention enables the use of inexpensive glass substrates because the maximum processing temperature is at the first process in the device fabrication, so that alignment error caused by the thermal processes is minimum. Since the initial a-Si film of this embodiment is made up of large regions, the size of the crystal grains after the crystallization is also large, thus providing high-performance electrical characteristics. In other words, an ideal a-Si film is obtained by optimizing the deposition conditions under which the initial a-Si film is formed, and a uniform high-quality poly-Si film is obtained by crystallizing this a-Si film.

With a-Si films produced by prior art techniques, LPCVD at a deposition temperature of approximately 550 °C or more is used without consideration of the deposition rate, or the substrate temperature set to approximately 400 °C for PECVD without any considering the quality of the initial a-Si film. Therefore, various problems occurred such as non-uniformity and an inability to provide stable production. One more aspect of the present invention is the way in which the processing temperature after the poly-Si film is formed is held to 350 °C or less. Under this condition, the quality of the MOS boundary surface and the insulation film can be highly stabilized. Thus the present invention is particularly effective for the top gate type of TFT, as shown in Figs. 25A to 25D. For a bottom gate type of TFT, since a silicon film is deposited after the gate insulation film is formed and then crystallization is performed by means such as laser irradiation, parts of the MOS boundary surface and gate insulation film will inevitably be subjected to a high-temperature thermal environment at close to 1000 °C. Although this high-temperature environment continues only for short periods, this thermal environment will roughen the MOS boundary surface and also alter the chemical composition and bonding state of the insulation film in the vicinity of the MOS boundary surface. As a result, the transistor characteristic will worsen and there will be large variations in quality.

When a poly-Si TFT is fabricated through a low-temperature process, the most important point is the formation of a good-quality poly-Si film. Therefore, when an amorphous film is crystallized by optical or electromagnetic energy, or by a low-temperature thermal environment in the region of about 600 °C, it is necessary to optimize the quality of the amorphous film. The section on optimizing the deposition temperature in the description of the second embodiment stated that polycrystalline films will consist of large-area grains and contain rather small number of crystalline defects, if they are formed by the crystallization of amorphous semiconductor films (amorphous silicon film) that is formed under conditions of a deposition temperature of 530 °C or less and a deposition rate of 6 Å/minute or more. Therefore, an amorphous semiconductor film formed under these conditions is the optimum semiconductor film for a low-temperature process.

In accordance with this fifth embodiment as described above, a high-quality semiconductor film consisting of a polycrystalline silicon film can easily be formed at a low temperature of less than approximately 600 °C. This makes it possible to dramatically improve the characteristic of the thin-film semiconductor device, as well as enable stable mass production. More specifically, the present invention has the effects described below.

First of all, since the processing temperature is low at less than 600 °C, inexpensive glass can be used and thus the product price can be reduced. Since it is also possible to prevent warping of the glass under its own weight, the resultant liquid crystal display device can easily be made large.

Secondly, uniform laser irradiation is performed over the entire substrate. This also improves the uniformity between lots and thus enables stable production.

Thirdly, it is extremely simple to produce a self-aligned TFT in which the source and drain align themselves with respect to the gate electrode, by ion doping and subsequent low-temperature activation at approximately 300 °C to 350 °C. This enables stable activation, and ensures that a lightly doped drain (LDD) type of TFT can be fabricated quite easily and stably. Since an LDD is thereby implemented by a low-temperature poly-Si TFT, it becomes possible to miniaturize the TFT components and reduce the OFF leakage current.

Fourthly, low-temperature poly-Si TFTs in the prior art were available only when the gate-$SiO_2$ was deposited by ECR-PECVD, while this fifth embodiment makes it possible to use an ordinary PECVD apparatus for preparing the gate-insulation film in the low-temperature poly-Si TFT fabrication. Therefore, it is possible to easily obtain a practicable fabrication apparatus of preparing a gate oxide film, which are applicable to large substrates and which are suitable for mass production, when conforming to the current embodiment.

Fifthly, the fifth embodiment fabricates a good thin-film semiconductor device, that has a higher ON-current and lower OFF-current than does the prior art. In addition, variations in these currents are reduced in the fifth embodiment.

When the present invention as described above is applied to an application such as an active matrix liquid crystal display, an inexpensive glass substrate can be used, and it becomes possible to fabricate a large, high-quality LCD easily and stably. When it is applied to other electronic devices, deterioration of components due to heat is reduced. Thus this fifth embodiment has a huge effect of simply implementing a high-performance, and inexpensive active matrix liquid crystal display device or electronic devices such as integral circuits.

**Sixth Embodiment**

The sixth to twelfth embodiments described below illustrate how optimization of factors such as processing conditions can provide LDD-type thin-film semiconductor devices (LDD-type TFT circuits) having high speeds and good characteristics.

A TFT circuit of the sixth embodiment is a CMOS circuit using both p-channel and n-channel LDD-type TFTs. Since an LDD-type TFT has a high-resistance portion between a channel portion and source and drain portions thereof, the electric field is not concentrated at the drain edge of the channel, so that it has particular effects in reducing the OFF current and increasing the breakdown voltage between source and drain and that between gate and source. However, it does have a problem in that the high-resistance portions reduce the actual voltage applied to the channel portion and thus the ON current is reduced. Therefore, LDD-type TFTs have not yet been used in CMOS circuits that are required to work in high-speed, though they are used in applications such as the switching elements of an active matrix portion or SRAM resistance elements. However, it has been determined from experiments and simulations that a CMOS circuit of LDD-type TFTs is capable of high-speed operation. Note, however, that the high-speed LDD-type TFT of the present invention is not limited to a CMOS configuration; it can also be applied widely to NMOS and PMOS configurations.

The method of fabricating an LDD-type CMOS TFT configuration will first of all be described with reference to Fig. 26. A gate insulation film 5 is formed on a thin semiconductor film 2 that is patterned in an island shape on an insulating substrate 1, and a gate electrode 6 is formed thereon. Next, an impurity that is to form donors is implanted at low concentration into the thin semiconductor film at source and drain portions of an n-channel TFT, to form a thin $n^-$ semiconductor film 9. The impurity implantation dose in this case is approximately $1 \times 10^{13}$ $cm^{-2}$ to $1 \times 10^{14}$ $cm^{-2}$, and preferably approximately $2 \times 10^{13}$ $cm^{-2}$ to $5 \times 10^{13}$ $cm^{-2}$. If the dose is within this range, the maximum impurity concentration of the thin $n^-$ semiconductor film 9 is that value multiplied by $10^5$ (see the calculations below) and thus is approximately $1 \times 10^{18}$ $cm^{-3}$ to $1 \times 10^{19}$ $cm^{-3}$, and preferably approximately $2 \times 10^{18}$ $cm^{-3}$ to $5 \times 10^{18}$ $cm^{-3}$.

The impurity is then further implanted at high concentration into source and drain portions to form a thin $n^+$ semiconductor film 3. The impurity implantation dose in this case is approximately $5 \times 10^{14}$ $cm^{-2}$ to $1 \times 10^{16}$ $cm^{-2}$, preferably approximately $1 \times 10^{15}$ $cm^{-2}$ to $3 \times 10^{15}$ $cm^{-2}$. If the dose is within this range, the maximum impurity concentration of the thin $n^+$ semiconductor film 3 is that value multiplied by $10^5$ and thus is approximately $5 \times 10^{19}$ $cm^{-3}$ to $1 \times 10^{21}$ $cm^{-3}$, preferably approximately $1 \times 10^{20}$ $cm^{-3}$ to $3 \times 10^{20}$ $cm^{-3}$. This process divides the island-shaped thin semiconductor film into three sections with differing resistances: an intrinsic semiconductor region of channel, high-resistance impurity-doped semiconductor regions on either side of an intrinsic semiconductor region of a channel portion, and a low-resistance impurity-doped semiconductor region of the source and drain portions.

In a similar manner, an impurity that is to form acceptors is implanted at low concentration into the thin semiconductor film at source and drain portions of a p-channel TFT, to form a thin $p^-$ semiconductor film 10, then at high concentration into source and drain portions to form a thin $p^+$ semiconductor film 4. With this method, the gate electrode is used as a mask for the implantation of impurities, so that boundaries between the thin $n^-$ semiconductor film 9 and the channel portion and between the thin $p^-$ semiconductor film 10 and the channel portion are self-aligned to the gate edge (self-aligned structure). There are at least two methods of forming the boundaries between the thin $n^-$ semiconductor film 9 and the thin $n^+$ semiconductor film 3 and between the thin $p^-$ semiconductor film 10 and the thin $p^+$ semiconductor film 4. One method is non-self-aligned, using means such as a photoresist as a mask for high concentration implantation. Another is self-aligned, using the side walls made by the insulation film, which covers the gate electrode, to form the boundaries self-aligned to the side walls.

Highly doped source and drain portions need not be formed by the impurity implantation into the intrinsic semiconductor film as described above; they could equally well be formed as island shapes of a thin $n^+$ semiconductor film or a thin $p^+$ semiconductor film that already contains an impurity. Since the current that flows when a reverse bias is applied must be as low as possible in a TFT, it is preferable that the (intrinsic) thin semiconductor film is as thin as possible. However, if this film is too thin, the aluminum wiring could protrude out of the substrate through the contact holes. Therefore, if the highly doped source and drain portions are formed as individual island-shaped thin semiconductor films, then the above mentioned phenomenon will be prevented and a further thin (intrinsic) semiconductor film will be possibly used as a channel.

Next, a interlayer insulation film 7 is formed over each of these TFTs, and a thin metal film 8 is patterned to form wiring and complete the CMOS TFT circuit. A thin polycrystalline silicon film, a thin amorphous silicon film, a thin semiconductor film of Te or the like, or a thin semiconductor film of a compound such as CdSe, can be used as the material of the thin semiconductor film 2.

The reason why the LDD-type CMOS TFT circuit of Fig. 26 is more suited to high-speed operation than a CMOS TFT circuit of an ordinary structure, shown in Fig. 27, will now be discussed. The lengths of an overlapping portion Yjn of the n-channel TFT and an overlapping portion Yjp of the p-channel TFT, shown in Fig. 26, are smaller than the equivalent lengths in the TFTs of the ordinary structure shown in Fig. 27. The concentration of the impurity implanted into the thin n- semiconductor film 9 and the thin p- semiconductor film 10 is extremely small, so that the diffusion length along the direction of the channel is shortened. The capacitances of these overlapping portions work loads for the CMOS circuit as parasitic capacitances. Therefore, the LDD-type CMOS TFT circuit, which has smaller overlapping capacitance, will be operating at higher speed than be a TFT of an ordinary structure, if it has nearly the same ON-current as does the TFT of an ordinary structure.

As stated previously, the effective n-channel channel length Leffn and the effective p-channel channel length Leffp are the lengths obtained by subtracting twice the corresponding overlapping portion Yjn or Yjp from the n-channel gate electrode length (see Fig. 26; note that the gate electrode length is sometimes called the gate electrode width) Lgaten and the p-channel gate electrode length Lgatep. Therefore, if the overlapping portions could be made small, the effective channel length would be increased and the ON current decreased. Since the overlapping portions of the LDD-type CMOS TFT are small, as described above, the effective channel length becomes somewhat longer than that of a TFT of an ordinary structure, if the gate lengths are the same between two type of TFTs, and the ON current is reduced. However, when an LDD structure is implemented, the breakdown voltage between source and drain is markedly improved in practice, and thus the circuit can be configured with LDD TFTs having an extremely small gate electrode length. As a result, LDD structure can compensate for the reduced ON current by shortening both the gate electrode length and the effective channel length.

In general, the channel resistance Rch(on) when the TFT is in an ON state varies faster than linearly with the effective channel length Leff. In other words, Rch(on) is given by:

$$Rch(on) = k \times Leff^n$$

k: proportional constant, $n > 1$

where the power n of Leff is usually greater than 1. This means that the ON current of each TFT increases suddenly as the effective channel length shortens. Since the channel portion of a TFT is in a polycrystalline state, the number of grain boundaries within the channel decreases as the channel becomes shorter, and thus it is considered that their adverse effect on electrical conductivity is reduced. Thus, although the current can be controlled somewhat by the parasitic resistance of the LDD portion, the current flowing through the components can be made greater in an LDD-type TFT with a short channel than in a TFT of an ordinary structure.

A characteristic diagram illustrating the relationship between gate electrode length and source-drain breakdown voltage in the LDD-type TFT of this embodiment and a TFT of an ordinary structure is shown in Fig. 28. As shown in this figure, the breakdown voltage between source and drain in the TFT of an ordinary structure deteriorates when the gate electrode length is 5 $\mu$m or less. In other words, the gate electrode lengths of both the p-channel TFT and the n-channel TFT of the ordinary structure must be made at least 5 $\mu$m, in order to reliably prevent the breakdown in voltage between source and drain. In contrast, it is clear from Fig. 28 that a reliable prevention of the source-drain breakdown (breakdown voltage of at least 20 V) can be obtained with the LDD-type TFT of this embodiment, even if the gate electrode length is 5 $\mu$m or less. Even if the gate electrode length is 3 $\mu$m, a breakdown voltage between source and drain of at least 20 V can be obtained. A breakdown voltage between source and drain of at least 15 V can still be obtained when the gate electrode length is 2 $\mu$m. The OFF current is also reduced by at least one order of magnitude compared with a TFT of an ordinary structure.

A characteristic diagram illustrating the relationship between gate electrode length and ON current in the LDD-type TFT of this embodiment and a TFT of an ordinary structure is shown in Fig. 29. As is clear from this figure, the ON current of the TFT of an ordinary structure when the gate electrode length is 5 µm is about the same as the ON current of the LDD-type TFT when the gate electrode length is 4 µm. In other words, although the ON current is reduced by the implementation of an LDD structure, an ON current of at least the same level as that of the ordinary structure can be obtained, provided the gate electrode length can be made small. LDD-type TFT causes no problems concerning low breakdown voltage, even when the electrode length is 4 µm, as can be seen from Fig. 28. Similarly, the ON current of a TFT of the ordinary structure when the electrode length is 4 µm is about the same as the ON current of the LDD-type TFT when the electrode length is 3 µm. Even when the gate electrode length is 3 µm, there are no problems concerning low breakdown voltage, as is clear from Fig. 28. Since the source-drain breakdown voltage is very low when the gate electrode length is less than 4 µm in the TFT of the ordinary structure, it becomes impossible to measure the ON current. In contrast, the source-drain breakdown voltage of the LDD-type TFT with the gate length even of 2 µm of this embodiment is still high, so that the extremely high ON current is available as shown in Fig. 29. In other words, the LDD-type TFT of this embodiment can achieve a large size of ON current that can never be obtained by the TFT of the ordinary structure, when the gate electrode length is, for example, less than 3 µm. In accordance with this embodiment, applying an LLD structure both to a p-channel and n-channel TFT makes it possible to reduce the gate electrode length of either type of TFT to 5 µm or less, preferably 4 µm or less, and more preferably 3 µm or less, and thus enabling the CMOS circuit that works very fast in operation speed.

Since the LDD-type TFT has higher value of the breakdown voltage between gate and source than does the TFT of the ordinary structure, the gate insulation film in the LDD-type TFT can be made thinner to, for example, 1000 Å or less. Although making the gate insulation film thinner increases the channel capacitance, it increases the operating speed of the TFT circuit, because it simultaneously decreases the threshold voltage, and thus increases the ON current.

Circuit symbols for a CMOS inverter circuit are shown in Fig. 30A, a circuit diagram thereof is shown in Fig. 30B, and an equivalent circuit is shown in Fig. 30C. The operating speed of an LDD-type CMOS TFT circuit will now be discussed with reference to those figures. In general, CMOS digital circuits are connected as shown in Fig. 30A, with the output of one gate connected to the input of the next-stage gate. If this simple two-stage inverter is considered, a first-stage transistor TFTp1 or TFTn1 charges or discharges the two channel capacitances of next-stage transistors TFTp2 and TFTn2, and the time constant set by this charge/discharge determines the switching speed. Since the channel length of the LDD-type CMOS TFT can be shortened as shown in Fig. 30C, an ON resistance Rp1 of the p-channel TFT and an ON resistance Rn1 of the n-channel TFT are reduced, and the magnitudes of a charge current ip1 and a discharge current in1 are increased. Since an overlapping capacitance Cp02 of the next-stage p-channel TFT and an overlapping capacitance Cn02 of the next-stage n-channel TFT are reduced as described above, and also a capacitance C2 of the channel portion is reduced by the shortening of the channel, the load capacitance under all of the bias conditions (ON state, OFF state, and an intermediate bias) is reduced. In other words, it is clear that a short-channel LDD-type CMOS TFT circuit has a shorter charge/discharge time constant and a higher operating speed than a circuit with TFTs of the ordinary structure. Even although the ON resistance Rp1 of the p-channel TFT and the ON resistance Rn1 of the n-channel TFT become somewhat higher, due to a higher resistance in the LDD portion, than those of the TFTs of the ordinary structure, the operating speed can be increased if the value of the time constant Rp1 × (Cp02 + Cn02 + C2) and of Rn1 × (Cp02 + Cn02 + C2) could be made smaller than those of the TFTs of the ordinary structure.

Examples of the actual transfer characteristics of TFTs formed with the configuration of Fig. 26 are shown in Figs. 31A and 31B. It can be seen from transfer characteristics 42 and 44 of LDD-type TFTs that the ON current is approximately 50% to 60% of that of transfer characteristics 41 and 43 of ordinary TFTs. Since TFTs of the same gate electrode length are compared, this is attributed to the longer effective channel length of LDD-type TFTs. Since the OFF current is greatly reduced, the ON/OFF ratio is increased by at least one order of magnitude. The breakdown voltage between source and drain and the breakdown voltage between source and gate are also greatly increased in the LDD-type TFT. Therefore, if the gate electrode length of an LDD-type TFT is halved, the ON current would remain at or above the same level and the OFF current would decrease by at least one order of magnitude, thus enabling an increase in the breakdown voltage.

Results of simulating the maximum operating frequency of a shift register circuit, based on the characteristics of the tested LDD-type TFT, are shown in Fig. 32. As can be seen from this figure, a short-channel LDD-type TFT circuit can operate at higher speed than a TFT circuit of the ordinary structure.

Moreover, since the LDD-type TFT has a far smaller OFF current, the power consumption of a circuit driven at the same voltage can be reduced, even if the gate electrode length is reduced to about half. In addition, since the breakdown voltage between source and drain and the breakdown voltage between source and gate are far larger with the LDD-type TFT, a high-voltage circuit can be configured if necessary. For example, an electro-optical material that could not be driven by a TFT circuit of the prior art, because it requires a high drive voltage, can be driven easily by such a circuit with LDD-type TFTs. Examples of such an electro-optical material could be a high-molecular weight polymer dispersed liquid crystal (PDLC) or a guest/host type of liquid crystal. The threshold voltage of such a liquid crystal can be increased and, if this liquid crystal is used in a display element of a liquid crystal display device, the angle of visibility thereof can be greatly increased.

In order to balance the ON currents of an n-channel TFT and a p-channel TFT with different carrier mobilities, the gate electrode length of the n-channel TFT is made to be longer than that of the p-channel TFT. In order to operate the CMOS circuit at the highest speed, it is preferable that the ON currents of the two TFTs are approximately the same. In particular, since it is necessary to make the parallel resistances of the two TFTs constant at the operating points in a CMOS analog switch, the resistance of the p-channel TFT must be made sufficiently small. From the point of view of spatial efficiency in the layout, it is more effective to vary the channel length with a constant channel width, than vary the channel width with a constant channel length. Note, however, that if design rule restrictions make it impossible to shorten channels, the channel length could be fixed as the minimum dimension of the gate electrode length, and the n-channel width could be made smaller than the p-channel width. Note also that, with an analog switch or a circuit comprising only an inverter, the channel lengths or widths of the p-channel and n-channel TFTs can be determined comparatively easily. However, with a circuit in which the connections of TFTs of the same polarity are mixed in parallel and in series, such as a NAND gate or NOR gate, it will be necessary to optimize the size of each TFT to suit the objective of that circuit.

A circuit diagram, a pattern diagram, and a wafer cross-sectional view when a CMOS inverter circuit is configured of a single-crystal MOSFET are shown in Figs. 33A, 33B, and 33C, respectively. Similarly, a pattern diagram when a CMOS inverter circuit is configured of a TFT is shown in Fig. 34. With a single-crystal MOSFET, a p-well is necessary for forming the n-channel transistor, and thus the p-channel transistor and the n-channel transistor cannot be place too close together. A single-crystal MOSFET must also be provided with a $p^+$ stopper (guard bar) in a p-well or an $n^+$ stopper in an n- bulk in order to stabilize the potential of the well or n-bulk and prevent the occurrence of latch-up. This stopper must be provided at the boundary between the p-channel transistor and the n-channel transistor, and thus the p-channel transistor and the n-channel transistor must be located even further apart. For that reason, the length in the lateral direction of Fig. 33 is large and thus the area occupied by this circuitry is also large. In contrast, the island-shaped thin semiconductor films of a TFT are completely insulating. Therefore, as shown in Fig. 34 (corresponding to the cross-sectional view of Fig. 27), there is no need to provide a stopper for a TFT, and thus the length in the lateral direction of Fig. 34 can be made small. In comparison with a single-crystal MOSFET, the configuration of a TFT is simple and has the further advantage that the p-channel and n-channel transistors can be freely laid out.

Therefore, the fabrication methods of the first to fifth embodiments plus further use of the LDD structure make it possible to increase the speed of the TFT. If the operating speed could be made to be close to that of a single-crystal MOSFET, the above advantage concerning layout could be used to substitute the TFT configuration into circuits that have had to use single-crystal MOSFETs up until now. TFTs also have the advantage that there are many ways in which their patterns can be arranged, as shown in Fig. 34, and their layout efficiency can also be increased by the channel width constant while varying the channel length.

**Seventh Embodiment**

This embodiment relates to optimization of the conditions for fabricating an LDD-type TFT.

This embodiment first optimizes the maximum impurity concentration (dose) of the LDD portion, then optimizes the maximum impurity concentration (dose) of the source and drain portions, and finally optimizes the LDD length. Thus this embodiment is designed to increase the speed and increase the breakdown voltage of an LDD-type TFT.

The description first concerns the optimization of the maximum impurity concentration of the LDD portion. A characteristic diagram showing the relationship between dose of the LDD portion and ON and OFF currents is shown in Fig. 35, a characteristic diagram showing the relationship between dose of the LDD portion and ON/OFF ratio (ON current/OFF current) is shown in Fig. 36, and a characteristic diagram showing the relationship between dose of the LDD portion and sheet resistance of the LDD portion is shown in Fig. 37. In this case, polycrystalline semiconductor films are prepared in accordance with the first fabrication method described in the section on the background of the invention, with film thickness of approximately 500 Å. It is clear from Fig. 35 that if the dose of the impurity implanted into the LDD portion is too high, it is impossible to reduce the OFF current. For example, Fig. 35 shows that the OFF current drops dramatically at doses of 1 $\times$ $10^{14}$ $cm^{-2}$ or less. If the dose of the LDD portion is high, the concentration of electric field at the drain edges cannot be restrained, and thus the OFF current increases, lowering the breakdown voltages between source and drain and between source and gate. Therefore the dose of the LDD portion is preferably 1 $\times$ $10^{14}$ $cm^{-2}$ or less, and thus the maximum impurity concentration of the LDD portion is preferably that value multiplied by $10^5$, which is 1 $\times$ $10^{19}$ $cm^{-3}$ or less.

On the other hand, if the dose of the LDD portion is too low, the ON current will drop dramatically, as shown in Fig. 36. This is because a reduced dose of the LDD portion increases the sheet resistance at the LDD portion, as is clear from Fig. 37. For example, if the dose of the LDD portion is less than 1 $\times$ $10^{13}$ $cm^{-2}$, the sheet resistance becomes greater than 250 kΩ/□. This increase in the sheet resistance has an extremely bad influence on the total ON-resistance if, for example, the ON resistance of the transistor is as low as approximately 10 kΩ to 20 kΩ. Therefore, the dose of the LDD portion is preferably 1 $\times$ $10^{13}$ $cm^{-2}$ or more.

The ON/OFF ratio is at a maximum when the dose is between 1 $\times$ $10^{13}$ $cm^{-2}$ and 1 $\times$ $10^{14}$ $cm^{-2}$, as shown in Fig. 36, optimally between approximately 2 $\times$ $10^{13}$ $cm^{-2}$ and 5 $\times$ $10^{13}$ $cm^{-2}$.

As described above, the dose of the LDD portion is preferably in the range of approximately between 1 $\times$ $10^{13}$ $cm^{-2}$ and 1 $\times$ $10^{14}$ $cm^{-2}$ and the maximum impurity concentration is preferably in the range of approximately between 1 $\times$ $10^{18}$ $cm^{-3}$ and 1 $\times$ $10^{19}$ $cm^{-3}$. More preferably, the dose of the LDD portion is in the range of approximately between 2 $\times$ $10^{13}$ $cm^{-2}$ and 5 $\times$ $10^{13}$ $cm^{-2}$ and the maximum impurity concentration is in the range of approximately 2 $\times$ $10^{18}$ $cm^{-3}$ to 5 $\times$ $10^{18}$ $cm^{-3}$. This optimizes the maximum impurity concentration of the LDD portion.

Note that the previously mentioned Japanese Patent Application Laid-Open No. 6-102531 discloses that the dose of the LDD portion should be 1 $\times$ $10^{14}$ $cm^{-2}$ or less. However, no lower limit is disclosed with this prior art technique, and there is absolutely no suggestion that there could be a maximum value of the ON/OFF ratio in the dose range of 1 $\times$ $10^{14}$ $cm^{-2}$ to 1 $\times$ $10^{13}$ $cm^{-2}$. The very idea of optimizing the maximum impurity concentration of the LDD portion in this seventh embodiment cannot exist in the techniques of single-crystal LDD-type MOSFETs. This is because the LDD length of a single-crystal LDD-type MOSFET is as short as, for example, approximately 0.1 µm and thus the resistance of this LDD portion has virtually no effect on operating speed. Therefore, there is no need to consider the maximum impurity concentration of the LDD portion with an LDD-type MOSFET. On the other hand, since impurity ions acceleratingly diffuse along with the grain boundaries (accelerated diffusion) in a non-single-crystal LDD-type TFT, as described previously, the LDD length must be made longer than that of a single-crystal MOSFET. Thus the sheet resistance of the LDD portion is not negligible and, in order to implement higher speeds, it is necessary to consider the idea of optimizing the maximum impurity concentration at the LDD portion.

The description now turns to the optimization of the maximum impurity concentration of the source and drain portions. A characteristic diagram showing the relationship between dose of the source and drain portions and diffusion length is shown in Fig. 38 and a characteristic diagram showing the relationship between dose of the source and drain portions and contact resistance in the source and drain portions is shown in Fig. 39. Fig. 38 shows that diffusion length increases as the dose of impurities implanted in the source and drain portions increases. If the diffusion length becomes too large, impurities diffuse into the LDD portion from the drain or source portion, causing problems such as a reduction of the effective LDD length of the LDD portion to zero.

If the LDD portion is formed in a non-self-aligned manner using a photoresist, the LDD length is determined by the dimensions of the photoresist mask. Consider, for example, a case in which the LDD length determined by this mask is assumed to be 4 µm. With this embodiment, the aim is to shorten the channel by making the gate electrode length 5 µm or less, so in order to miniaturize the components the LDD length cannot be set too long, and thus it is preferable that the LDD length is, for example, 4 µm or less. However, in this case, if the dose of the source and drain portions becomes larger than 1 $\times$ $10^{16}$ $cm^{-2}$, the diffusion length also increases to more than 4 µm, as shown in Fig. 38. If this happens, impurities from the source and drain portions diffuse into 4 µm of the whole LDD portion, and thus the effective LDD length becomes zero. If the effective LDD length becomes zero, the function of the LDD portion is lost, and thus the breakdown voltage between source and drain, for example, drops greatly. Therefore, it is preferable that the dose of the source and drain portions is 1 $\times$ $10^{16}$ $cm^{-2}$ or less.

On the other hand, if the dose of the source and drain portions is too low, the contact resistance at the source and drain portions (Rc1 and Rc2 in Fig. 56B) increases. One of the major reasons why an LDD-type TFT is used by this embodiment is to reduce this contact resistance. Therefore, it is preferable that this contact resistance is set as low as possible, to, for example, 3 kΩ or less for a contact hole sized 10 μm□ - (3kΩ/100 $\mu m^2$). It is also preferable in this case that the dose of the source and drain portions is at least $5 \times 10^{14}$ $cm^{-2}$, as shown in Fig. 39. This reduces the contact resistance and enables an increase in speed of the LDD-type TFT.

If a gate electrode length of 5 μm or less is considered and the components are to be miniaturized, the LDD length is preferably in the range of approximately between 1 μm and 2 μm. Therefore, the dose of the source and drain portions in this case is in the range of approximately between $1 \times 10^{15}$ $cm^{-2}$ and $3 \times 10^{15}$ $cm^{-2}$, as is clear from Fig. 38.

Thus it is preferable that the dose in the source and drain portions is in the range of approximately between $5 \times 10^{14}$ $cm^{-2}$ and $1 \times 10^{16}$ $cm^{-2}$ and the maximum impurity concentration is in the range of approximately between $5 \times 10^{19}$ $cm^{-3}$ and $1 \times 10^{21}$ $cm^{-3}$. More preferably, the dose in the source and drain portions is in the range of approximately between $1 \times 10^{15}$ $cm^{-2}$ and $3 \times 10^{15}$ $cm^{-2}$ and the maximum impurity concentration is in the range of approximately between $1 \times 10^{20}$ $cm^{-3}$ and $3 \times 10^{20}$ $cm^{-3}$. This optimizes the maximum impurity concentration of the source and drain portions.

Note that the previously mentioned Japanese Patent Application Laid-Open No. 6-102531 discloses that the dose of the source and drain portions should be in the range of between $1 \times 10^{14}$ $cm^{-2}$ and $1 \times 10^{17}$ $cm^{-2}$. However, this lower numerical value, $1 \times 10^{14}$ $cm^{-2}$, is nothing more that a limit that ensures that the dose is greater than that of the LDD portion. A practical problem with setting the dose to $1 \times 10^{14}$ $cm^{-2}$ concerns the way in which the contact resistance becomes approximately 50 kΩ for a contact hole having the area of 100 $\mu m^2$, as shown in Fig. 39, which cannot be borne by the LDD-type TFT of this embodiment. In other words, since the gate channel length with this prior art technique is 6 μm and thus the ON resistance is so much higher than that of this embodiment, there is no need to worry about lowering such a contact resistance in the prior art. The upper limit of the dose with this prior art technique is $1 \times 10^{17}$ $cm^{-2}$, but a dose so large increases the diffusion length excessively, as shown in Fig. 38. However, there is no need to worry about shortening the channel and miniaturizing the components with this prior art technique, so that if the gate channel length is 6 μm, the LDD length need not be shortened by that amount, and thus the upper limit can be made so large. Thus this prior art technique discloses absolutely nothing about the idea of optimizing the maximum impurity concentration of the source and drain portions to enable the LDD-type to operate at high speed and with a high breakdown voltage. The very idea of optimizing the maximum impurity concentration of these source and drain portions in the seventh embodiment cannot exist in the techniques of single-crystal LDD-type MOSFETs. This is because the phenomenon of accelerated diffusion along the grain boundaries does not occur in a single-crystal LDD-type MOSFET, and thus there is no particular need to consider the effects of diffusion of the impurities from the source and drain portions. Proof of this lies in the way that the LDD length of a single-crystal LDD-type MOSFET is extremely short at, for example, approximately 0.1 μm.

The description now turns to the optimization of the LDD length of the LDD portion. A characteristic diagram showing the relationship between LDD length and ON and OFF currents is shown in Fig. 40, and a characteristic diagram showing the relationship between LDD length and source-drain breakdown voltage is shown in Fig. 41. In this case, the channel and LDD portions are thin polysilicon films with film thickness of 450 Å. The dose of the LDD portion is $3 \times 10^{13}$ $cm^{-2}$. Fig. 40 shows that the OFF current drops suddenly at a certain LDD length and it decreases only slightly at longer LDD lengths. Similarly, the ON current decreases a little at a certain LDD length then decreases gradually at longer lengths, but it only decreases by about one half, in contrast to the drop of at least two orders of magnitude in the OFF current. Fig. 41 shows that there is a huge increase in the breakdown voltage between source and drain (and the breakdown voltage between source and gate too) at the point at which the OFF current suddenly decreases. From observation of these phenomena, it is clear that it is better to ensure that the LDD lengths of all the TFTs in a circuit are greater than length at which the OFF current drops suddenly. If the LDD length is determined in a self-aligned manner by means such as side walls made by the insulation film, the thickness of that insulation film could be made thicker than the necessary LDD length. The minimum value of variations in the LDD length can be at least 1 μm, even when a fabrication method is used in which the LDD length is varied by mask alignment. Assuming that the differences in ON current are comparatively small with TFTs with slightly large LDD lengths, as seen in Fig. 40, this should not cause much of a problem in a digital circuit. With an analog circuit, it will be necessary to set the LDD length in such a manner that the resistance required in the circuit is satisfied, even at the previously estimated maximum LDD length.

Note that the optimum value of the LDD length can be considered as described below. As described previously in the section on the optimization of the source and drain portions, the LDD length should be set to be in a range within which the effective LDD length is not reduced to zero by diffusion from the source and drain portions, and it should be as short as possible from consideration of component miniaturization. Therefore, the LDD length corresponding to the optimal dose of the source and drain portions (which is $5 \times 10^{14}$ $cm^{-2}$ to $1 \times 10^{16}$ $cm^{-2}$, preferably $1 \times 10^{15}$ $cm^{-2}$ to $3 \times 10^{15}$ $cm^{-2}$) is preferably in the range of approximately between 0.6 $\mu$m and 4 $\mu$m, and more preferably in the range of approximately between 1 $\mu$m and 2 $\mu$m.

As described above, the diffusion coefficient in a TFT using a non-single-crystal thin semiconductor film is at least one order of magnitude larger than that of a single-crystal semiconductor, because accelerated diffusion occurs along the grain boundaries. Thus a design method that employs a MOSFET using a single-crystal semiconductor can not be applied to an LDD-type CMOS TFT circuit using a non-single-crystal thin semiconductor film. For example, it is preferable that an LDD length of at least 1 $\mu$m is obtained for each of p-channel and n-channel polysilicon CMOS TFTs. However, since a resistance of approximately 30% to 100% times the ON resistance of the channel portion is connected in series at each end of the channel in a TFT having an LDD length of at least 1 $\mu$m, it is difficult to accurately estimate the TFT current with a prior art MOSFET model. In particular, when a fabrication method is used in which the LDD length is determined in a non-self-aligned manner, the LDD length has large variations of approximately 1 to 4 $\mu$m. In order to improve the TFT characteristics, it is necessary to reduce the film thickness of the channel and LDD portions to 1000 Å or less, preferably 500 Å or less, but this makes it more likely for variations in the sheet resistance of the LDD portion to occur. However, the TFT must either ensure the necessary ON current or operate at the speed necessary for the TFT circuitry, even if the sheet resistance of the LDD portion is maximized and the LDD length is also maximized, and thus a special design method that allows for such cases is necessary. Dedicated LDD-type CMOS TFT circuit models have been developed, which take into account large variations in the assumed range of the resistance of the LDD portion, and which can calculate the resultant effective voltage applied to the channel portion to estimate the ON current, and thus simulations have been performed.

Techniques of making use of a MOSFET using a single-crystal semiconductor are not employed in the fabrication method of LDD-type TFT. For example, with a single-crystal semiconductor, it would be easy to form an LDD structure by using side walls of a thin thermal oxidation film of about 1000 Å, but it is extremely difficult to form defect-free side walls with an insulation film that is about 1 $\mu$m thick. Moreover, problems concerning throughput and variations make it impracticable to implant impurity ions into a thin semiconductor film of 1000 Å or less through such a thick insulation film. Various fabrication methods have been considered, including a method in which the boundaries of the LDD and source and drain portions are not self-aligned using a photoresist, or a method in which the end surfaces of the gate electrode are overetched by 1 $\mu$m or more. All of these methods can be used for pixel TFTs that are part of an active matrix substrate. However, these methods are developed with a rigid main objective of reducing the OFF current, so they cannot be used as is in CMOS TFT circuits designed with the objective of operating at high speeds because of the insufficient ON currents. Thus this embodiment concentrates on the ON current in the optimization of the LDD length and the amount of impurity implanted in the LDD portion, while greatly shortening the channels of both the p-channel and n-channel TFTs in comparison with the prior art. This embodiment also enables impurity implantation at low energy but a high throughput, in order to implant impurities from through a thin gate insulation film. As described above, optimization of the fabrication process enables the implementation of an LDD-type CMOS TFT that is the first to be suitable for high-speed operation.

**Eighth Embodiment**

This embodiment relates to a method of fabricating a CMOS circuit in which an LDD-type TFT is used. Process diagrams of a typical method of fabricating polysilicon TFTs is shown in Figs. 42A to 42D. First a thin polysilicon film 72 patterned as islands is subjected to thermal oxidation to form a thermal oxidation $SiO_2$ film 73 for each TFT, then a gate electrode 74 is formed thereon as shown in Fig. 42A. Photoresist 75 is then coated over a p-channel TFT area, and an impurity that is to form donors is implanted at low concentration, as shown in Fig. 42B. Phosphorus ions are used. Photoresist is once again coated over the entire surface of the p-channel TFT and an area somewhat larger than the gate electrode of the n-channel TFT, as shown in Fig. 42C, and the impurity that is to form donors is implanted at high concentration. This completes the source and drain and channel portions of the n-channel LDD-type TFT. In the same manner, an impurity that is to form acceptors, such as boron ions, is implanted at low concentration and high concentration into regions of the p-channel TFT. Finally, an interlayer insulation film 76 is deposited and metal wiring 77 is patterned, as shown in Fig. 42D.

Since this method enables unrestricted setting of the LDD lengths by a mask pattern, differing LDD lengths can be used, depending on the type of circuit. If an element is always subjected to a fixed bias, the LDD structure of the element can be set for only a single electrode. For example, the LDD structure could be used for the drain portion only.

Another method of forming an LDD-type TFT uses side walls made by an insulation film as a mask. For example, before the high-concentration ion implantation, the gate electrode could be covered by an insulation film made by thermal oxidation or anodic oxidation, or by a new insulation film that could be formed by a deposition method such as chemical vapor deposition and that could cover the electrode surface layer portion with the thickness of at least the necessary LDD length. Note, however, that when a deposition method is used, an insulation film is deposited on the source and drain portions, and thus fairly high-energy ion implantation must be performed if the insulation film is thick. Note also that sections with differing resistances are formed by ion implantation into the same thin semiconductor film, but patterning of the first thin semiconductor films which already have differing resistances and then depositing the second thin semiconductor films overlapping the first could be used instead. Further, amongst semiconductor films of the same crystallinity, the one with the thinner channel portion has the better characteristics, but a thicker film is better for reducing the contact resistance of source and drain portions, so a method that forms a thick impurity-doped semiconductor film in source and drain portions only could be used.

The method of fabricating a TFT of this embodiment can be applied to all LDD-type CMOS TFTs using non-single-crystal thin semiconductor films.

**Ninth Embodiment**

This ninth embodiment combines a fabrication method based on the principle that the nucleus generation rate is retarded and the island growth rate is accelerated with a method of fabricating an LDD-type TFT. A solid-phase crystallization method is used in this ninth embodiment to convert the as-deposited film of an amorphous state to a polycrystalline state. The fabrication method of the ninth embodiment is described below with reference to Figs. 1A, 1B, and Figs. 42A to 42D.

In accordance with the ninth embodiment, an intrinsic silicon film is deposited by LPCVD on a substrate 201. Quartz glass is used as this substrate without an underlying protective film deposited thereon, in order to simplify the process. However, a silicon dioxide ($SiO_2$) film could be deposited by CVD as an underlying protective film, before the semiconductor film is formed, as shown in Fig. 25A. This would provide the following effects: a) the adhesion of the semiconductor film is improved, b) when low-quality inexpensive glass is used as the substrate, impurity ions (such as of Na, K, or Mg) can be prevented from diffusing into the semiconductor film, and c) nucleus generation can be stabilized and the variations in the nucleus generation rate between substrates can be made small. In other words, the size of grains making up the semiconductor film, which is of polycrystalline silicon after the thermal oxidation, can be made constant between substrates.

Using the same LPCVD apparatus as that of the first embodiment, an amorphous silicon film is first deposited. The thickness of the film after deposition is 950 Å. The deposition temperature is 495 °C, monosilane ($SiH_4$) of purity of at least 99.99% is used as the reactant gas, and this gas is supplied into the reaction chamber at a flow rate of 200 sccm. The deposition pressure in this case is 1.3 Torr and the deposition rate of the silicon film under these conditions is 16 Å/minute. The thus deposited silicon film is subjected to patterning to obtain a silicon film 202 (Fig. 1A).

The substrate is then subjected to furnace annealing for approximately 24 hours at 600 °C in a nitrogen atmosphere to convert the amorphous silicon film into a polycrystalline silicon film (solid-phase crystallization method). Note that the furnace annealing temperature in this case is not limited to 600 °C; it is preferably in the range of between 500 °C and 700 °C, and more preferably in the range of between 550 °C and 650 °C.

The patterned surface of the silicon film 202 is subjected to a thermal oxidation method to form a silicon dioxide film 203. This thermal oxidation is performed at a temperature of 1000 °C in a 100% oxygen environment at one atmospheric pressure. The thickness of the silicon film is thus reduced to 600 Å, and thus a silicon dioxide film having film thickness of 700 Å is obtained (Fig. 1B).

A gate electrode 74 is then formed on the thermal oxidation $SiO_2$ film (Fig. 42A). Next, the p-channel TFT is covered with photoresist 75 and an impurity that is to form donors is implanted at low concentration (Fig. 42B). Photoresist is once again coated over the entire surface of the p-channel TFT and an area somewhat larger than the gate electrode of the n-channel TFT, and the impurity that is to form donors is implanted at high concentration (Fig. 42C). This completes the source and drain and channel portions of the n-channel LDD-type TFT. In the same manner, an impurity that is to form acceptors, such as boron ions, is implanted at low and high concentration into regions of the p-channel TFT. Finally, an interlayer insulation film 76 is deposited and metal wiring 77 is patterned, as shown in Fig. 42D. The LDD lengths of the thus-formed LDD-type TFTs are 2.0 $\mu$m on both the p-channel side and the n-channel side. The dose of the LDD regions is $2 \times 10^{13}$ $cm^{-2}$ and the dose in the low-resistance source and drain portions (high-concentration regions) is $1 \times 10^{15}$ $cm^{-2}$.

The transistor characteristics of the thus-formed LDD-type TFT are shown in Fig. 43. The transistor dimensions of the n-channel LDD-type TFT (hereinafter abbreviated to NMOS LDD) are L/W = 2.5 $\mu$m/10 $\mu$m, those of the p-channel LDD-type TFT (hereinafter abbreviated to PMOS LDD) are L/W = 1.5 $\mu$m/10 $\mu$m, and the balance between the current supply capabilities of the NMOS LDD and the PMOS LDD is optimized. As is clear from a comparison of Figs. 2 and 43, the OFF current in this ninth embodiment is restrained to be extremely low. A sufficient ON current is obtained even when Vgs is 5 V or -5 V, thus enabling a lowering of the power voltage. The ON current Ion of this NMOS LDD is 152 $\mu$A (Vds = Vgs = 5 V) and the ON current Ion of the PMOS LDD is 30 $\mu$A (Vds = Vgs = -5 V).

In accordance with this embodiment, the threshold voltage of both the NMOS LDD and the PMOS LDD has little dependency on Vds, enabling a shortening of the channel length. In the prior arts, when the channel length was 4 $\mu$m or less, the dependency of the threshold voltage on Vds was extremely large, making these TFTs in the prior arts unsuitable for practicable use, while this embodiment of the present invention provides a much better characteristic. In practice, in a PMOS LDD variations in the threshold voltage between Vds = -5 V and Vds = -12 V are only about 1 V, and those in the NMOS LDD are only about 0.3 V. If the channel length was 5 $\mu$m or less in the prior art, the corresponding variations in the threshold voltage due to the different values of Vds was at least several volts (5 V or more when L = 4 $\mu$m). The contact resistance can also be made sufficiently small with this embodiment. Since the film quality of the polysilicon film of this embodiment is so good, the sheet resistance can be reduced even if the dose is lowered. In other words, the parasitic resistance of the source and drain portions can be reduced and the ON current can be increased.

The relationship between the maximum clock frequency and supply voltage of a shift register circuit using the LDD-type TFT of this embodiment is shown in the characteristic diagram of Fig. 44. It can be verified from this figure that the shift register circuit of this embodiment (Lgaten = 2.5 $\mu$m, Lgatep = 1.5 $\mu$m) operates at 10 MHz when the supply voltage is 3 V, and it could still operate at sufficient speed when the power voltage drops to 2 V or less. In contrast, the TFT of a comparative example (with an ordinary structure), the operating speed is much slower at a power voltage of 3 V and the shift register circuit is virtually unable to operate at below 1.5 V.

The contact resistance, source and drain resistance, and LDD resistance of the LDD-type TFTs in accordance with this embodiment and comparative examples are measured, with the results being as shown in Fig. 45. The comparative examples are prepared by the first fabrication method of the prior art. As shown in Fig. 45, the contact resistance, source and drain resistance, and LDD resistance of the transistors of this embodiment are all less than those of the comparative examples. In particular, it can be seen that the source and drain resistances are far lower (one-fifth to one-fiftieth) than those of the comparative examples. In particular, since the crystallinity of the polysilicon film of this embodiment is so high, the sheet resistance of the LDD portion is low, even when the dose of the LDD portion is low. In the prior art, when an LDD structure is used, the sheet resistance of the LDD portion is so high that it is not possible to avoid a drop in the ON current. However, sheet resistance of the LDD portion in accordance with this embodiment is low enough that the parasitic resistance generated within the LDD portion can be minimized.

Note that the description here concerns the relationship between the implantation dose and the maximum impurity concentration within the semiconductor film. When the dose amount is denoted by N0 ($cm^{-2}$), the impurity concentration N(x) ($cm^{-3}$) is given by:

$$N(x) = N0/(2\pi)^{1/2}(\Delta Rp) \times \exp\{-(X - Rp)^2/2(\Delta Rp)^2\}$$

X: Distance from the surface
N(x): Concentration at x
Rp: Range
$\Delta$Rp: Range deviation

Therefore, the maximum impurity concentration Nmax is given by:

$$Nmax = N\,(X = Rp) = N0/(2\pi)^{1/2}(\Delta Rp)$$

When the thickness of the gate insulation film (G-$SiO_2$) of the TFT is around 1000 Å to 1500 Å, the range deviation of ion implantation into the semiconductor film through the G-$SiO_2$ is about 400 Å (ΔRp ~ 400 Å). Therefore, Nmax is given by:

$$Nmax = N0/(2\pi)^{1/2}(\Delta Rp) = N0 \times 10^5$$

Thus, in Fig. 45, for example, when the dose N0 is $1 \times 10^{13}$ $cm^{-2}$, the maximum impurity concentration Nmax in the semiconductor film is $1 \times 10^{18}$ $cm^{-3}$.

Various calculations are performed below to compare the comparative examples and the TFTs of this embodiment, based on the data of Fig. 45. Note that, since the contact resistance is inversely proportional to the area of the contact hole, the following values apply:

| Contact Hole Size | Comparative Example | Present Embodiment |
|---|---|---|
| 10 µm × 10 µm | 1.4 kΩ | 1.2 kΩ |
| 6 µm × 6 µm | 3.9 kΩ | 3.3 kΩ |
| 4 µm × 4 µm | 8.8 kΩ | 7.5 kΩ |
| 2 µm × 2 µm | 35 kΩ | 30 kΩ |
| 1 µm × 1 µm | 140 kΩ | 120 kΩ |

First, the parasitic resistances of NMOS and PMOS TFTs of comparative examples and this embodiment, when used in the shift register as shown in Fig. 44, are compared.

**(1) This Embodiment (NMOS)**

The dose of the LDD portion of the NMOS TFT in the shift register of Fig. 44 is $2 \times 10^{13}$ $cm^{-2}$. Therefore, it can be seen from Fig. 45 that the sheet resistance of the LDD portion is 36 kΩ/n. The parasitic resistance in this case is calculated as follows:

Contact hole size = 100 $\mu m^2$

Contact resistance = 1.2 kΩ

Resistance of source and drain portions = (length of source and drain portions ÷ width of source and drain portions ) × sheet resistance of source and drain portions = (7 µm/14 µm) × 530 Ω/□ = 0.265 kΩ

Resistance of LDD portion = (length of LDD portion ÷ width of LDD portion) × sheet resistance of the LDD portion

= (2 µm/10 µm) × 36 kΩ/□ = 7.2 kΩ

Overall parasitic resistance = (contact resistance + resistance of source and drain portions + resistance of LDD portion) × 2

= (1.2 kΩ + 0.265 kΩ + 7.2 kΩ) × 2

= 17.33 kΩ

Note that, since the ON-state channel resistance is 15.56 kΩ, the total ON-state resistance Ron is given by:

Ron = 17.33 kΩ + 15.56 kΩ = 32.89 kΩ

Therefore, the ON current Ion is given by:

Ion = Vds/Ron = 5V/32.89 kΩ = 152 µA

**(2) NMOS (Comparative Example)**

Contact resistance = 1.4 kΩ
Resistance of source and drain portions = (7 μm/14 μm) × 2.6 kΩ/□ = 1.3 kΩ
Resistance of LDD portion = (2 μm/10 μm) × 180 kΩ/□ = 36 kΩ
Overall parasitic resistance = (1.4 kΩ + 1.3 kΩ + 36 kΩ) × 2
= 77.4 kΩ

Thus, since the overall parasitic resistance in the comparative example is large, it is not possible to lower the total ON-state resistance Ron, even when the channel is shortened and thus the ON-state channel resistance is reduced. In contrast, the parasitic resistance in accordance with this embodiment does not become large even if LDD is implemented. This tendency is particularly obvious with a PMOS LDD, as shown below.

**(3) PMOS (This Embodiment)**

Contact resistance = 1.18 kΩ
Resistance of source and drain portions = (7 μm/14 μm) × 50 kΩ = 0.025 kΩ
Resistance of LDD portion = (2 μm/10 μm) × 13 kΩ = 2.6 kΩ
Overall parasitic resistance = (1.18 kΩ + 0.025 kΩ + 2.6 kΩ) × 2
= 7.61 kΩ

**(4) PMOS (Comparative Example)**

Contact resistance = 1.4 kΩ
$p^+$ source and drain resistance = (7 μm/14 μm) × 2.6 kΩ = 1.3 kΩ
$p^-$ source and drain resistance = (2 μm/10 μm) × 375 kΩ = 75 kΩ
Overall parasitic resistance = (1.4 kΩ + 1.3 kΩ + 75 kΩ) × 2
= 155.4 kΩ

Thus there is a particularly dramatic difference between the overall parasitic resistance of a PMOS TFT of this embodiment and that of the comparative examples.

The description now turns to calculating the parasitic resistance when the contact holes become smaller as miniaturization increases. As an example, consider the case in which the contact hole size is 2 μm × 2 μm = 4 $\mu m^2$.

**(5) This Embodiment (LDD Structure)**

As described previously, an important problem raised by recent advances in miniaturization is the way in which the contact resistance is becoming less. That is why the contact portion is provided at high-concentration source and drain portions, and the doses are such that the dose in the high-concentration portions is 3 × $10^{15}$ $cm^{-2}$ and that in the LDD portion (low-concentration portion) is 2 x $10^{13}$ $cm^{-2}$. Assume that the LDD length is 1 μm. First, as is clear from Fig. 39, if the dose of the source and drain portions is set to 3 × $10^{15}$ $cm^{-2}$, the contact resistance of a 10 μm × 10 μm contact hole decreases to approximately 0.1 kΩ. Thus the contact resistance of a 2 μm × 2 μm contact hole would be 2.5 kΩ.

Contact resistance = (100 $\mu m^2$/4 $\mu m^2$) × 0.1 kΩ = 2.5 kΩ

Next, the resistances of the high-concentration source and drain portions and the LDD portion are obtained. The description below is based on consideration of the model shown in Fig. 46. The channel width is 10 μm and the channel length (gate length) is 2.5 μm. The distance from the edge portion of the gate electrode to the center of the contact hole is 4.5 μm, of which 1.0 μm is the LDD length. Since the LDD portion has a dose of 2 × $10^{13}$ $cm^{-2}$, Fig. 45 shows that the sheet resistance is 36 kΩ/□. Since the LDD length is 1.0 μm and the width of the LDD portion is 10 μm, the resistance of the LDD portion is given by:

1 μm/10 μm × 36 kΩ = 3.6 kΩ

Since the dose of the high-concentration source and drain portions is $3 \times 10^{15}$ $cm^{-2}$, three times that of the examples in Fig. 45, their sheet resistance is 1/3 or less of 30Ω/□. The length of the high-concentration source and drain portions is the distance to the center of the contact hole (4.5 µm) less the LDD length (1 µm). Thus the resistance of the source and drain portions is:

$$(4.5\ \mu m - 1.0\ \mu m)/10\ \mu m \times 530\ \Omega/3 = 0.062\ k\Omega$$

Therefore:

$$\text{Overall parasitic resistance} = (2.5\ k\Omega + 0.062\ k\Omega + 3.6\ k\Omega) \times 2 = 12.32\ k\Omega$$

$$\text{ON-state channel resistance} = 15.56\ k\Omega$$

$$Ron = 12.32\ k\Omega + 15.56\ k\Omega = 27.88\ k\Omega$$

**(6) Comparative Example (Ordinary Self-Aligned Structure)**

With an ordinary self-aligned structure, the results are as described below. In order to avoid problems such as punch-through in the previously described ordinary structure, the minimum channel length must be more than 5 µm and it is not possible to have an implantation dose of $1 \times 10^{15}$ $cm^{-2}$ or less. In that case, the contact resistance taken from Fig. 45 is given by:

$$\text{Contact resistance} = (100\ \mu m^2/4\ \mu m^2) \times 1.2\ k\Omega = 30\ k\Omega$$

If the length of the high-concentration source and drain portions is assumed to be in the same as that described in (5) above, and the length up to the center of the contact hole is 4.5 µm:

$$\text{Resistance of source and drain portions} = 4.5\ \mu m/10\ \mu m \times 530\ \Omega = 0.24\ k\Omega$$

Therefore:

$$\text{Overall parasitic resistance} = (30\ k\Omega + 0.24\ k\Omega) \times 2 = 60.48\ k\Omega$$

On the other hand, since the channel length is long at 5 µm, the channel resistance in the ON state is increased more than twice in comparison with the 15.56 kΩ obtained when the channel length is 2.5 µm, and is approximately 33 kΩ.

$$\text{ON-state channel resistance} = 33\ k\Omega$$

As a result:

$$Ron = 60.48\ k\Omega + 33\ k\Omega = 93.48\ k\Omega$$

As described above, as miniaturization progresses and contact holes become smaller, the overall parasitic resistance in the LDD-type TFT becomes much less than that of an ordinary structure. Moreover, since the channel length is shorter and the channel resistance is lower, Ron is effectively reduced even further.

Calculations for proving why the LDD structure has a greater ON current than an ordinary structure will now be discussed, with reference to the previously described Fig. 29. Note that the calculations below are based on the model of Fig. 46.

**(7) This Embodiment (LDD Structure with L = 2.5 µm)**

Consider a case in which the contact hole size is 6 µm × 8 µm = 48 $\mu m^2$, the dose of the source and drain portions is $3 \times 10^{15}$ $cm^{-2}$, the dose of the LDD portion is $2 \times 10^{13}$ $cm^{-2}$, and the LDD length is 1.0 µm.

Contact resistance = (100 $\mu m^2$/48 $\mu m^2$) × 0.1 kΩ
= 0.208 kΩ
Resistance of source and drain portions = (4.5 μm - 1.0 μm)/10 μm × (530 Ω/3)
= 0.062 kΩ
Resistance of LDD portion = (1 μm/10 μm) × 36 kΩ = 3.6 kΩ
Overall parasitic resistance = (0.208 kΩ + 0.062 kΩ + 3.6 kΩ) × 2
= 7.74 kΩ
ON-state channel resistance (L/W = 2.5 μm/10 μm) = 15.56 kΩ

Therefore, the total resistance in the ON state is given by:

Ron = 7.74 kΩ + 15.56 kΩ = 23.3 kΩ

**(8) Comparative Example (Ordinary Structure)**

Consider a case in which the minimum channel length is 5 μm and the dose of the source and drain portions for preventing punch-through is 1 × $10^{15}$ $cm^{-2}$.

Contact resistance = (100 $\mu m^2$/48 $\mu m^2$) × 1.2 kΩ = 2.5 kΩ
Length of source and drain portions = length to contact hole center = 4.5 μm
Resistance of source and drain portions = (4.5 μm - 1.0 μm)/10 μm × 530 Ω
= 0.24 kΩ
Overall parasitic resistance = (2.5 kΩ + 0.24 kΩ) × 2
= 5.48 kΩ
ON-state channel resistance (L/W = 5 μm/10 μm) = 33 kΩ

Therefore, the total resistance in the ON state is given by:

Ron = 5.48 kΩ + 33 kΩ = 38.48 kΩ

As described above, the overall parasitic resistance of an LDD structure is fairly large at 7.74 kΩ, but the total ON-state resistance can be made 40% smaller.

Note that, since the maximum processing temperature is set to 1000°C in this ninth embodiment, at first an amorphous semiconductor (a-Si) film is deposited at a deposition temperature of 495°C and a deposition rate of 16 Å/minute, secondly the A-Si film is crystallized by solid phase crystallization method, and finally thermal oxidation is performed. However, the throughput with a solid-phase crystallization method is bad and thus it may be impracticable from the fabrication viewpoint. If solid-phase crystallization is omitted for that reason, the thermal oxidation temperature could be increased by approximately 100°C to produce exactly the same effect as a TFT obtained by solid-phase crystallization. In other words, if solid-phase crystallization is not performed in accordance with this embodiment, the thermal oxidation temperature can be set to 1100°C to obtain the same quality film as the one using solid-phase crystallization.

To reduce the processing temperature and create a CMOS circuit that operates at high speed from TFTs, the deposition of the amorphous film is ideally performed at 530°C or less, as shown in Fig. 16. In general, there are many defects within the crystals of a film obtained by solid-phase crystallization, but there are fewer defects within a film that is crystallized from a film deposited at a temperature of 530°C or less. Not only Fig. 16 but also Fig. 45 prove that, when atoms of an impurity such as boron (B) have been implanted into the semiconductor film (polycrystalline silicon film) obtained by this embodiment, the sheet resistance of the source and drain portions is as low as 50 Ω/□, compared with rather high resistance of 2.6 kΩ/□ of comparative examples. After the boron atoms have been implanted into semiconductor film, these implanted impurity atoms are normally activated (boron or other atoms correctly positioned at the Si lattice points) by annealing at 800°C to 1000°C (in this embodiment, for 20 minutes at 1000°C in a nitrogen atmosphere). If activation is for 20 minutes at 1000°C, nearly 100% of the implanted impurity atoms are activated. Although comparative examples and semlconductor films in accordance with this embodiment have the same impurity dose (see Fig. 45) and the activation ratios of both are nearly 100%, there is a difference in the resultant source and drain resistances, as shown in Fig. 45. This is because the semiconductor films in accordance with this embodiment have fewer crystal defects than the comparative examples. Thus, the leakage current in the OFF state is reduced (see Fig. 16), the collision times of the electrical conductors (holes with a PMOS device; electrons with an NMOS device) are extended, the probability of scattering due to crystal defects, etc., is reduced, and thus the source and drain resistance is reduced. Regardless of whether solid-phase crystallization is performed before the thermal oxidation, the poly-crystalline film converted from the amorphous film that has been deposited at 530°C or less has far fewer crystal defects. It should be obvious that a deposition rate of 6 Å/minute or more is preferable for making the grains of a polycrystalline film large, and, from consideration of mass production and transistor characteristics, this rate is ideally 12 Å/minute or more. This condition makes the grains larger and increases the carrier mobility.

The description now turns to the reasons why high-speed operation is implemented by a CMOS circuit of LDD-type TFTs fabricated by a method that uses the principle that the nucleus generation rate is retarded and the island growth rate is accelerated.

A. Since the semiconductor film is made of large-area grains (the carrier mobility is large) and there are few defects within the crystals (the leakage current in the OFF state is small, and the subthreshold swing from the OFF state to the ON state is extremely small), the channel resistance Rch(on) in the ON state is reduced.

B. For the same reasons, the sheet resistances of the LDD and source and drain portions are reduced. In other words, the use of the LDD structure can restrain increases in parasitic resistance to a minimum.

C. The contact resistance can be held small, even when components are miniaturized.

D. Channels can be shortened.

E. Gate insulation films can be made thinner.

F. Yj (overlapping portions between source or drain and the gate electrode) can be made small.

The above reasons A to E increase the ON current, and reasons D and F reduce the transistor capacitance.

A method of fabricating an LDD-type TFT, using the principle that the nucleus generation rate is retarded and the island growth rate is accelerated, enables a broadening of the setting ranges of various fabrication-related parameters. As described previously with respect to the seventh embodiment, the dose range of the LDD portion (particularly the lower limit) is required for setting conditions for optimizing the transistor ON/OFF ratio. In contrast, with this ninth embodiment, since the sheet resistance is 1/5 or less of that of the prior art, as shown in Fig. 45, the lower limit of the dose can be set to be 1/5 or less for the same sheet resistance. In other words, the dose of the LDD portion in accordance with this ninth embodiment can be reduced to approximately $2 \times 10^{12}$ $cm^{-2}$. Thus the impurity dose of the LDD portion of an LDD-type TFT fabricated by using the principle that the nucleus generation rate is retarded and the island growth rate is accelerated is preferably in the range of between $2 \times 10^{12}$ $cm^{-2}$ and $1 \times 10^{14}$ $cm^{-2}$. The preferable range of maximum impurity concentration is $2 \times 10^{17}$ $cm^{-3}$ to $1 \times 10^{19}$ $cm^{-3}$.

With the previously described seventh embodiment (an LDD-type TFT fabricated without using the principle that the nucleus generation rate is retarded and the island growth rate is accelerated), the range of LDD length is 0.6 $\mu$m to 4 $\mu$m, due to the restriction of accelerated diffusion along the grain boundaries from the high-dose-concentration regions. On the other hand, since the grain boundaries in an LDD-type TFT fabricated using the principle that the nucleus generation rate is retarded and the island growth rate is accelerated are so much smaller (see and compare Figs. 4 and 5), the accelerated diffusion is also less. Therefore, use of the principle that the nucleus generation rate is retarded and the island growth rate is accelerated enables a shortening of the minimum LDD length to approximately 0.3 $\mu$m. In other words, the LDD length of an LDD-type TFT fabricated by using principle that the nucleus generation rate is retarded and the island growth rate is accelerated is now preferably in the range of between 0.3 $\mu$m and 4 $\mu$m. Note that it should be obvious that this enabling of a shortening of the LDD length also reduces the parasitic resistance based in the LDD portion.

The description now turns to the positional relationship between LDD portions 216 and 218 and contact holes 232 and 234, with reference to the model of Fig. 46. As described above, the LDD length is preferably shortened within a range such that the effective LDD length is not reduced to zero by accelerated diffusion from the high-dose-concentration source and drain portions. It is also preferable that the contact holes 232 and 234 are located close to a gate electrode 210, in order to reduce the sheet resistance of the corresponding source portion 212 and drain portion 214, or to increase the degree of integration of the circuit. On the other hand, it is preferable that the contact holes 232 and 234 are opened within the high-dose-concentration source and drain portions 212 and 214, in order to reduce the contact resistance. These conditions imply that ideally the edges 224 and 226 of the contact holes 232 and 234 closest to the gate electrode 210 should be aligned with the boundaries between LDD portions 216 and 218 and the source and drain portions 212 and 214 (boundaries 220 and 222 indicated by broken lines in Fig. 46). This is because it would reduce the contact resistance and also reduce the resistance of the source and drain portions, and also enable miniaturization of the components.

However, in practice, factors such as slipping of masks make it extremely difficult to align the contact hole edges 224 and 226 with the boundaries 220 and 222. In this case, the contact holes 232 and 234 could be located so that they intrude slightly into the LDD portions 216 and 218. Alternatively, they could be located so that they are slightly outside the LDD portions. Experiments performed by the present inventors have determined that no problems are caused if discrepancies in the locations of the edge 224 and 226 and the boundaries 220 and 222 lead to approximately 20% of the contact hole areas intruding into the LDD portions. In the example shown in Fig. 46, the length of each contact hole is 6.0 µm, so that there will not be any large increase in the contact resistance if the contact holes intrude by 1.2 µm into the LDD portions.

Consider the case in which the edges 224 and 226 are aligned to the boundaries 220 and 222 on the mask, by way of example. In this case, if a slippage of the mask should cause the contact hole 232 on the source portion side to intrude by 1.2 µm into the LDD portion 216, the other contact hole 234 will be 1.2 µm outside the other LDD portion 218. This means that the distance from the edge 224 to the gate electrode 210 is 0.8 µm and the distance from the edge 226 to the gate electrode 210 is 3.2 µm.

Now, the sum of the source-side LDD length Lldds and the drain-side LDD length Llddd (Lldds + Llddd) is ideally equal to the sum of the distance Lconts from the source-side contact hole edge 224 to the gate electrode 210 and the distance Lcontd from the drain-side contact hole edge 226 to the gate electrode 210 (Lconts + Lcontd). In addition, to reduce the parasitic resistance, it is preferable that the following conditions are satisfied:

$$0.8 \times \text{Lldds} \leqq \text{Lconts} \leqq 1.2 \times \text{Lldds}$$
$$0.8 \times \text{Llddd} \leqq \text{Lcontd} \leqq 1.2 \times \text{Llddd}$$

Note that the NMOS and PMOS TFTs making up CMOS TFT circuit of this embodiment both have an LDD-type configuration. However, when a semiconductor film is provided by a deposition method by which nucleus generation is retarded and island growth is accelerated, the PMOS source and drain sheet resistance, which is 50 Ω/□ even at a dose of $1 \times 10^{15}$ $cm^{-2}$, as shown in Fig. 45, is 1/50 or less of the 2.6 kΩ/□ of the comparative examples. The sheet resistance of the PMOS LDD portion, which is 13 kΩ/□, is also 1/30 or less of the 375 kΩ/□ of the comparative examples. As previously described, the semiconductor film obtained by this embodiment is made up of large crystal grains and there are few defects within the crystals. To make use of such a good-quality semiconductor film, the source and drain portions implanted with acceptors to high concentration could be omitted and the entire source and drain portion region could be made a low-concentration region, at least on the PMOS side. In other words, the NMOS side of the CMOS circuit would have the same LDD structure as the NMOS TFT shown in Fig. 26, but the PMOS TFT could have the ordinary self-aligned structure shown in Fig. 27, with the acceptors being simply implanted into the source and drain regions at a concentration dose. The parasitic resistance of a transistor is the resistance of the source and drain portions plus the contact resistance, but the low-concentration impurity implantation of this embodiment makes the sheet resistance sufficiently low. If the metal wiring is the electrically conductive material such as aluminum (Al), indium (In), indium tin oxide (ITO), palladium (Pd), or platinum (Pt), which forms a p-type thin-film semiconductor layer on the junction surface between the electrically conductive material and the semiconductor film, the contact resistance can be held low. Since this conductive material in contact with silicon surface forms p-type semiconductive layer, it has the same electrical characteristics as a source and drain of a p-type semiconductor in which boron or the like is implanted, and thus it exhibits good contact characteristics. Thus, if the PMOS source and drain portions are formed of an ordinary self-aligned structure and the concentration of the implanted impurity is set to be in the range of between $5 \times 10^{17}$ $cm^{-3}$ (in dose terms: $5 \times 10^{12}$ $cm^{-2}$) and $5 \times 10^{19}$ $cm^{-3}$ (in dose terms: $5 \times 10^{14}$ $cm^{-2}$), a CMOS circuit capable of high-speed operation is obtained, without having to use an LDD-type structure. The maximum impurity concentration of the PMOS source and drain portions is preferably varied by adjusting the gate length Lgatep. If the gate length is 4 µm or more, the maximum impurity concentration of the PMOS source and drain portions is preferably in the range of between $5 \times 10^{18}$ $cm^{-3}$ (dose: $5 \times 10^{13}$ $cm^{-2}$) and $5 \times 10^{19}$ $cm^{-3}$ (dose: $5 \times 10^{14}$ $cm^{-2}$). With a gate length of 4 µm or less, the maximum impurity concentration of the PMOS source and drain portions is preferably in the range of between $5 \times 10^{17}$ $cm^{-3}$ (dose: $5 \times 10^{12}$ $cm^{-2}$) and $5 \times 10^{18}$ $cm^{-3}$ (dose: $5 \times 10^{13}$ $cm^{-2}$). By making the entire region of the source and drain portions of low concentration in the PMOS side alone, the process of fabricating the TFT can be reduced by one photoprocessing step in comparison with the fabrication of a PMOS LDD-type TFT, which not only simplifies the process; it also makes it easier to integrate the circuits.

**Tenth Embodiment**

This embodiment describes how the present invention can be applied to an active matrix liquid crystal display device. An active matrix liquid crystal display device comprises three main components: an active matrix portion 81, a data driver portion 82, and a scan driver portion 83, as shown in Fig. 47. The active matrix portion 81 comprises signal lines 90, scan lines 91, and pixel TFTs 92 provided at the intersections between the signal and scan lines, as well as a liquid crystal capacitance 94 and a storage capacitance 93 connected to the drain edges of each of the pixel TFTs. Since these pixel TFTs are of the same LDD type as the TFT of the peripheral drive circuits, an OFF resistance that is sufficiently high in comparison with the liquid crystal can be achieved, and thus the generation of crosstalk can be prevented. Provided a field-effect type of liquid crystal is used as the liquid crystal material of the active matrix portion, various different materials can be used therefor, not just twisted nematic liquid crystals. An LDD-type COMS TFT circuit having high value of breakdown voltage can easily drive the liquid crystal, that need comparatively high voltage to be driven, such as a polymer dispersed liquid crystal or a guest/host type of liquid crystal.

The data driver portion 82 comprises a shift register 84, a level shifter 85, video lines 87, and analog switches 86. If the video signal writes serially to the signal lines one at a time, the number of stages of the shift register would equal the number of signal lines, but if it writes to n signal lines simultaneously, the number of stages could be 1/n times the number of signal lines. In a liquid crystal display device using color filters, it is common that the number of video lines is to be set to the value obtained by the number of colors in the color filters multiplied by any integer, because this configuration can leave out color rotation in the video signal applied to the video lines. Since the analog switch 86 must be able to write the video signal to the signal lines at an extremely high speed, it must have a high gate voltage. Therefore, the level shifter 85 raises the voltage of sampling pulses to a sufficiently high level. The scan driver portion 83 comprises a shift register 88 and a level shifter 89, and selects scan lines of the active matrix portion in synchronization with the video signal. Since these peripheral drive circuits can be made to operate at higher speeds by configuring them of LDD-type CMOS TFT circuits, a sufficiently fast operating speed can be achieved even at a lower drive voltage. For example, a shift register circuit using prior art TFTs requires a high drive voltage in the region of 10 V, but the shift register circuit using the LDD-type CMOS TFTs of the present invention can achieve a sufficiently high operating speed at the TTL level, that is, at a voltage of 5 V. Thus the outputs of an external timing controller could all be set to the TTL level, and the circuitry can be made more compact and with a lower power consumption. If the controller is also integrated on the substrate using TFTs, the device could be made even more compact.

This circuit diagram illustrates an active matrix liquid crystal display device that uses a dot-sequential analog method, but this embodiment could equally well be applied to a line-sequential analog method or digital method, using LDD-type CMOS TFT circuits to enable high-speed operation.

A specific pixel pattern will now be described. A plan view and cross-sectional view of a pixel portion of a liquid crystal display device using LDD-type TFTs in the pixels are shown in Figs. 48A and 48B. In general, in order to obtain a bright screen for a liquid crystal display device, the aperture portion of each pixel must be made large, but since an increase in resolution results in a decrease in pixel pitch, it is important to form as large an aperture portion as possible with such a small pixel pattern. In this example, the design minimizes the decrease in aperture area due to the existence of the pixel TFT by using the gate line 102 without modification as a gate electrode and placing the pixel TFT under the metal line 103. The decrease in aperture area is further minimized by forming the storage capacitance with one electrode of a thin semiconductor film 104 which extends under the previous-stage gate line and another electrode of the previous-stage gate line. Since the metal line 103 is sandwiched between a first interlayer insulation film 105 and a second interlayer insulation film 106, a transparent conductive film 101 that directly drives the liquid crystal overlaps both the gate line and the metal line but does not short them. If a non-transparent film of a material such as a high-melting-point metal is used in the gate line 102, it can also function as a light-shielding layer as well as metal line, and thus it becomes unnecessary to use a black matrix that is ordinarily formed on opposing substrates, which enables a further increase in aperture efficiency.

The above embodiment has been described with reference to a liquid crystal display device, but this LDD-type CMOS TFT can equally well be used in another type of flat-panel displays. For example, an active matrix display device could also be implemented by using an electro-optical material that is not a liquid crystal. Since an LDD-type TFT circuit has a high breakdown voltage, it is particularly suitable for driving a material with a high drive voltage.

If the switching circuitry of the active matrix portion is formed of electro-optical conversion circuits, this embodiment can also be used to implement electroluminescent displays and plasma displays

**Eleventh Embodiment**

This embodiment gives a specific example of a CMOS circuit using LDD-type TFTs. A circuit diagram and a timing chart of an example of a bidirectional shift register are shown in Figs. 49A and 49B. As shown in Fig. 49A, this shift register is a combination of four clocked gates. The attached arrows and symbols show that each gate operates as an inverter when the indicated signals are high and is at high impedance when the signals are low. When R is high and L is low, the shift register transfer signals to right direction (a right shift); when R is low and L is high, it becomes a left shift. CL is a clock signal that determines the timing of the shift, and the bar over CL indicates that the clock signal is 180° out of phase.

The operation of this circuit will now be described with reference to Fig. 49B. First of all, for a right shift, one of the four gates to which the L signal is input is always in the high-impedance state, and data is transferred by the remaining three gates. If a waveform is applied to the DR portion at the left end, as shown in the figure, the same waveform is shifted to the right at each half-cycle of the clock signal. As a result, pulses for the half clock cycle are output at the points of P and Q as shown in the figure. Similarly, for a left shift, one of the four gates to which the R signal is input is always in the high-impedance state, and data is transferred by the remaining three gates. If a waveform is applied to the DL portion at the right end, as shown in the figure, the same waveform is shifted to the left at each half-cycle of the clock signal. As a result, pulses for the half clock cycle are output at P and Q as shown in the figure.

In general, a bidirectional shift register has the disadvantage that it operates at a slower speed than a single-direction shift register, but if the LDD-type CMOS TFT circuits of the present invention are used, even a bidirectional shift register will achieve an operating speed equal to or exceeding that of a single-direction shift register. When this bidirectional shift register is used in a liquid crystal display device, it simply enables mirror-reflected inversion of the screen image so that the same device can be used for both a front projector and a rear projector, for example. Similarly, in a liquid crystal projector where each of three R, G, and B light is allowed to pass through their own liquid crystal display device and the lights are combined for projection, restrictions on the optical system dictate that at least one of the three liquid crystal display devices has to display a mirror-reflected image. However, if this bidirectional shift register is used, the same type of liquid crystal display device can be used for all three colors in the system.

A circuit diagram and a timing chart of an example of a single-direction shift register are shown in Figs. 50A and 50B. In the example shown in Fig. 50A, paired shift registers are used. A NOR gate shortens the pulse widths of outputs from these two shift registers to be output. Fig. 50B shows that two clock signals CL2 are delayed by 90° from two clock signals CL1. When the waveforms shown at D1 and D2 in Fig. 50B are applied to the left end of the circuit, the paired shift registers each shift the waveforms to the right at each half-cycle of the clock signal. As a result, the waveforms shown at P and Q in Fig. 50B are output from the NOR gates. Since the frequency of the output pulses of this circuit can be made to be four times the clock frequency, it can provide an extremely fast circuit. If this circuit is made up of the LDD-type CMOS TFTs of the present invention, an HDTV-compatible high-speed data driver can be provided.

A circuit diagram and a timing chart of an example of a level shifter are shown in Figs. 51A and 51B. This circuit is used to convert the voltage of portions that drive the logic portion and active matrix of a liquid crystal display device. As shown in Fig. 51 A, the input signals and inversions of these input signals are input to an n-channel TFT and a p-channel TFT. Outputs OUT1 and OUT2 are extracted from connecting portions between two cascade-connected p-channel TFTs and these input TFTs. The two cascade-connected p-channel TFTs are connected to a power voltage VDD at a level higher than the input signal levels. When a VCC-level input signal IN is applied, the two outputs OUT1 and OUT2 output VDD-level signals, as shown in Fig. 51B. This circuit has the p-channel TFTs connected on the input side, which control the current flowing to another p-channel TFTs on the VDD side to prevent misoperation of the circuit. In general, a level shifter must operate at a sufficiently high speed, even at a low input voltage, and the breakdown voltage between source and drain must be sufficient if the output voltage should rise. Both the n-channel and p-channel LDD-type TFTs of the present invention enable the implementation of sufficiently high operating speeds and high breakdown voltages, thus greatly improving the capabilities of level shifter TFT circuits.

A circuit diagram of an example of an analog line-sequential data driver is shown in Fig. 52. Since a continuous current with a DC bias flows through this analog buffer circuit, it has been difficult up until now to make up such a circuits of TFTs, from the reliability point of view. However, since an LDD-type CMOS TFT is extremely reliable and its characteristics tend not to change while a current continues to flow therethrough for a long period, it enables the implementation of a driver using an analog buffer circuit. A video signal from a video line Vid is temporarily held in an analog latch A, then is transferred to an analog latch B by latch pulses LP at a certain timing. The signal in the analog latch B is always supplied to an analog buffer, so that the analog buffer can write with sufficient efficiency to the signal line of a fairly large liquid crystal display device.

A circuit diagram of an example of a 2-bit digital data driver is shown in Fig. 53. In general, an n-bit digital driver writes a number n of digital input signals D1, D2...Dn to a group of n latches A, then to a group of n latches B at a certain timing. The data in the latches B select one of $2^n$ analog switches according to a decoder, and one voltage from a group of $2^n$ drive voltages V1, V2...Vn is written to a signal line. With a multi-bit digital driver, some of the drive voltages are generated by being supplemented internally. To simplify the driver circuit, a combination of methods are used, such as a frame rate control method that supplements gradation data by using a plurality of frames and an area gradation method that supplements gradations by a plurality of pixels, and D/A conversion by a pulse width modulation could also be used. Since the LDD-type CMOS TFT circuits of the present invention enable such digital circuits to operate at high speed, they can enable the implementation of a high-definition data display.

Complicated circuits could be made up by combining these simple circuits. For example, a timing controller that supplies timing signals to peripheral drive circuits of a display device could be made up of the high-speed CMOS TFT circuits of the present invention. Since these LDD-type CMOS TFTs are so reliable there is no fear of them breaking down, they can easily be used in op amps, digital-to-analog conversion circuits, analog-to-digital conversion circuits, and memory circuits. Thus, while only the peripheral drive circuit were integrated with TFTs in the prior art, the present invention can implement the integration of more complicated systems such as video signal amplification devices or signal frequency converters using the TFTs.

**Twelfth Embodiment**

This embodiment concerns a display system that uses LDD-type CMOS TFTs. A block diagram of a display system using an active matrix liquid crystal display device is shown in Fig. 54. Video signals and timing signals from a video signal generation circuit of a computer or video source are simultaneously output. These video signals are necessary for a dedicated video signal amplification circuit that is required for amplifying the signals for a liquid crystal drive. If necessary, this amplification circuit also performs frequency conversion and $\gamma$ correction of the video signal. If an analog video signal requires frequency conversion, A/D conversion circuits, memory circuits, and D/A conversion circuits will also be necessary.

The timing controller shapes timing signals for driving the data driver and scan driver. By applying the optimal signals to this liquid crystal display device, the original capabilities of the liquid crystal display device are demonstrated. Since a liquid crystal display device using the LDD-type CMOS TFT circuits of the present invention operates at high speed, there might be no need to reduce frequencies at the video signal amplification circuit. Since the logic portion can be driven at a low voltage, the output levels of the timing controller, for example, could all be at TTL level. Further, part or all of the video signal amplification circuit and timing controller can be formed integrally of TFTs and the video signal generator itself can be integrated too. By integrating such a complicated system with high-speed TFT circuits, it becomes possible to implement an ultra-small type of portable information device that is impossible in the prior art, and the range of possible applications to which the TFT circuits can be applied is broadened beyond display systems alone.

Note that the present invention is not limited to the above described embodiments; it can be embodied in various forms within the scope of the claims of the present invention.

For example, the thin-film semiconductor device of the present invention is not only applicable to liquid crystal display devices, it can also be used in a wide range of circuits that had to use single-crystal MOSFETs in the prior art, such as digital circuits and analog circuits. To illustrate this, the carrier mobility and ON current of each of an amorphous TFT, prior art polycrystalline TFTs (of LDD and ordinary structures), thin-film semiconductor devices of this invention (of LDD and ordinary structures), and a single-crystal MOSFET are listed in Fig. 55. As is clear from Fig. 55, the present invention enables an ON current that is not inferior to that of a single-crystal MOSFET. Since the thin-film semiconductor device is formed on an insulating substance, virtually no noise is transmitted from the substrate. Therefore, if the thin-film semiconductor device of the present invention is used in a high-performance analog circuit that would have to use single-crystal MOSFETs in the prior art, the characteristics thereof are markedly improved. Comparing Fig. 34 with Fig. 33B with the viewpoint of integration density, the thin-film semiconductor device of the present invention with the short channel length is not inferior to a single-crystal MOSFET. Thus the thin-film semiconductor device of the present invention can be used in circuits in an extremely wide range of fields.

## Claims

1. A method of fabricating a thin-film semiconductor device comprising a non-single-crystal semiconductor film formed on an insulating material portion which covers at least one portion of a surface of a substrate, comprising the step of:
   depositing a semiconductor film by a chemical vapor deposition method under conditions that retard the generation rate of nuclei that act as seeds for film formation and accelerate the growth rate of islands formed from said nuclei.

2. The method of fabricating a thin-film semiconductor device as defined in claim 1, wherein:
   the generation rate of said nuclei is controlled in accordance with the deposition temperature and the growth rate of said islands is controlled in accordance with the deposition rate.

3. The method of fabricating a thin-film semiconductor device as defined in claim 2, wherein:
   said deposition temperature is 580 °C or less and said deposition rate is 6 Å/minute or more.

4. The method of fabricating a thin-film semiconductor device as defined in claim 3, wherein:
   said deposition temperature is 550 °C or less.

5. The method of fabricating a thin-film semiconductor device as defined in claim 3, wherein:
   said deposition temperature is 530 °C or less.

6. The method of fabricating a thin-film semiconductor device as defined in claim 1, wherein:
   either mono-silane ($SiH_4$) or di-silane ($Si_2H_6$) is used as at least one type of reactant gas while said semiconductor film is being deposited by said chemical vapor deposition method.

7. The method of fabricating a thin-film semiconductor device as defined in claim 1, further comprising the step of:
   subjecting a surface of said semiconductor film to thermal oxidation, after said semiconductor film deposition step.

8. The method of fabricating a thin-film semiconductor device as defined in claim 2, further comprising the step of:
   subjecting a surface of said semiconductor film to thermal oxidation, after said semiconductor film deposition step.

9. The method of fabricating a thin-film semiconductor device as defined in claim 3, further comprising the step of:
   subjecting a surface of said semiconductor film to thermal oxidation, after said semiconductor film deposition step.

10. The method of fabricating a thin-film semiconductor device as defined in claim 4, further comprising the step of:
    subjecting a surface of said semiconductor film to thermal oxidation, after said semiconductor film deposition step.

11. The method of fabricating a thin-film semiconductor device as defined in claim 5, further comprising the step of:
    subjecting a surface of said semiconductor film to thermal oxidation, after said semiconductor film deposition step.

12. The method of fabricating a thin-film semiconductor device as defined in claim 6, further comprising the step of:
    subjecting a surface of said semiconductor film to thermal oxidation, after said semiconductor film deposition step.

13. The method of fabricating a thin-film semiconductor device as defined in any one of claims 1 to 12, further comprising the step of:

irradiating said semiconductor film with optical energy or electromagnetic-wave energy, after said semiconductor film deposition step, wherein the maximum processing temperature after said irradiation step is 350 °C or less.

**14.** The method of fabricating a thin-film semiconductor device as defined in any one of claims 1 to 12, further comprising the step of:
annealing said semiconductor film at a temperature of 600 °C or less, after said semiconductor film deposition step, wherein the maximum processing temperature after said annealing step is 600 °C or less.

**15.** The method of fabricating a thin-film semiconductor device as defined in claim 14, wherein:
the maximum processing temperature after said annealing step is 350 °C or less.

**16.** The method of fabricating a thin-film semiconductor device as defined in any one of claims 1 to 12, further comprising the step of:
annealing said semiconductor film at a temperature in the range of between 500 °C and 700 °C, after said semiconductor film deposition step.

**17.** The method of fabricating a thin-film semiconductor device as defined in claim 16, wherein:
said temperature range is between 550 °C and 650 °C.

**18.** A thin-film semiconductor device comprising a non-single-crystal semiconductor film formed on an insulating material portion which covers at least one portion of a surface of a substrate, wherein:
said semiconductor film is deposited by a chemical vapor deposition method under conditions that retard the generation rate of nuclei that act as seeds for film formation and accelerate the growth rate of islands formed from said nuclei.

**19.** A thin-film semiconductor device comprising a non-single-crystal semiconductor film formed on an insulating material portion which covers at least one portion of a surface of a substrate, wherein:
the average grain area when said semiconductor film is in a polycrystalline state is at least 10,000 $nm^2$.

**20.** A thin-film semiconductor device comprising a non-single-crystal semiconductor film formed on an insulating material portion which covers at least one portion of a surface of a substrate, wherein:
the average area of islands grown from nuclei that act as seeds for forming said semiconductor film is at least 10,000 $nm^2$.

**21.** A thin-film semiconductor device comprising a non-single-crystal semiconductor film formed on an insulating material portion which covers at least one portion of a surface of a substrate, wherein:
the boundary surface roughness (center line average height, Ra) between a gate insulation film formed by thermal oxidation of said semiconductor film and a gate electrode formed on said gate insulation film is no more than 2.00 nm.

**22.** A thin-film semiconductor device comprising a non-single-crystal semiconductor film formed on an insulating material portion which covers at least one portion of a surface of a substrate, wherein:
said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor, and
the maximum impurity concentration of said second impurity-doped semiconductor film is in the range of between $1 \times 10^{18}$ $cm^{-3}$ and $1 \times 10^{19}$ $cm^{-3}$.

**23.** The thin-film semiconductor device as defined in claim 22, wherein:
the maximum impurity concentration of said second impurity-doped semiconductor film is in the range of between $2 \times 10^{18}$ $cm^{-3}$ and $5 \times 10^{18}$ $cm^{-3}$.

**24.** A thin-film semiconductor device comprising a non-single-crystal semiconductor film formed on an insulating material portion which covers at least one portion of a surface of a substrate, wherein:

said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor, and

the maximum impurity concentration of said first impurity-doped semiconductor film is in the range of between $5 \times 10^{19}$ $cm^{-3}$ and $1 \times 10^{21}$ $cm^{-3}$.

**25.** The thin-film semiconductor device as defined in claim 24, wherein:

the maximum impurity concentration of said first impurity-doped semiconductor film is in the range of between $1 \times 10^{20}$ $cm^{-3}$ and $3 \times 10^{20}$ $cm^{-3}$.

**26.** A thin-film semiconductor device comprising a non-single-crystal semiconductor film formed on an insulating material portion which covers at least one portion of a surface of a substrate, wherein:

said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor, and

an LDD length in said drain portion or said source portion is in the range of between 0.6 $\mu$m and 4 $\mu$m.

**27.** The thin-film semiconductor device as defined in claim 26, wherein:

said LDD length is in the range of between 1 $\mu$m and 2 $\mu$m.

**28.** A thin-film semiconductor device comprising a non-single-crystal semiconductor film formed on an insulating material portion which covers at least one portion of a surface of a substrate, wherein:

said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor, and

the length of a gate electrode formed on said semiconductor film with a gate insulation film in between is 5 $\mu$m or less.

**29.** The thin-film semiconductor device as defined in claim 28, wherein:

said gate electrode length is 3 $\mu$m or less.

**30.** A thin-film semiconductor device comprising a non-single-crystal semiconductor film formed on an insulating material portion which covers at least one portion of a surface of a substrate, wherein:

said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor, and

when an LDD length of a drain portion is Llddd and the distance from an edge thereof on a channel portion side of a contact hole in said drain portion to a gate electrode is Lcontd, the following relationship applies:

$$0.8 \times \text{Llddd} \leqq \text{Lcontd} \leqq 1.2 \times \text{Llddd}.$$

**31.** A thin-film semiconductor device comprising a non-single-crystal semiconductor film formed on an insulating material portion which covers at least one portion of a surface of a substrate, wherein:

said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor, and

when an LDD length of a source portion is Lldds and the distance from an edge thereof on a channel portion side of a contact hole in said source portion to a gate electrode is Lconts, the following relationship applies:

$$0.8 \times Lldds \leqq Lconts \leqq 1.2 \times Lldds.$$

**32.** The thin-film semiconductor device as defined in any one of claims 22 to 31, comprising:
a p-type thin-film transistor having said first and second impurity-doped semiconductor films in which the implanted impurities are p-type and an n-type thin-film transistor having said first and second impurity-doped semiconductor films in which the implanted impurities are n-type.

**33.** The thin-film semiconductor device as defined in claim 32, wherein:
the gate electrode length of said p-type thin-film transistor is shorter than that of said n-type thin-film transistor.

**34.** The thin-film semiconductor device as defined in claim 33, wherein:
the gate electrode length of said p-type thin-film transistor and that of said n-type thin-film transistor are each 5 $\mu$m or less.

**35.** The thin-film semiconductor device as defined in claim 32, wherein:
the channel width of said n-type thin-film transistor is less than that of said p-type thin-film transistor.

**36.** The thin-film semiconductor device as defined in claim 35, wherein:
the gate electrode length of said p-type thin-film transistor and that of said n-type thin-film transistor are each 5 $\mu$m or less.

**37.** A method of fabricating a thin-film semiconductor device comprising a non-single-crystal semiconductor film formed on an insulating material portion which covers at least one portion of a surface of a substrate, comprising the steps of:
implanting an impurity by using a gate electrode as a mask, and
implanting an impurity by using a photoresist as a mask, wherein:
an impurity dose implanted by using said gate electrode as a mask is in the range of between $1 \times 10^{13}$ $cm^{-2}$ and $1 \times 10^{14}$ $cm^{-2}$, and an impurity dose implanted by using said photoresist as a mask is in the range of between $5 \times 10^{14}$ $cm^{-2}$ and $1 \times 10^{16}$ $cm^{-2}$.

**38.** The method of fabricating a thin-film semiconductor device as defined in claim 37, further comprising a step of:
forming an impurity-doped semiconductor film in the shape of an island in source and drain portions of a thin-film transistor, and then forming an intrinsic semiconductor film on said impurity-doped semiconductor film formed in the shape of an island.

**39.** A method of fabricating a thin-film semiconductor device comprising a non-single-crystal semiconductor film formed on an insulating material portion which covers at least one portion of a surface of a substrate, comprising the steps of:
implanting an impurity by using a gate electrode as a mask, and
implanting an impurity after an insulation film is formed on the surface of the gate electrode, wherein:
an impurity dose implanted by using said gate electrode as a mask is in the range of between $1 \times 10^{13}$ $cm^{-2}$ and $1 \times 10^{14}$ $cm^{-2}$, and an impurity dose implanted after said insulation film is formed on the surface of the gate electrode, is in the range of between $5 \times 10^{14}$ $cm^{-2}$ and $1 \times 10^{16}$ $cm^{-2}$.

**40.** The method of fabricating a thin-film semiconductor device as defined in claim 39, further comprising a step of:
forming an impurity-doped semiconductor film in the shape of an island in source and drain portions of a thin-film transistor, and then forming an intrinsic semiconductor film on said impurity-doped semiconductor film formed in the shape of an island.

**41.** The method of fabricating a thin-film semiconductor device as defined in claim 39 or claim 40, wherein:
an insulation film formed on said gate electrode surface layer portion is formed by thermal oxidation or anodic oxidation of the material of said gate electrode, or by a given deposition method.

**42.** A display system using a thin-film semiconductor device comprising a non-single-crystal semiconductor film formed on an insulating material portion which covers at least one portion of a surface of a substrate, wherein:

said display system further comprises an active matrix portion formed on said insulating material and data and scan driver portions formed on said insulating material and also formed of said thin-film semiconductor device,

said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor, and

the maximum impurity concentration of said second impurity-doped semiconductor film is in the range of between $1 \times 10^{18}$ $cm^{-3}$ and $1 \times 10^{19}$ $cm^{-3}$.

**43.** A display system using a thin-film semiconductor device comprising a non-single-crystal semiconductor film formed on an insulating material portion which covers at least one portion of a surface of a substrate, wherein:

said display system further comprises an active matrix portion formed on said insulating material and data and scan driver portions formed on said insulating material and also formed of said thin-film semiconductor device,

said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor, and

the maximum impurity concentration of said first impurity-doped semiconductor film is in the range of between $5 \times 10^{19}$ $cm^{-3}$ and $1 \times 10^{21}$ $cm^{-3}$.

**44.** A display system using a thin-film semiconductor device comprising a non-single-crystal semiconductor film formed on an insulating material portion which covers at least one portion of a surface of a substrate, wherein:

said display system further comprises an active matrix portion formed on said insulating material and data and scan driver portions formed on said insulating material and also formed of said thin-film semiconductor device,

said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor, and

an LDD length in said drain portion or said source portion is in the range of between 0.6 $\mu$m and 4 $\mu$m.

**45.** A display system using a thin-film semiconductor device comprising a non-single-crystal semiconductor film formed on an insulating material portion which covers at least one portion of a surface of a substrate, wherein:

said display system further comprises an active matrix portion formed on said insulating material and data and scan driver portions formed on said insulating material and also formed of said thin-film semiconductor device,

said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor, and

the length of a gate electrode formed on said semiconductor film with a gate insulation film in between is 5 $\mu$m or less.

**46.** A display system as defined in any one of claims 42 to 45, wherein:

said data driver portion or said scan driver portion comprises a clocked gate bidirectional shift register circuit.

**47.** A display system as defined in any one of claims 42 to 45, wherein:

said data driver portion or said scan driver portion comprises a plurality of shift register circuits,

each of which has a different clock signal phase, and gate-circuits to which outputs from said plurality of shift register circuits are input.

**48.** A display system as defined in any one of claims 42 to 45, wherein:
said data driver portion or said scan driver portion comprises a level-shifter circuit and a shift register circuit, and said shift register circuit is driven at levels equal to or below the TTL level.

**49.** A display system as defined in claim 48, wherein:
an input portion of said level-shifter circuit comprises a p-type thin-film transistor and an n-type thin-film transistor connected in series.

**50.** A display system as defined in any one of claims 42 to 45, wherein:
said data driver portion comprises at least one shift register circuit, at least one video line, and analog switches, and one of outputs of said shift register circuit is input to a gate terminal of said analog switch, either directly or through a level-shifter circuit, whereby an analog signal is supplied to each of picture elements in a dot-sequential manner.

**51.** A display system as defined in any one of claims 42 to 45, wherein:
said data driver portion comprises first-stage analog latches, each of which is connected to at least one video line, second-stage analog latches, each of which has at least one input to which an output from said first-stage analog latch enters, and analog buffers, each of which is connected to one of signal lines to which outputs from said second-stage analog latches are input; whereby an analog signal is supplied to each of picture elements in a line-sequential manner.

**52.** A display system as defined in any one of claims 42 to 45, wherein:
said data driver portion comprises a group of n first-stage latches connected to n digital signal input lines, a group of n second-stage latches to which outputs of said first-stage latches are input, and a decoder connected to $2^n$ analog switch gates to which outputs of said second-stage latches are input, whereby digital signals are supplied to picture elements.

**53.** A display system as defined in any one of claims 42 to 45, further comprising:
a video signal amplification circuit for amplifying video signals output from a video signal generator and a timing controller for generating timing signals in synchronization with video signals output from said video signal generator, wherein said data driver portion and said scan driver portion are driven by said timing signals.

**54.** A display system as defined in claim 53, wherein:
said timing controller, said data driver portion, and said scan driver portion are driven at levels equal to or below the TTL level.

**55.** A display system as defined in claim 53, wherein:
said timing controller is made from said thin-film semiconductor device.

**56.** A display system as defined in claim 53, wherein:
said video signal amplification circuit comprises a signal frequency conversion circuit for converting a video signal into a plurality of low-frequency signals or a $\gamma$ correction circuit.

**57.** A display system as defined in claim 53, wherein:
said video signal amplification circuit is made from said thin-film semiconductor device.

**58.** A thin-film semiconductor device comprising a non-single-crystal semiconductor film formed on an insulating material portion which covers at least one portion of a surface of a substrate, wherein:
said semiconductor film is deposited by a chemical vapor deposition method under conditions that retard the generation rate of nuclei that act as seeds for film formation and accelerate the growth rate of islands formed from said nuclei, and also said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor.

**59.** A thin-film semiconductor device comprising a non-single-crystal semiconductor film formed on an insulating material portion which covers at least one portion of a surface of a substrate, wherein:
the average grain area when said semiconductor film is in a polycrystalline state is at least 10,000 $nm^2$, and also said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor.

**60.** A thin-film semiconductor device comprising a non-single-crystal semiconductor film formed on an insulating material portion which covers at least one portion of a surface of a substrate, wherein:
the average area of islands grown from nuclei that act as seeds for forming said semiconductor film is at least 10,000 $nm^2$, and also said semiconductor film comprises a first impurity-doped semiconductor film located in source and drain portions of a thin-film transistor and a high-resistance second impurity-doped semiconductor film located in at least one area between drain and channel portions or between source and channel portions of said thin-film transistor.

**61.** The thin-film semiconductor device as defined in any one of claims 58 to 60, wherein:
the maximum impurity concentration of said second impurity-doped semiconductor film is in the range of between $2 \times 10^{17}$ $cm^{-3}$ and $1 \times 10^{19}$ $cm^{-3}$.

**62.** The thin-film semiconductor device as defined in any one of claims 58 to 60, wherein:
the maximum impurity concentration of said first impurity-doped semiconductor film is in the range of between $5 \times 10^{19}$ $cm^{-3}$ and $1 \times 10^{21}$ $cm^{-3}$.

**63.** The thin-film semiconductor device as defined in any one of claims 58 to 60, wherein:
an LDD length of a drain portion or source portion is within a range of between 0.3 $\mu$m and 4 $\mu$m.

**64.** The thin-film semiconductor device as defined in any one of claims 58 to 60, wherein:
the length of a gate electrode formed on said semiconductor film with a gate insulation film in between is 5 $\mu$m or less.

**65.** The thin-film semiconductor device as defined in any one of claims 58 to 60, wherein:
when an LDD length of a drain portion is Llddd and the distance from an edge thereof on a channel portion side of a contact hole in said drain portion to a gate electrode is Lcontd, the following relationship applies:

$$0.8 \times Llddd \leqq Lcontd \leqq 1.2 \times Llddd.$$

**66.** The thin-film semiconductor device as defined in any one of claims 58 to 60, wherein:
when an LDD length of a source portion is Lldds and the distance from an edge thereof on a channel portion side of a contact hole in said source portion to a gate electrode is Lconts, the following relationship applies:

$$0.8 \times Lldds \leqq Lconts \leqq 1.2 \times Lldds.$$

**67.** The thin-film semiconductor device as defined in any one of claims 58 to 60, wherein:
said second impurity-doped semiconductor film is arranged over the entire region of source and drain portions of a p-type thin-film transistor having an impurity-doped semiconductor film to which p-type impurity is implanted.

**68.** A method of fabricating a thin-film semiconductor device comprising a non-single-crystal semiconductor film formed on an insulating material portion which covers at least one portion of a surface of a substrate, comprising the steps of:
depositing a semiconductor film by a chemical vapor deposition method under conditions that retard the generation rate of nuclei that act as seeds for film formation and accelerate the growth rate of islands formed from said nuclei,

implanting an impurity by using a gate electrode as a mask, and

implanting an impurity by using a photoresist as a mask, wherein:

an impurity dose implanted by using said gate electrode as a mask is less than an impurity dose implanted by using said photoresist as a mask.

**69.** A method of fabricating a thin-film semiconductor device comprising a non-single-crystal semiconductor film formed on an insulating material portion which covers at least one portion of a surface of a substrate, comprising the steps of:

depositing a semiconductor film by a chemical vapor deposition method under conditions that retard the generation rate of nuclei that act as seeds for film formation and accelerate the growth rate of islands formed from said nuclei,

implanting an impurity by using a gate electrode as a mask, and

implanting an impurity after an insulation film is formed on the surface of the gate electrode, wherein:

an impurity dose implanted by using said gate electrode as a mask is less than an impurity dose implanted after said insulation film is formed on the surface of the gate electrode.

**70.** The method of fabricating a thin-film semiconductor device as defined in either claim 68 or claim 69, wherein:

the generation rate of said nuclei is controlled by the deposition temperature, the growth rate of said islands is controlled by the deposition rate, and while said deposition temperature is 580°C or less, said deposition rate is 6 Å/minute or more.

**71.** The method of fabricating a thin-film semiconductor device as defined in either claim 68 or claim 69, further comprising the step of:

annealing said semiconductor film at a temperature in the range of between 500°C and 700°C, after said semiconductor film deposition step.

**72.** The method of fabricating a thin-film semiconductor device as defined in either claim 68 or claim 69, wherein:

an impurity dose implanted by using said gate electrode as a mask is in the range of between $2 \times 10^{12}$ $cm^{-2}$ and $1 \times 10^{14}$ $cm^{-2}$, and an impurity dose implanted by using said photoresist as a mask or an impurity dose implanted after said insulation film is formed on the surface of the gate electrode, is in the range between $5 \times 10^{14}$ $cm^{-2}$ and $1 \times 10^{16}$ $cm^{-2}$.

FIG. 1A

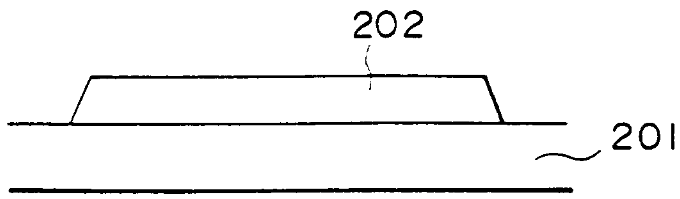


FIG. 1B

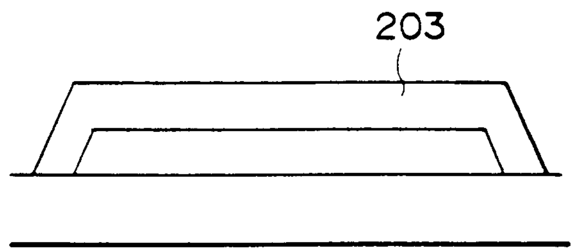


FIG. 1C

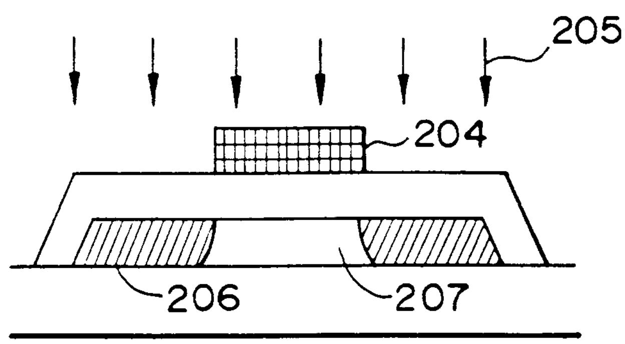


FIG. 1D

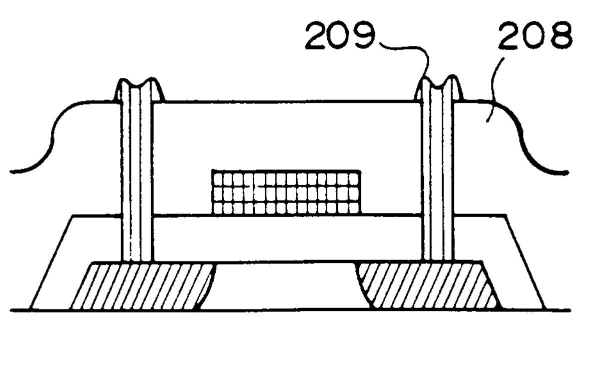

FIG. 2

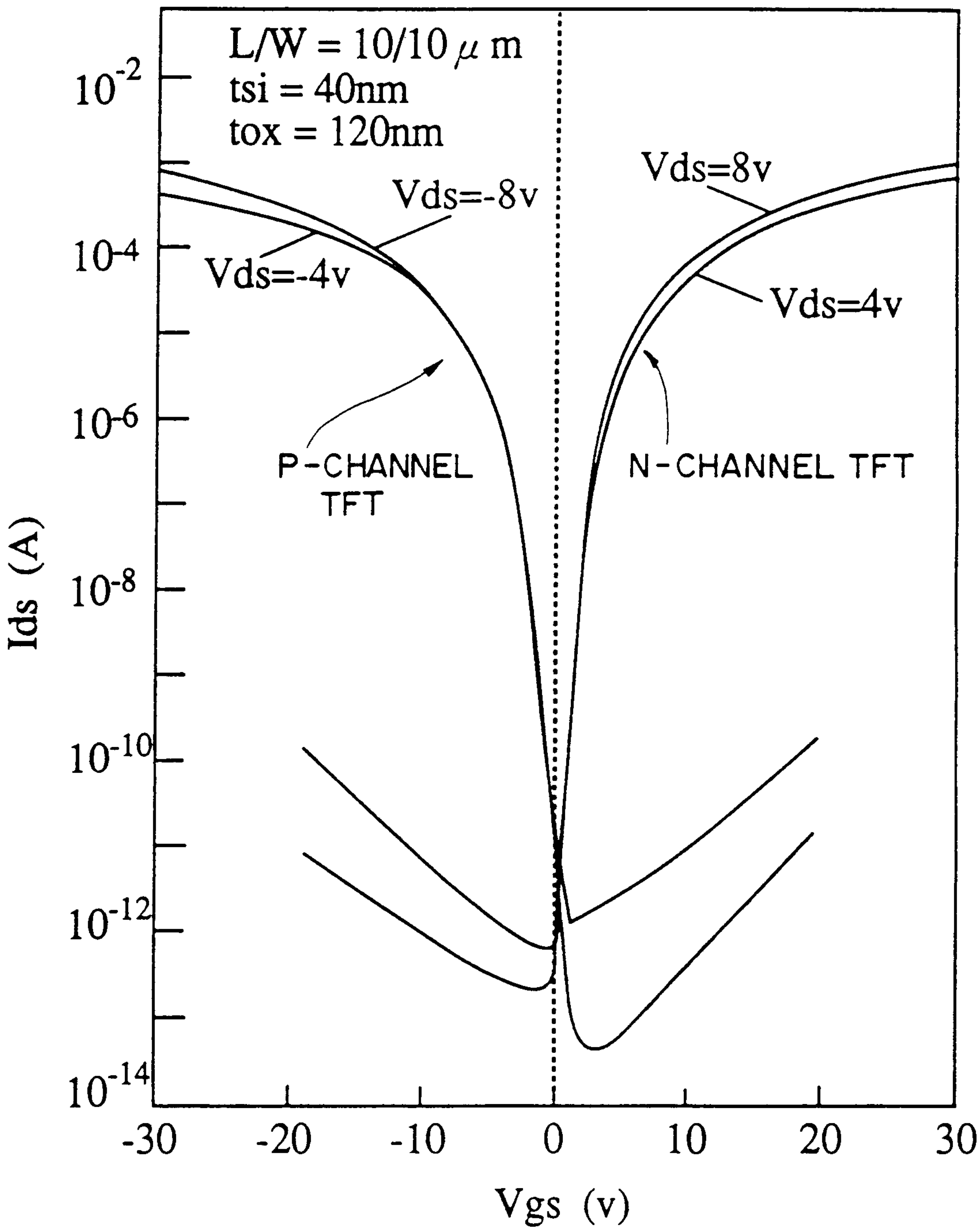
L/W = 10/10 μ m
tsi = 40nm
tox = 120nm
Vds=-8v
Vds=-4v
Vds=8v
Vds=4v
P-CHANNEL TFT
N-CHANNEL TFT
Ids (A)
10-2
10-4
10-6
10-8
10-10
10-12
10-14
-30
-20
-10
0
10
20
30
Vgs (v)

FIG. 3

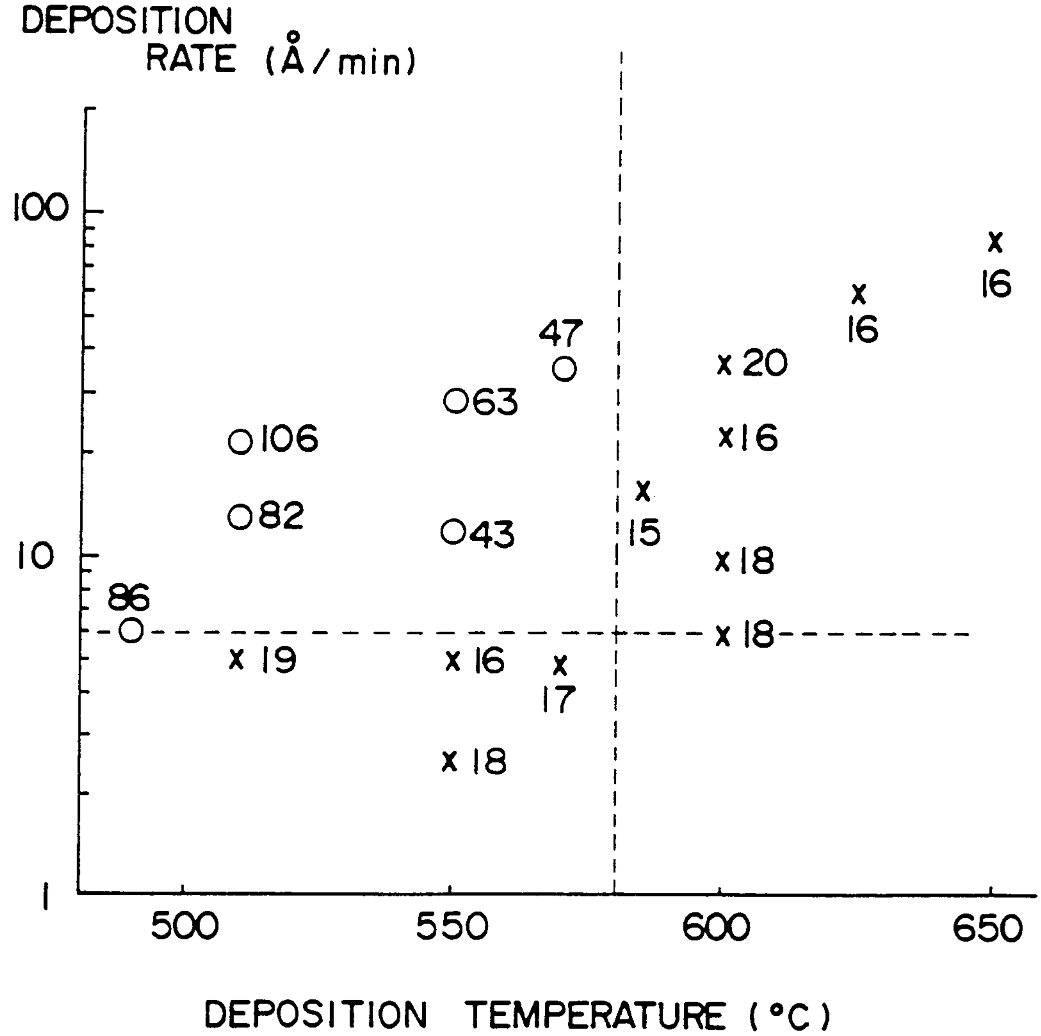
DEPOSITION RATE (Å/min)
100
10
1
500
550
600
650
DEPOSITION TEMPERATURE (°C)
47
63
106
82
43
86
19
16
17
18
15
20
16
18
18
16
16

FIG. 4

PRESENT EMBODIMENT

SEM PHOTOGRAPH (AFTER THERMAL OXIDATION, DEPOSITON TEMPERATURE=510°C)

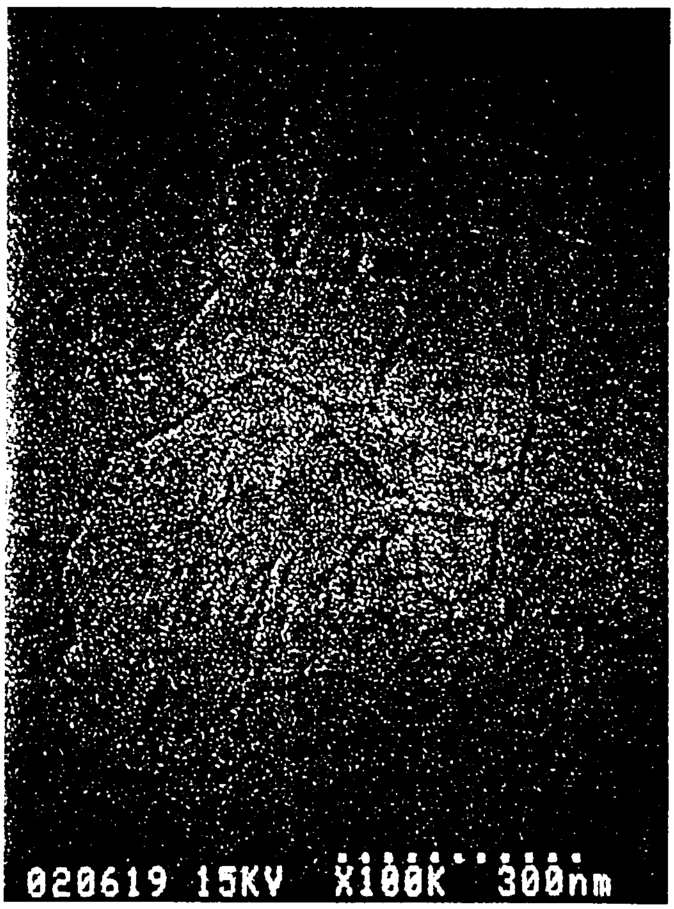


300 nm

FIG. 5

COMPARATIVE EXAMPLE

SEM PHOTOGRAPH (AFTER THERMAL OXIDATION, DEPOSITION TEMPERATURE=600°C)

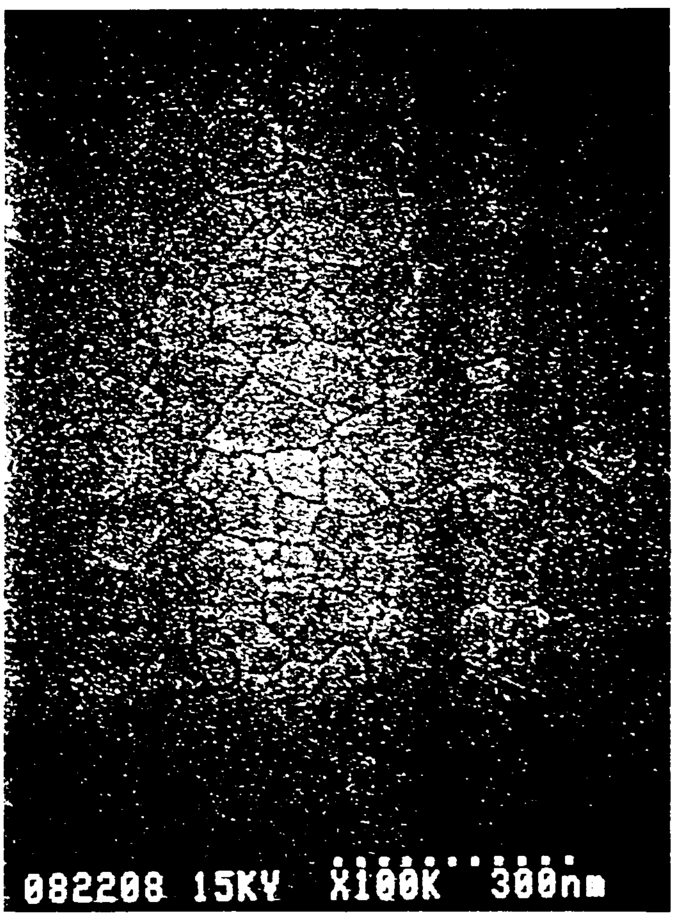


300 nm

FIG. 6A

PRESENT EMBODIMENT

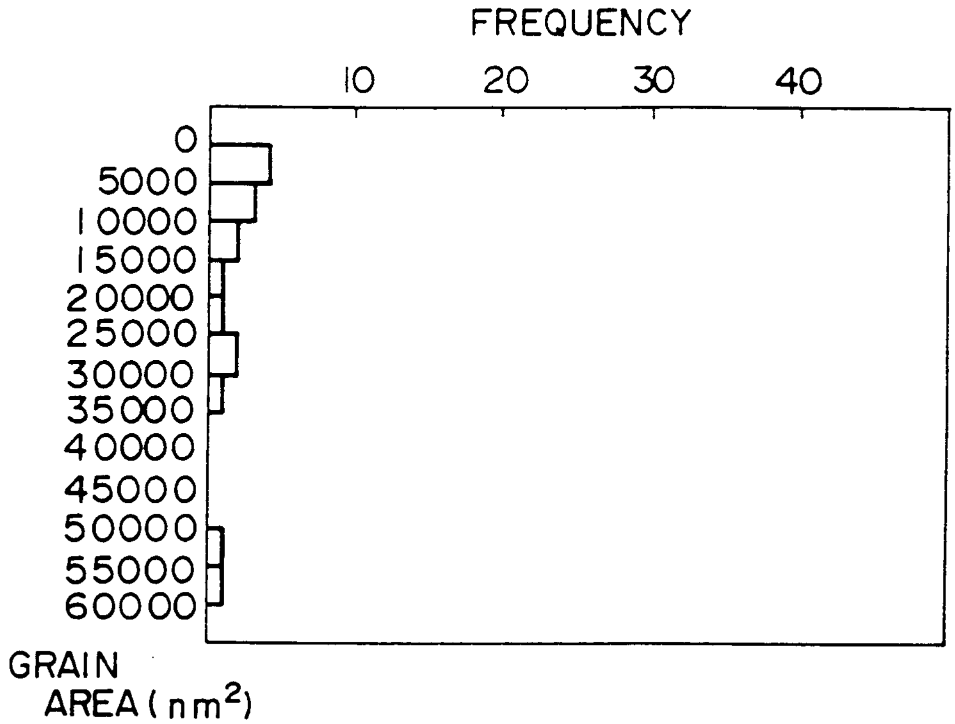


FIG. 6B

COMPARATIVE EXAMPLE

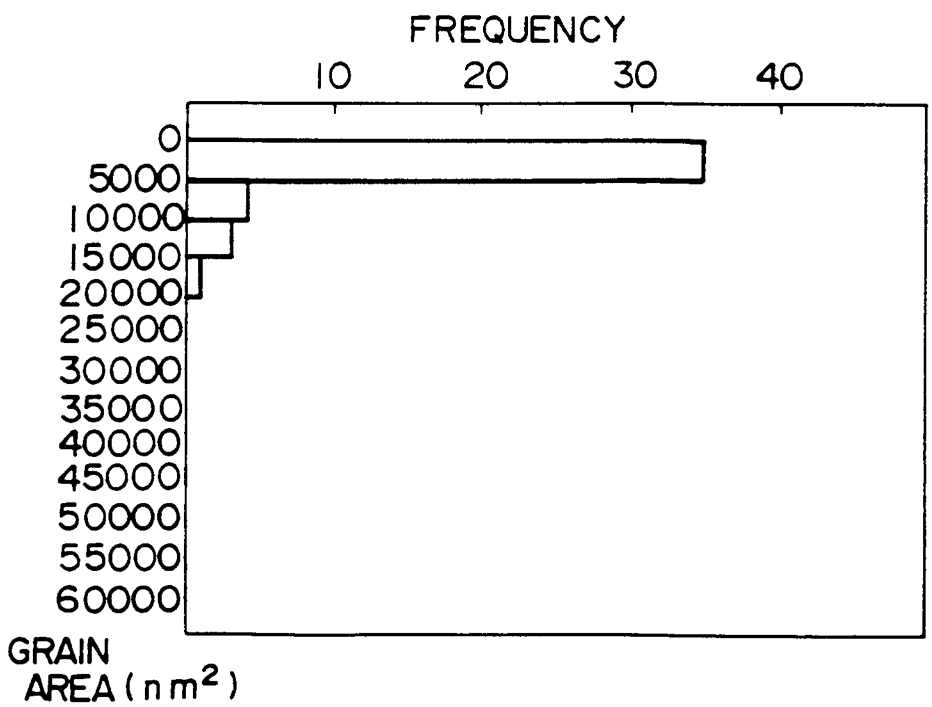

FIG.7A

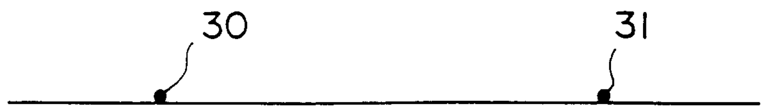


FIG.7B

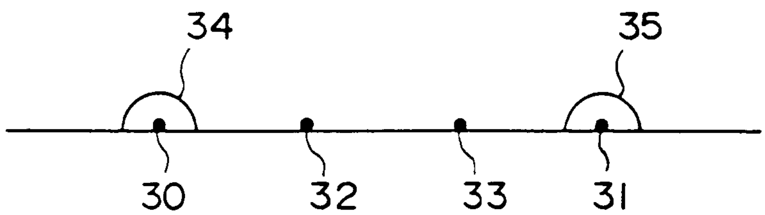


FIG.7C

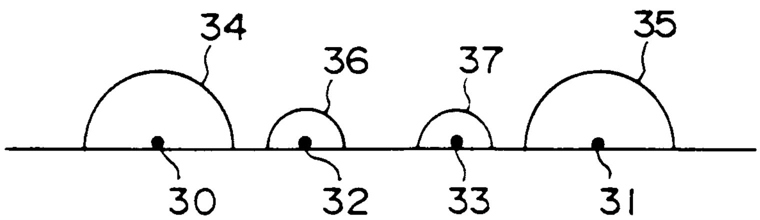


FIG.7D

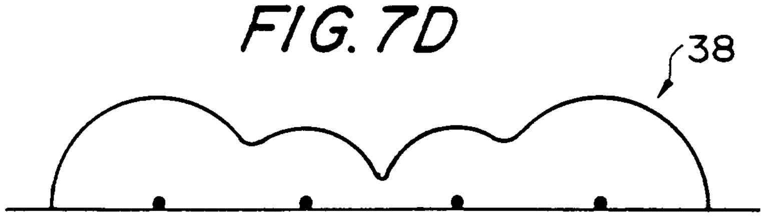


FIG.7E

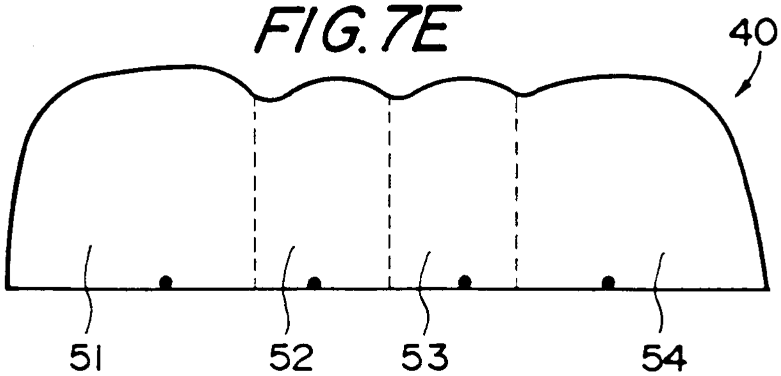

PRESENT INVENTION

FIG. 8A

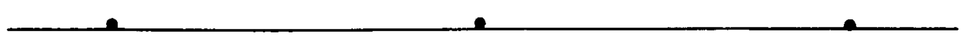

FIG. 8B

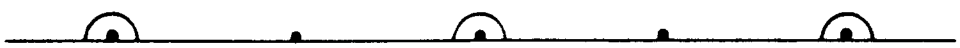

FIG. 8C

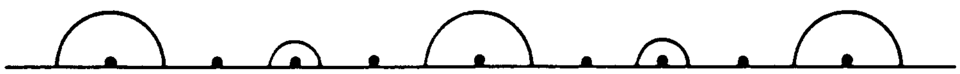

FIG. 8D

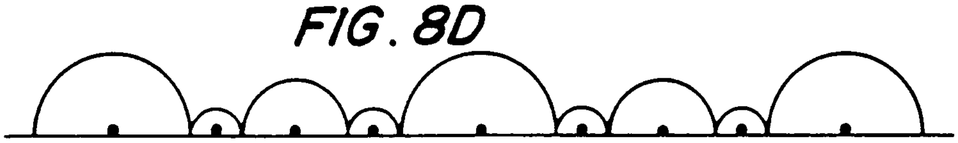

COMPARATIVE EXAMPLE

FIG. 8E

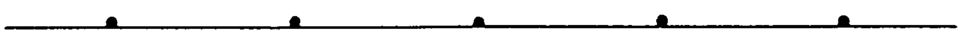

FIG. 8F

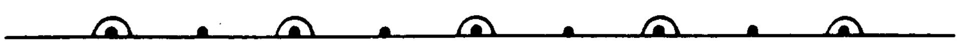

FIG. 8G

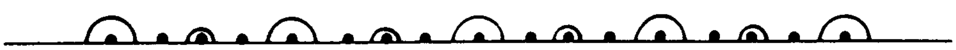

FIG. 8H

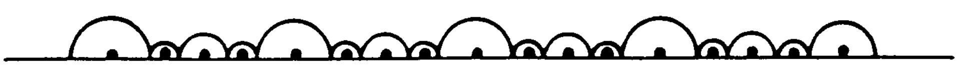

FIG. 9

PRESENT EMBODIMENT

SEM PHOTOGRAPH (BEFORE THERMAL OXIDATION, DEPOSITION TEMPERATURE=510°C)

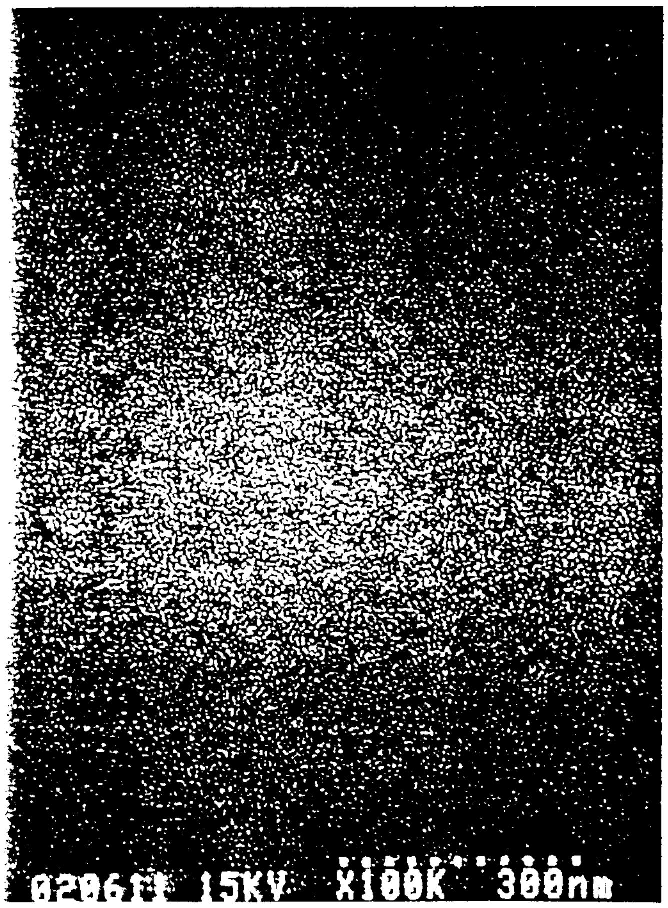


300nm

FIG. 10

PRESENT EMBODIMENT

AFM PHOTOGRAPH (BEFORE THERMAL OXIDATION, DEPOSITION TEMPERATURE=510°C)

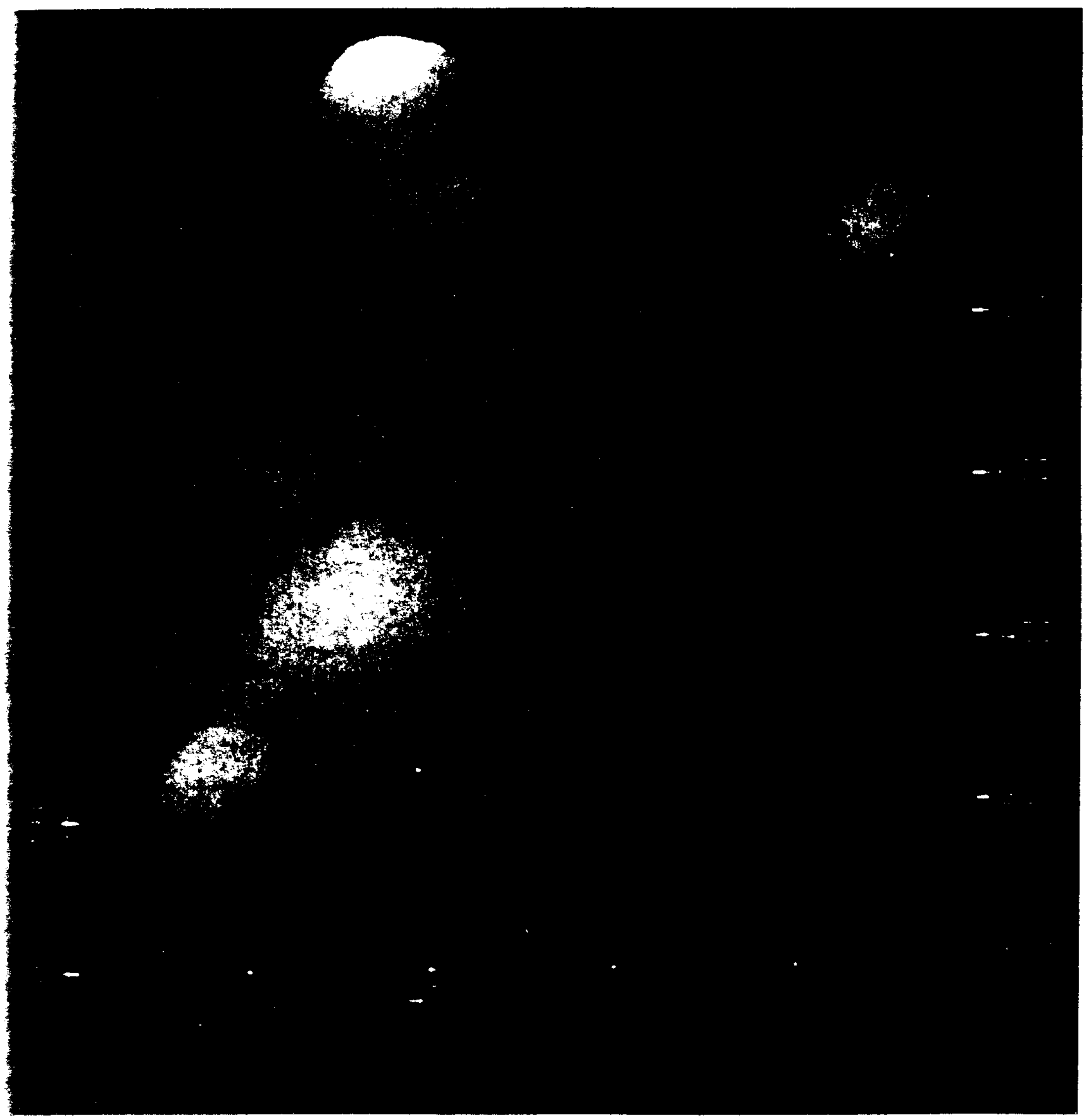

FIG. 11

PRESENT EMBODIMENT

AFM PHOTOGRAPH (BEFORE THERMAL OXIDATION, DEPOSITION TEMPERATURE=570°C)

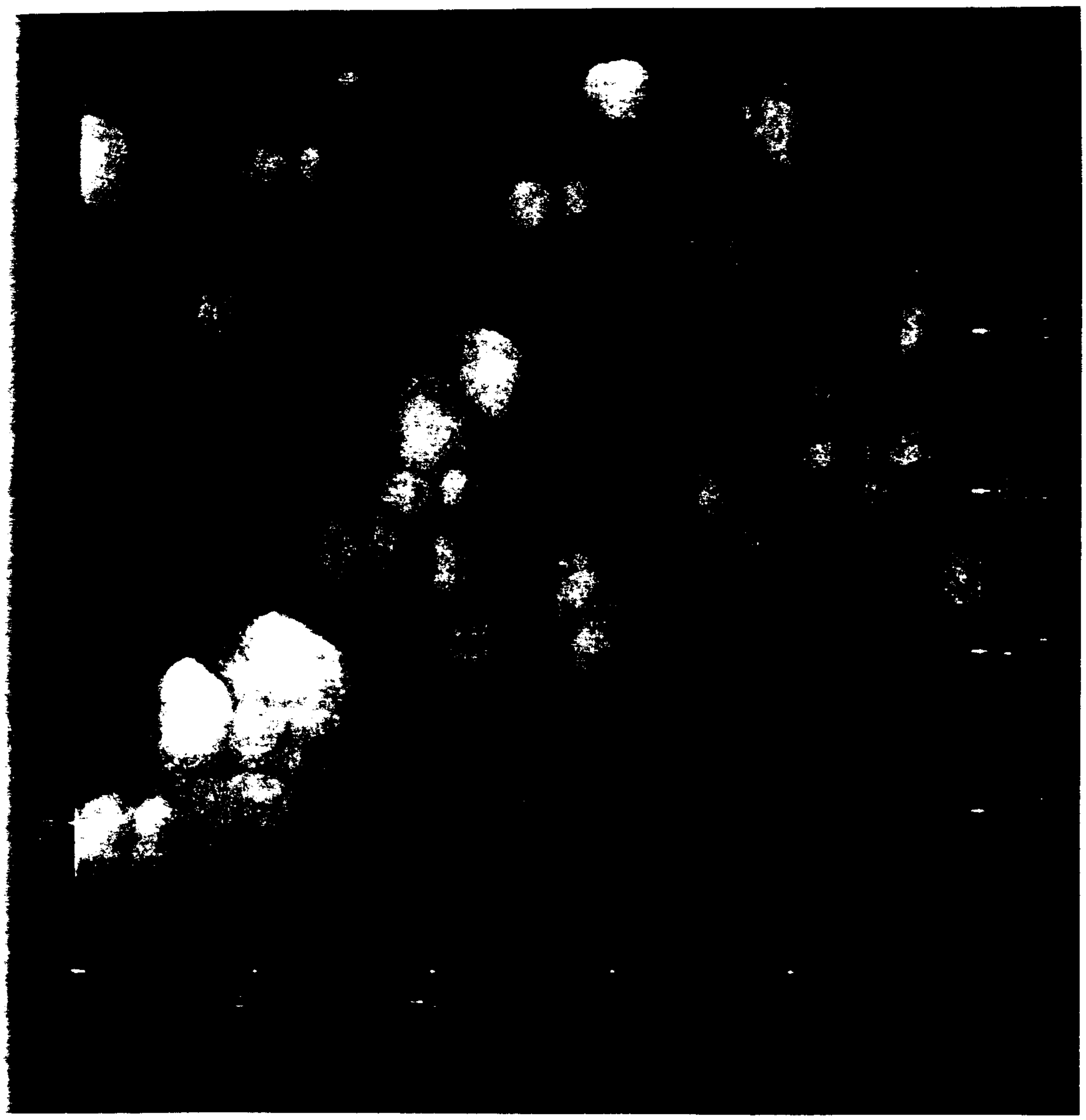

FIG. 12

PRESENT EMBODIMENT

SEM PHOTOGRAPH (BEFORE THERMAL OXIDATION, DEPOSITION TEMPERATURE=570°C)

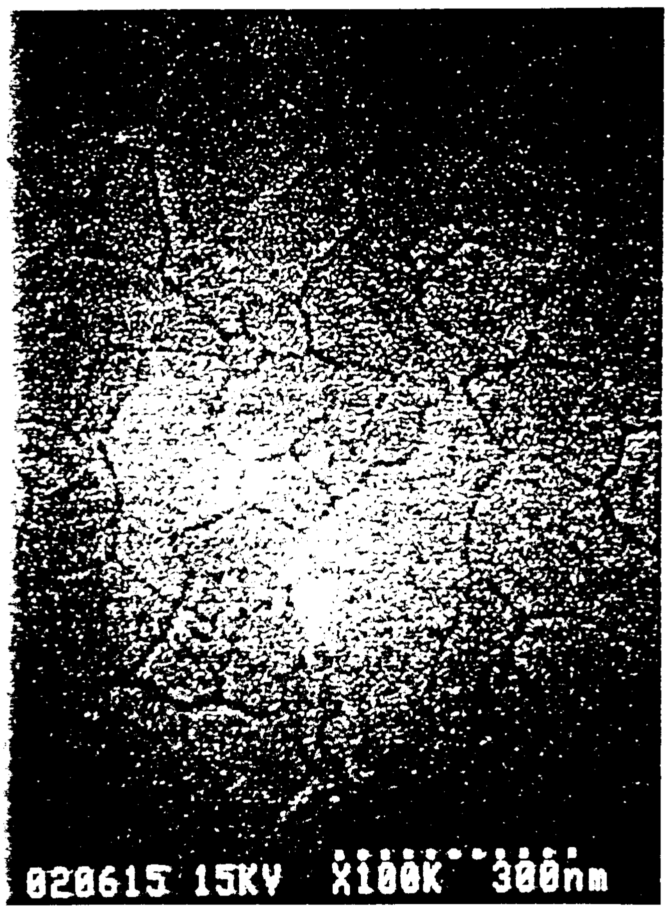


300 nm

FIG. 13

COMPARATIVE EXAMPLE
SEM PHOTOGRAPH (BEFORE THERMAL OXIDATION, DEPOSITION TEMPERATURE = 600°C)

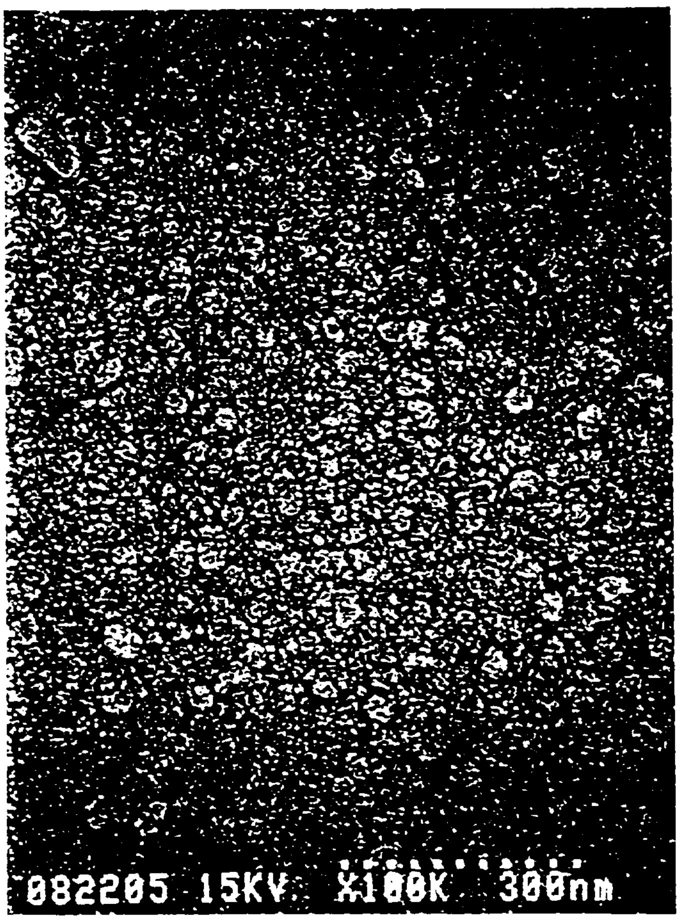


300 nm

FIG. 14

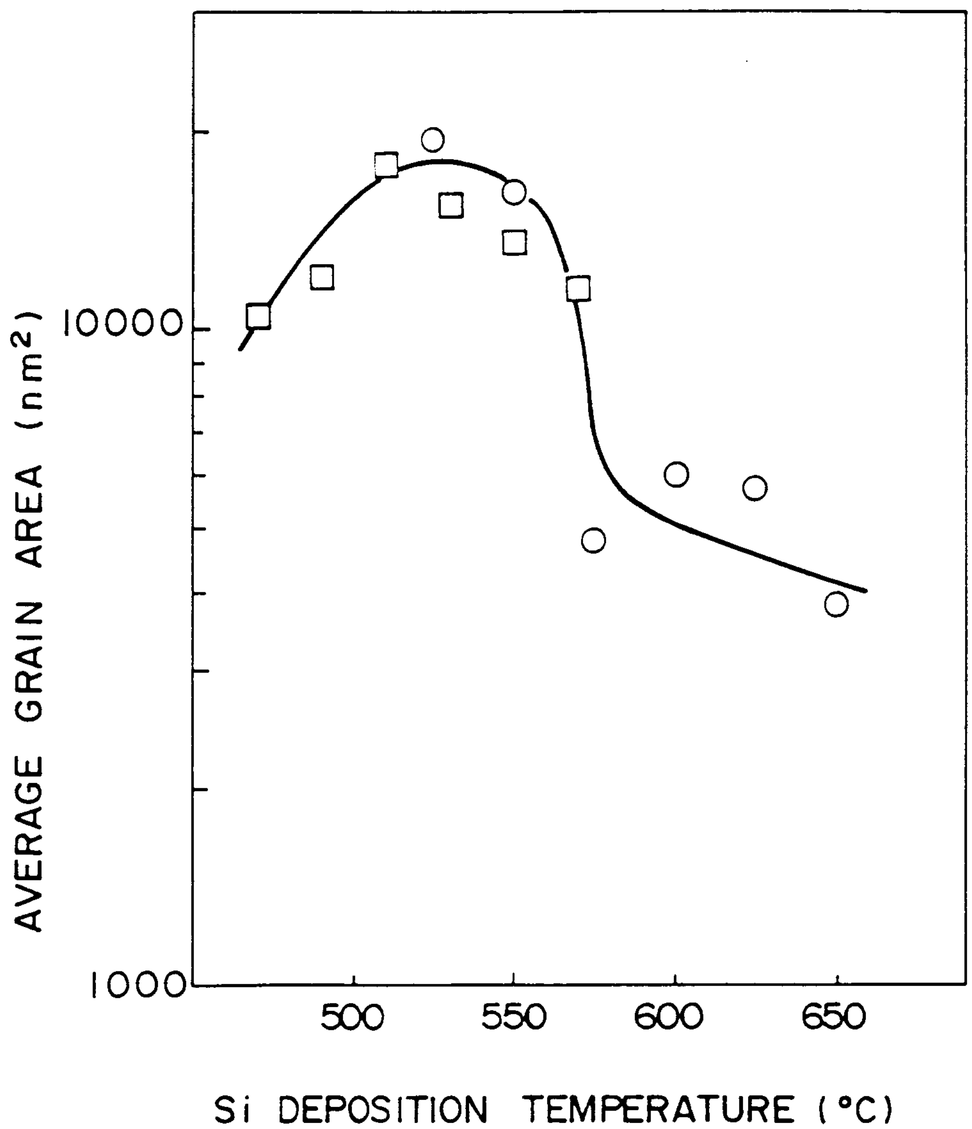

AVERAGE GRAIN AREA (nm²)
10000
1000
500
550
600
650
Si DEPOSITION TEMPERATURE (°C)

FIG. 15

| GRAIN AREA \ DEPOSITION TEMPERATURE | 470°C | 490°C | 530°C | 550°C | 570°C |
|---|---|---|---|---|---|
| 0 ~ 5000 | 45 | 27 | 9 | 14 | 52 |
| 5000 ~ 10000 | 9 | 8 | 2 | 6 | 9 |
| 10000 ~ 15000 | 11 | 6 | 5 | 1 | 8 |
| 15000 ~ 20000 | 6 | 4 | 2 | 7 | 4 |
| 20000 ~ 25000 | 4 | 1 | 5 | 0 | 11 |
| 25000 ~ 30000 | 1 | 1 | 0 | 1 | 7 |
| 30000 ~ 35000 | 1 | 3 | 0 | 2 | 4 |
| 35000 ~ 40000 | 0 | 3 | 0 | 0 | 1 |
| 40000 ~ 45000 | 0 | 0 | 1 | 0 | 0 |
| 45000 ~ 50000 | 0 | 0 | 1 | 1 | 0 |
| 50000 ~ 55000 | 2 | 0 | 0 | 0 | 2 |
| 55000 ~ 60000 | 0 | 0 | 1 | 1 | 0 |

FIG. 16

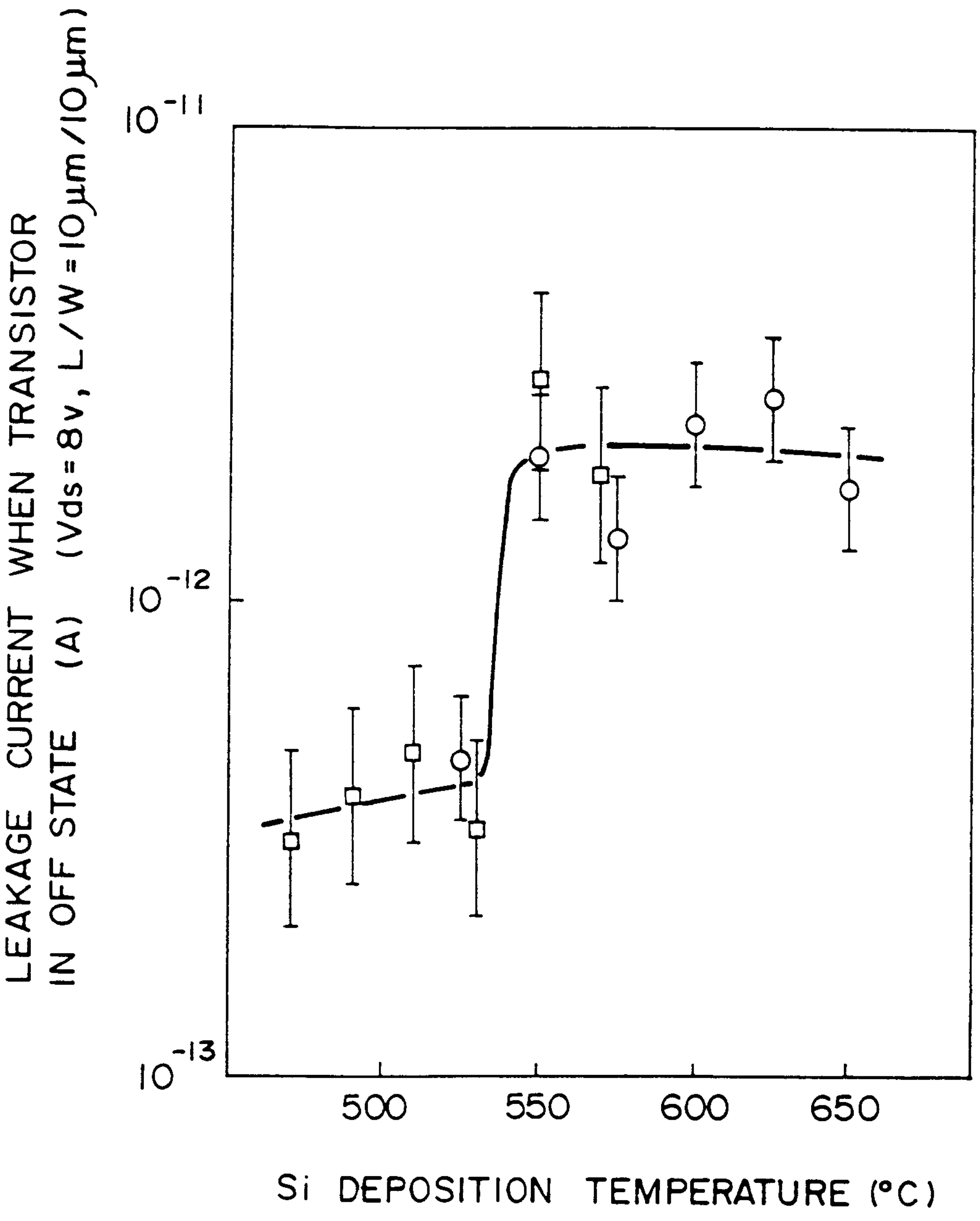
LEAKAGE CURRENT WHEN TRANSISTOR IN OFF STATE (A) (Vds = 8v, L/W = 10μm/10μm)
$10^{-11}$
$10^{-12}$
$10^{-13}$
500
550
600
650
Si DEPOSITION TEMPERATURE (°C)

FIG. 17

| TESTPIECE \ No | 1 | 2 | 3 |
|---|---|---|---|
| 1 | AT LEAST 100V | AT LEAST 100V | AT LEAST 100V |
| 2 | AT LEAST 100V | AT LEAST 100V | AT LEAST 100V |
| 3 | AT LEAST 100V | AT LEAST 100V | AT LEAST 100V |
| 4 | AT LEAST 100V | AT LEAST 100V | AT LEAST 100V |
| 5 | AT LEAST 100V | AT LEAST 100V | AT LEAST 100V |
| 6 | 65V | 71 V | 69V |
| 7 | AT LEAST 100V | 88V | 93V |
| 8 | AT LEAST 100V | AT LEAST 100V | AT LEAST 100V |
| 9 | AT LEAST 100V | AT LEAST 100V | AT LEAST 100V |
| 10 | AT LEAST 100V | AT LEAST 100V | AT LEAST 100V |
| 11 | AT LEAST 100V | AT LEAST 100V | AT LEAST 100V |

FIG. 18

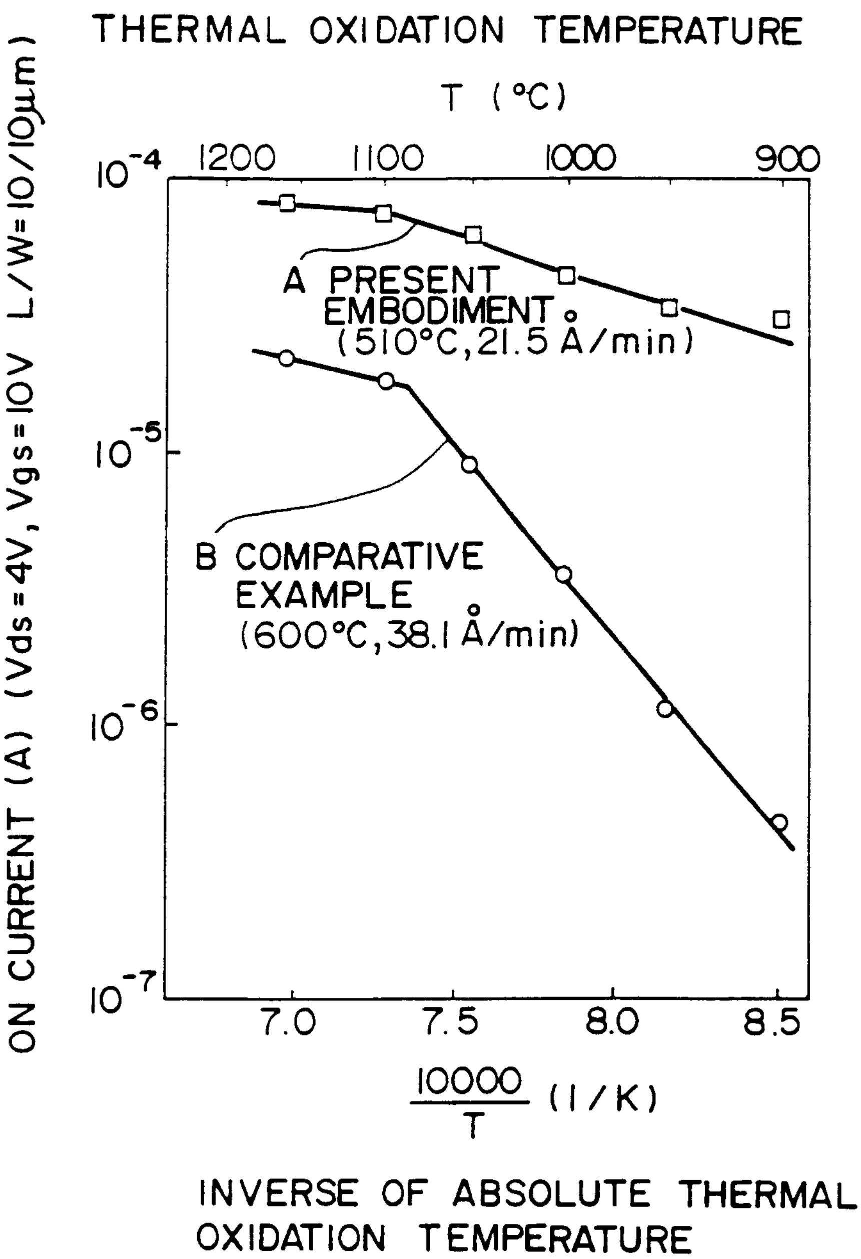
THERMAL OXIDATION TEMPERATURE
T (°C)
1200
1100
1000
900
ON CURRENT (A) (Vds=4V, Vgs=10V L/W=10/10μm)
10^-4
10^-5
10^-6
10^-7
A PRESENT EMBODIMENT (510°C, 21.5 Å/min)
B COMPARATIVE EXAMPLE (600°C, 38.1 Å/min)
7.0
7.5
8.0
8.5
10000/T (1/K)
INVERSE OF ABSOLUTE THERMAL OXIDATION TEMPERATURE

FIG. 19

PRESENT EMBODIMET

THERMAL OXIDATION TEMPERATURE = 1160°C

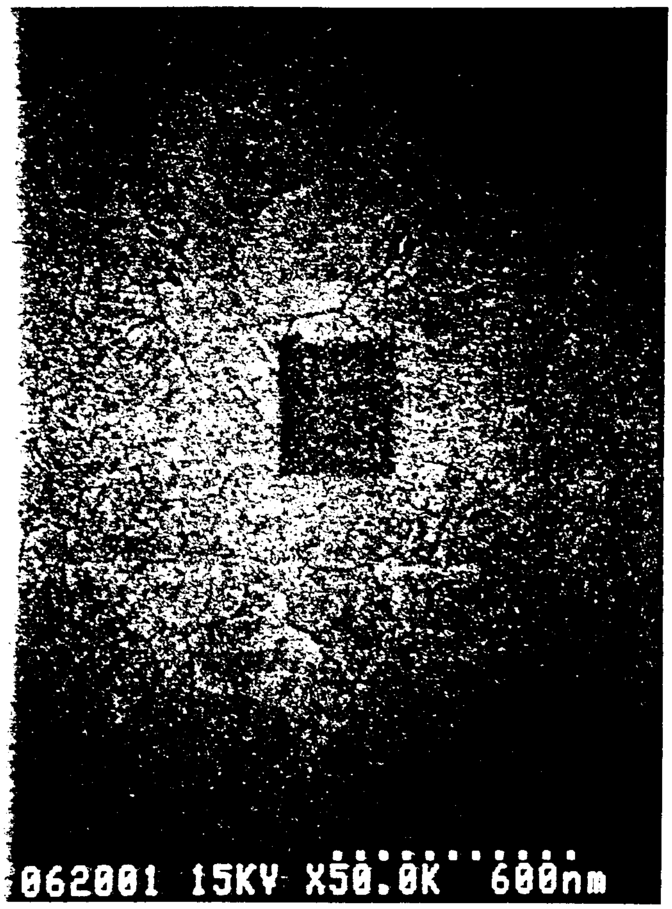


600nm

FIG. 20

PRESENT EMBODIMENT

THERMAL OXIDATION TEMPERATURE = 1050°C

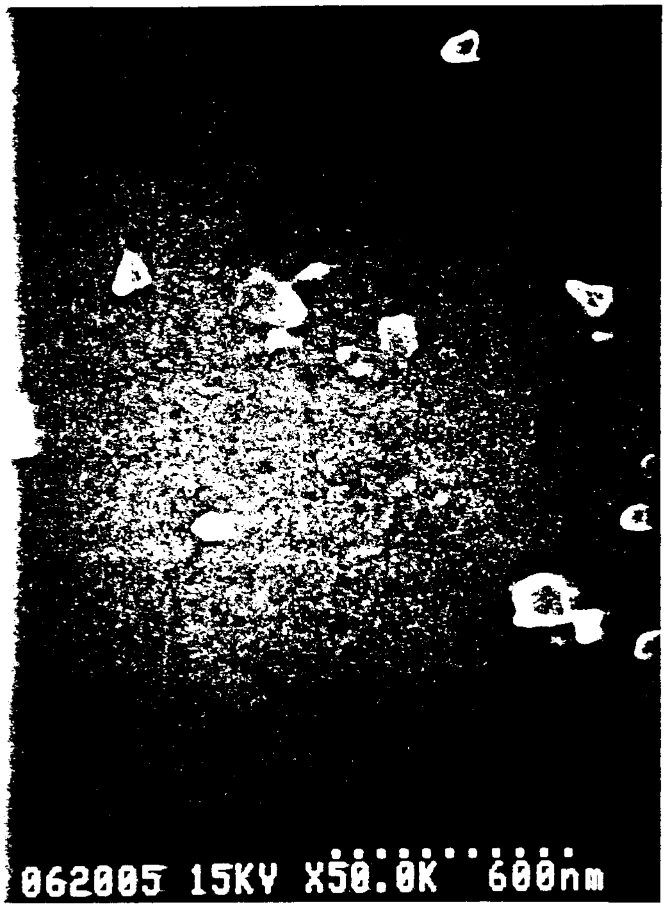


600 nm

FIG.21

PRESENT EMBODIMENT

THERMAL OXIDATION TEMPERATURE = 900°C

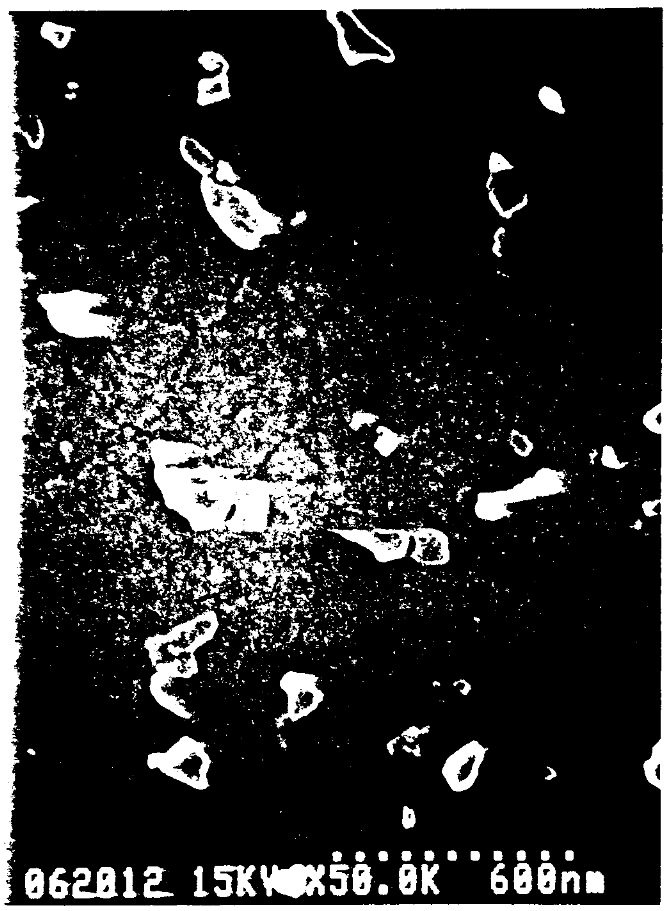


600 nm

FIG. 22

COMPARATIVE EXAMPLE
THERMAL OXIDATION TEMPERATURE = 1160°C

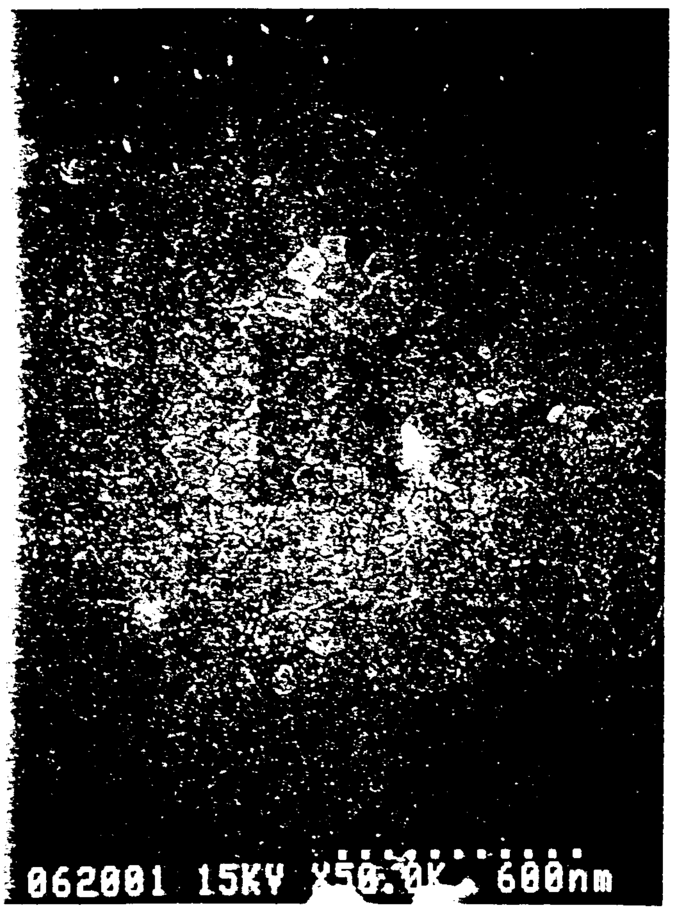


600nm

FIG. 23

COMPARATIVE EXAMPLE

THERMAL OXIDATION TEMPERATURE = 1050°C

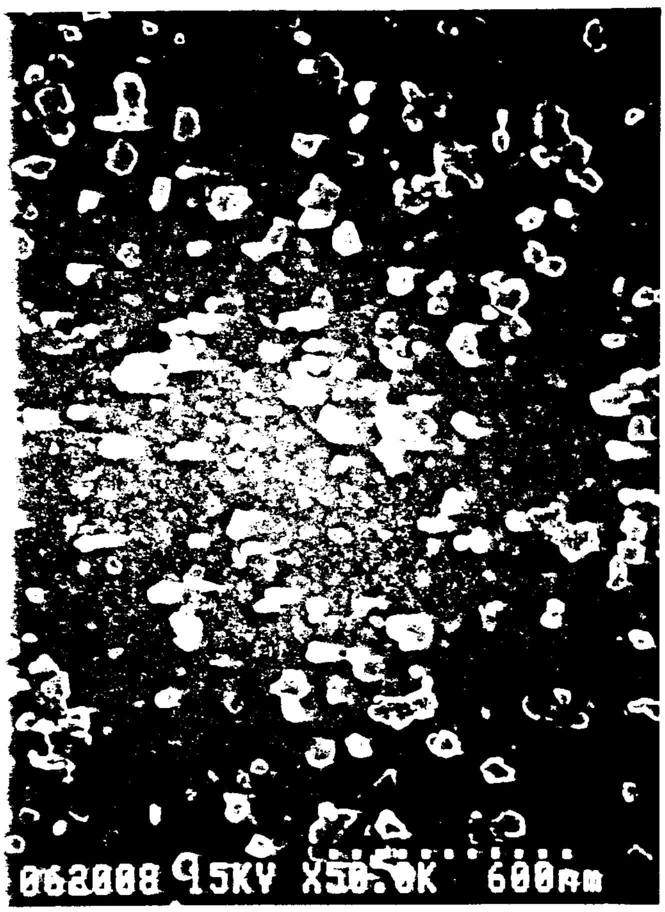


600nm

FIG. 24

COMPARATIVE EXAMPLE
THERMAL OXIDATION TEMPERATURE = 900°C

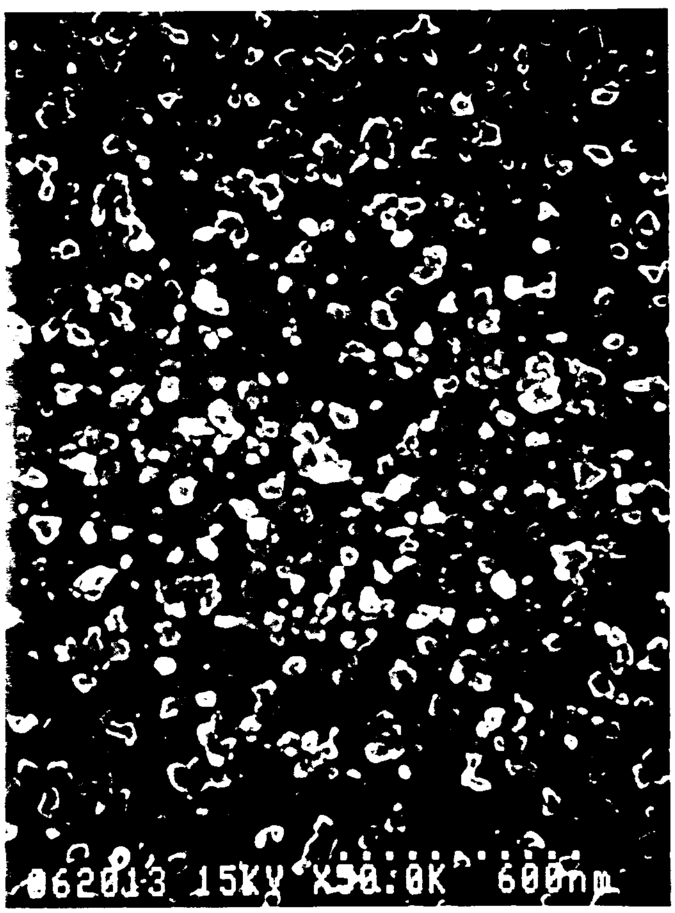


600 nm

FIG. 25A

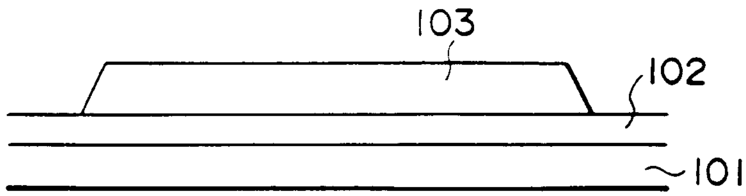


FIG. 25B

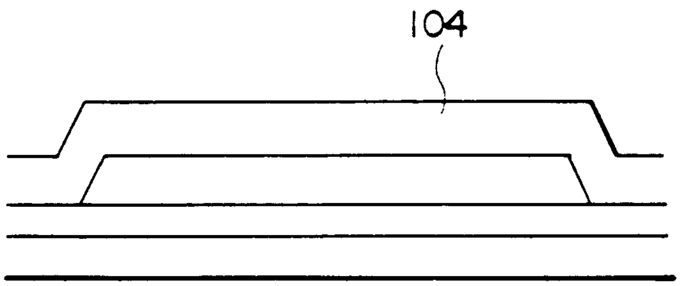


FIG. 25C

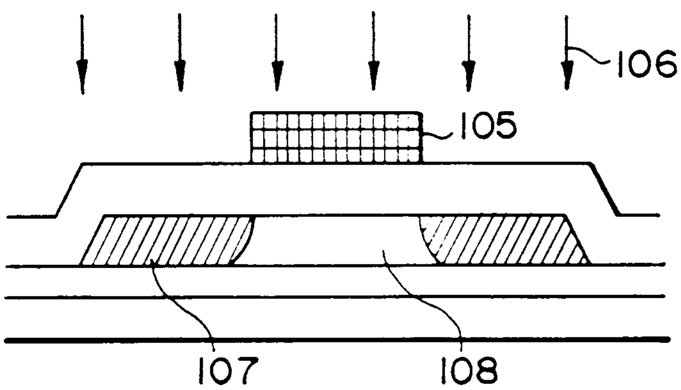


FIG. 25D

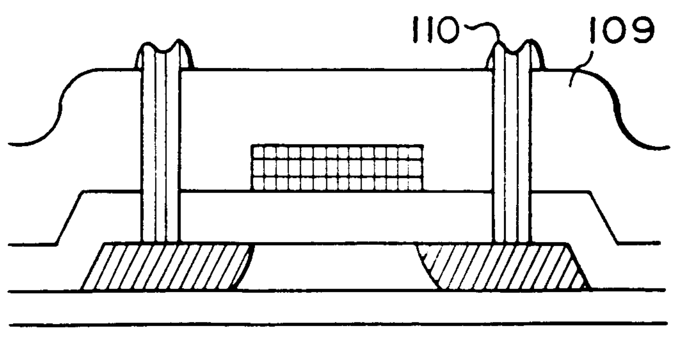

FIG. 26

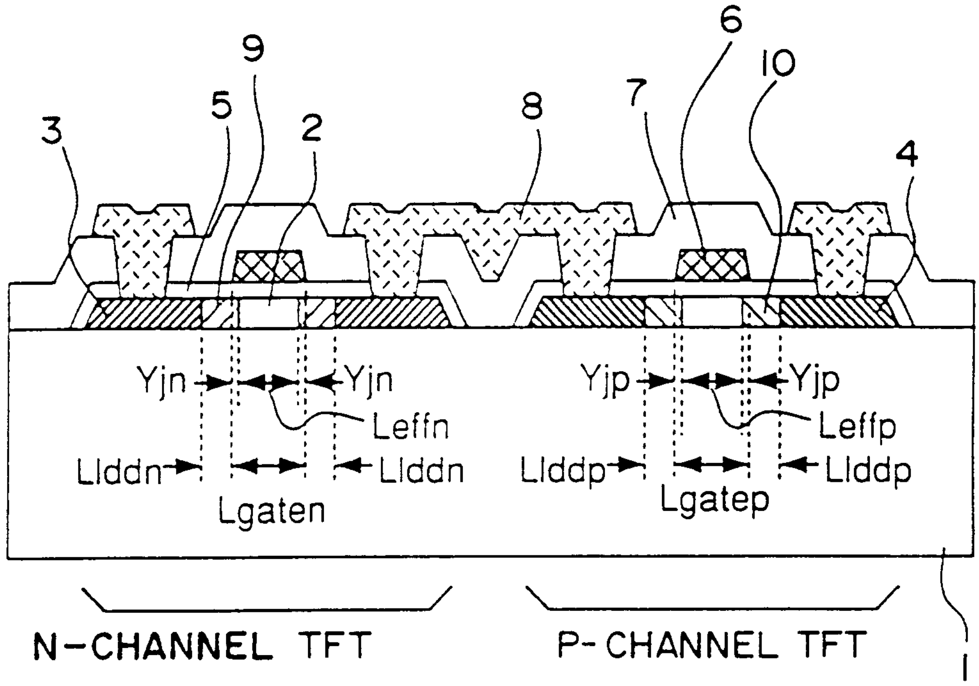


Yjn ..........N-CHANNEL OVERLAPPING PORTION

Yjp ..........P-CHANNEL OVERLAPPING PORTION

Leffn ........EFFECTIVE CHANNEL LENGTH, N-CHANNEL

Leffp ........EFFECTIVE CHANNEL LENGTH, P-CHANNEL

Lgaten ......GATE ELECTRODE LENGTH, N-CHANNEL

Lgatep ......GATE ELECTRODE LENGTH, P-CHANNEL

Llddn ........LDD LENGTH, N-CHANNEL

Llddp ........LDD LENGTH, P-CHANNEL

FIG. 27

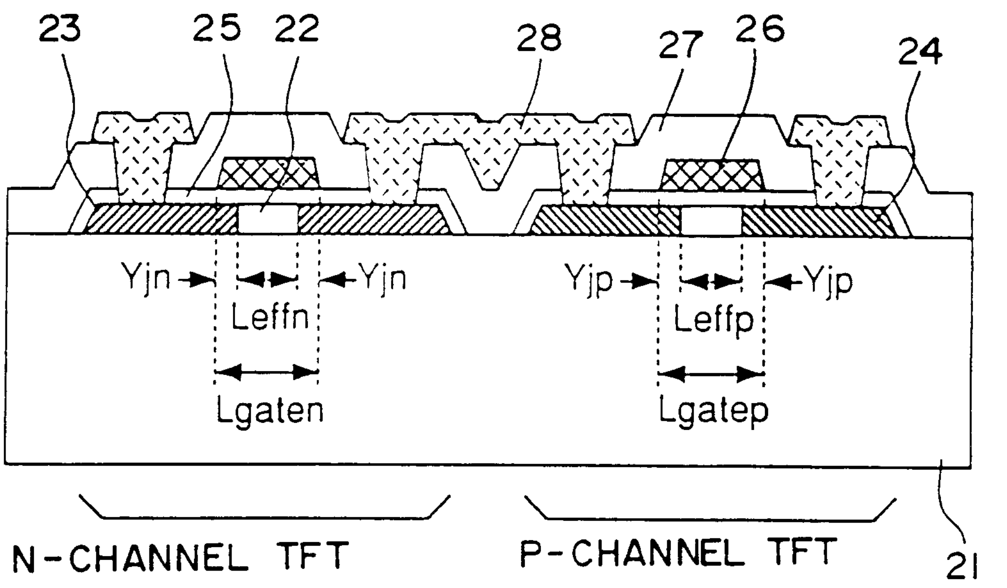


Yjn ..........N-CHANNEL OVERLAPPING PORTION

Yjp ..........P-CHANNEL OVERLAPPING PORTION

Leffn ........EFFECTIVE CHANNEL LENGTH, N-CHANNEL

Leffp ........EFFECTIVE CHANNEL LENGTH, P-CHANNEL

Lgaten ......GATE ELECTRODE LENGTH, N-CHANNEL

Lgatep ......GATE ELECTRODE LENGTH, P-CHANNEL

FIG. 28

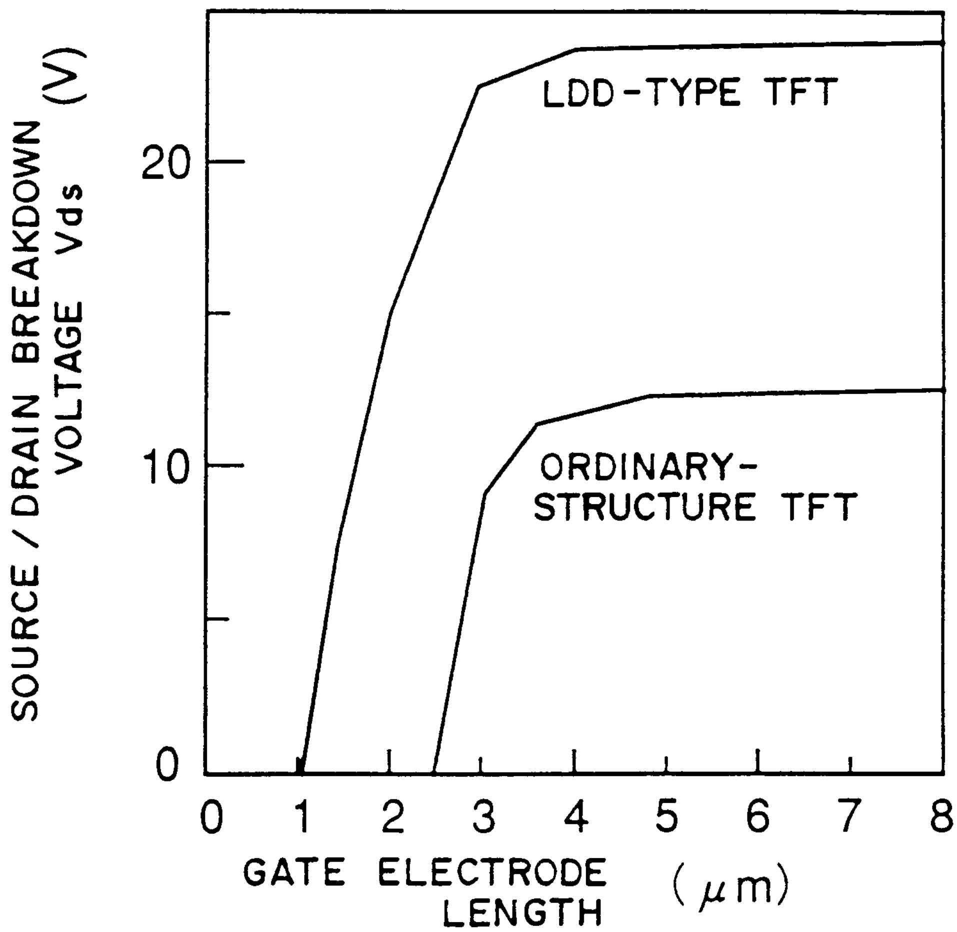
SOURCE / DRAIN BREAKDOWN VOLTAGE Vds (V)
20
10
0
LDD-TYPE TFT
ORDINARY-STRUCTURE TFT
0 1 2 3 4 5 6 7 8
GATE ELECTRODE LENGTH (μm)

FIG. 29

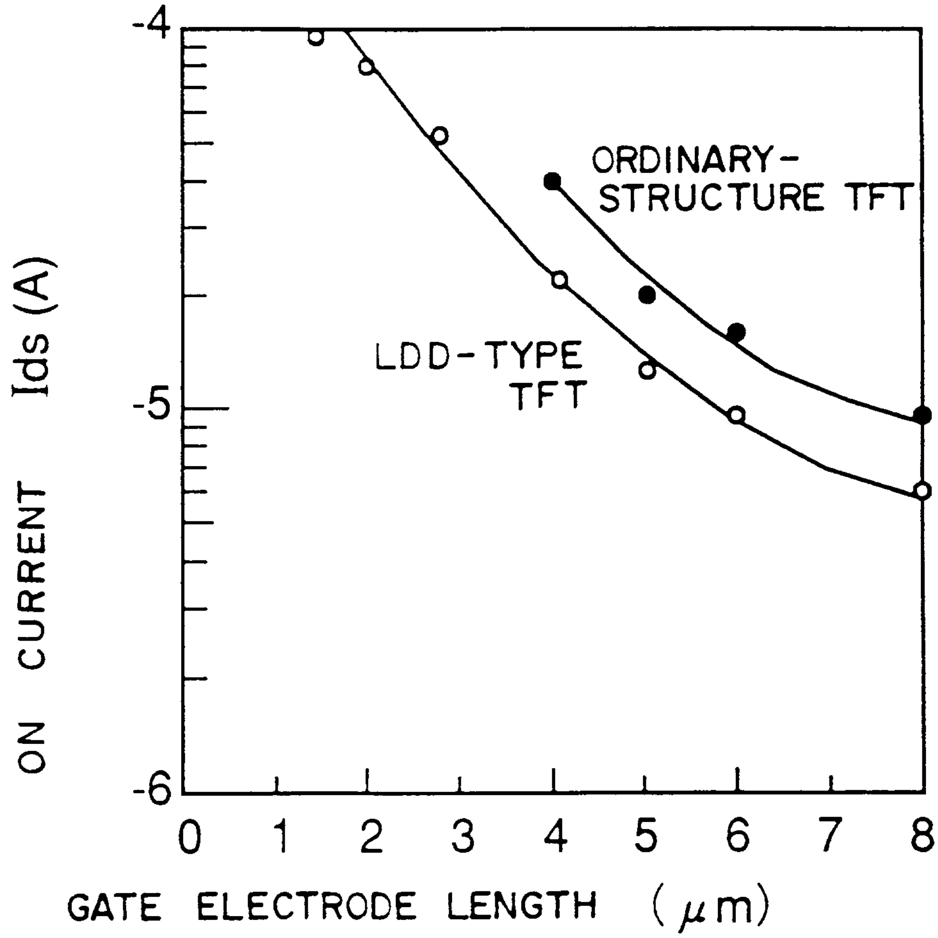

-4
-5
-6
ON CURRENT Ids (A)
ORDINARY-STRUCTURE TFT
LDD-TYPE TFT
0
1
2
3
4
5
6
7
8
GATE ELECTRODE LENGTH (μm)

FIG. 30A

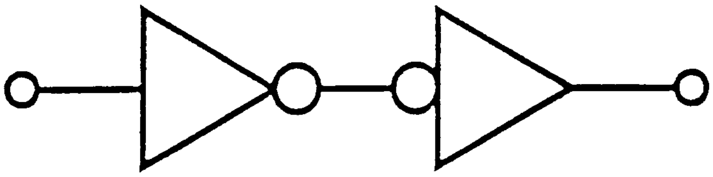

FIG. 30B

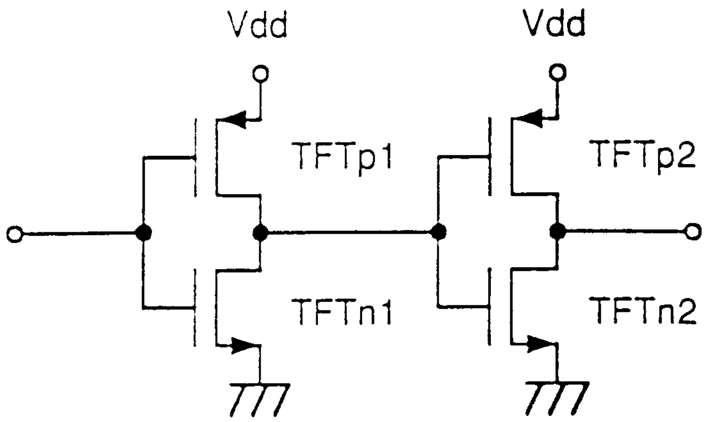


FIG. 30C

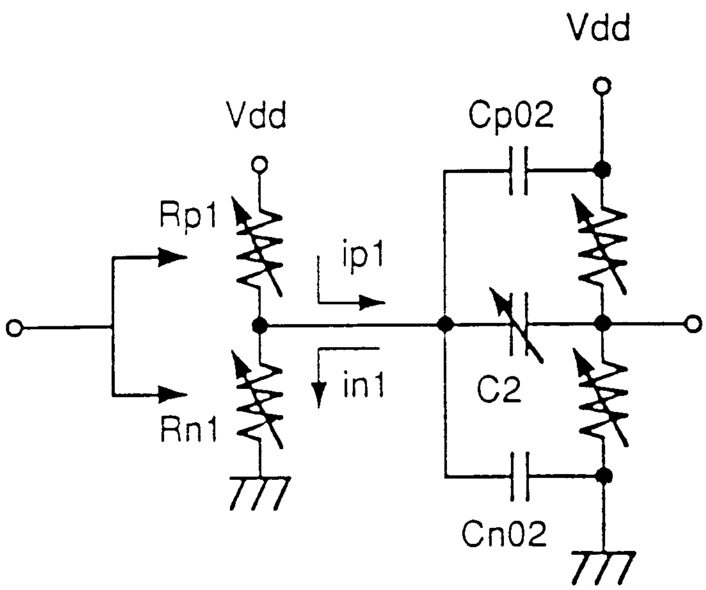

FIG. 31A

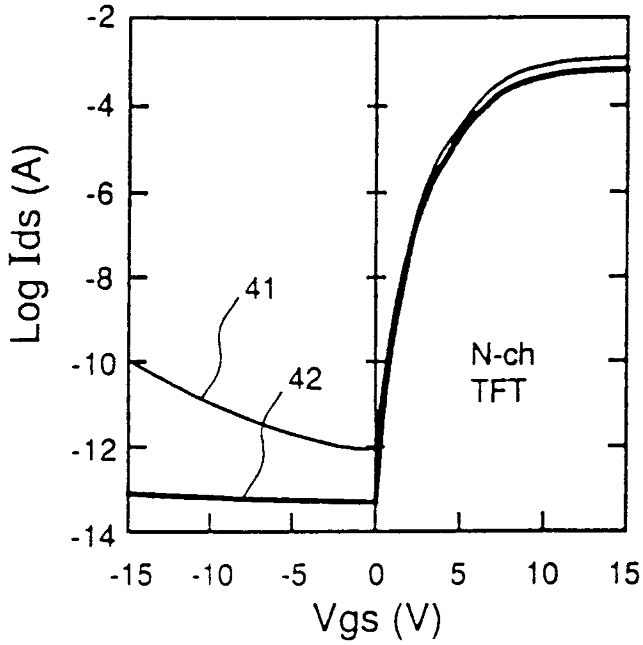


FIG. 31B

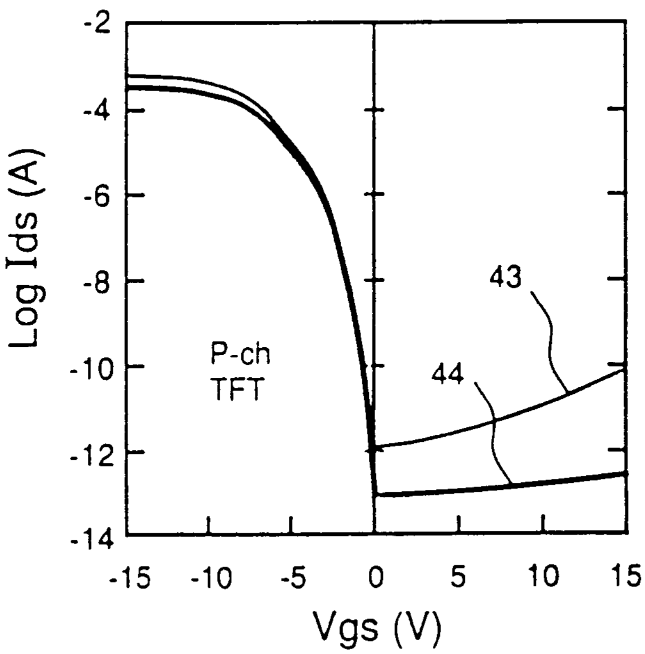


41,43 ........ TRANSFER CHARACTERISTICS OF ORDINARY-STRUCTURE TFT

42,44 ........ TRANSFER CHARACTERISTICS OF LDD-TYPE TFT

FIG. 32

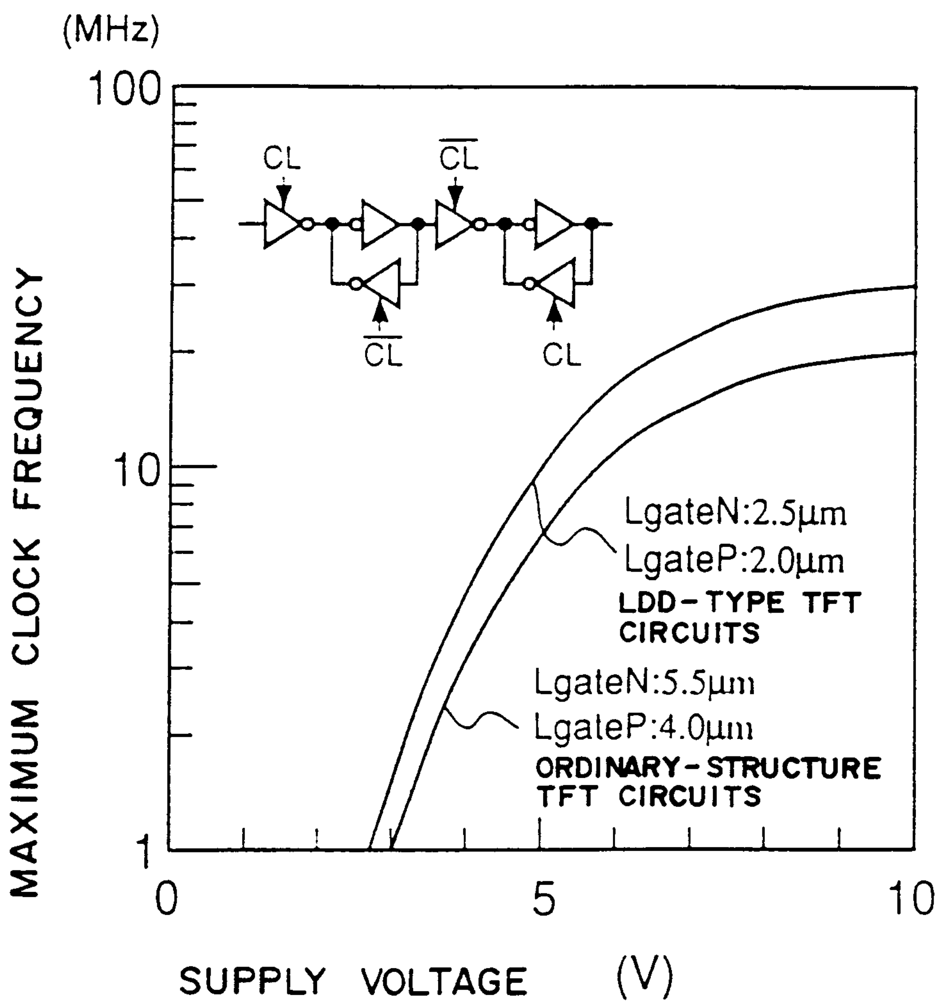
(MHz)
100
10
1
0
5
10
MAXIMUM CLOCK FREQUENCY
SUPPLY VOLTAGE (V)
CL
CL
CL
CL
LgateN:2.5μm
LgateP:2.0μm
LDD-TYPE TFT CIRCUITS
LgateN:5.5μm
LgateP:4.0μm
ORDINARY-STRUCTURE TFT CIRCUITS

FIG. 33A

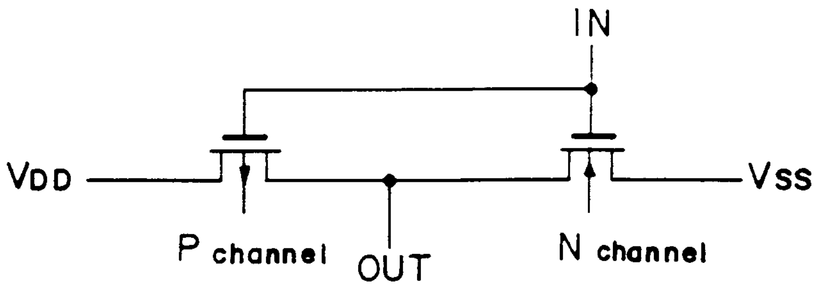


FIG. 33B

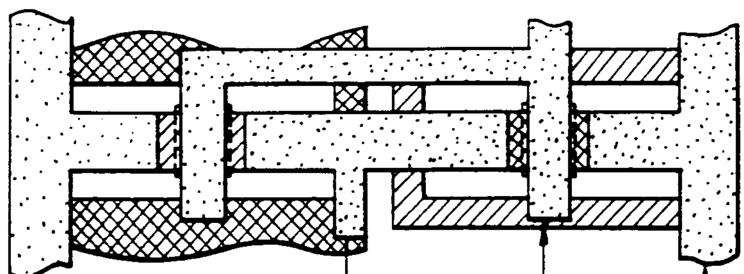

FIG. 33C

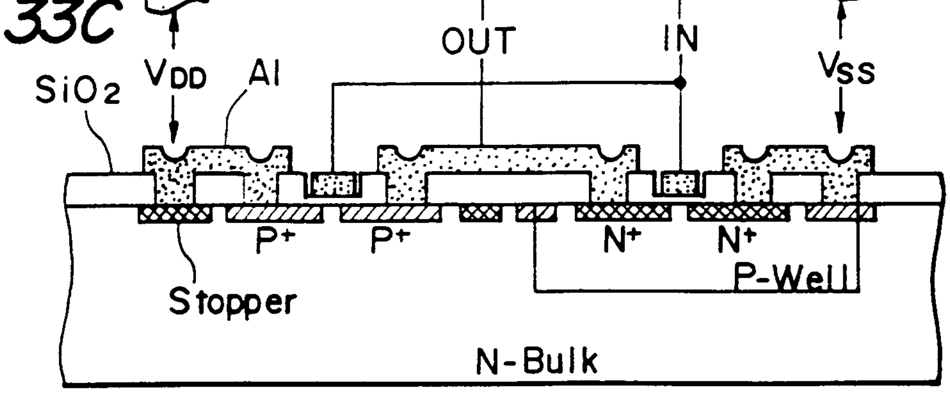

FIG. 34

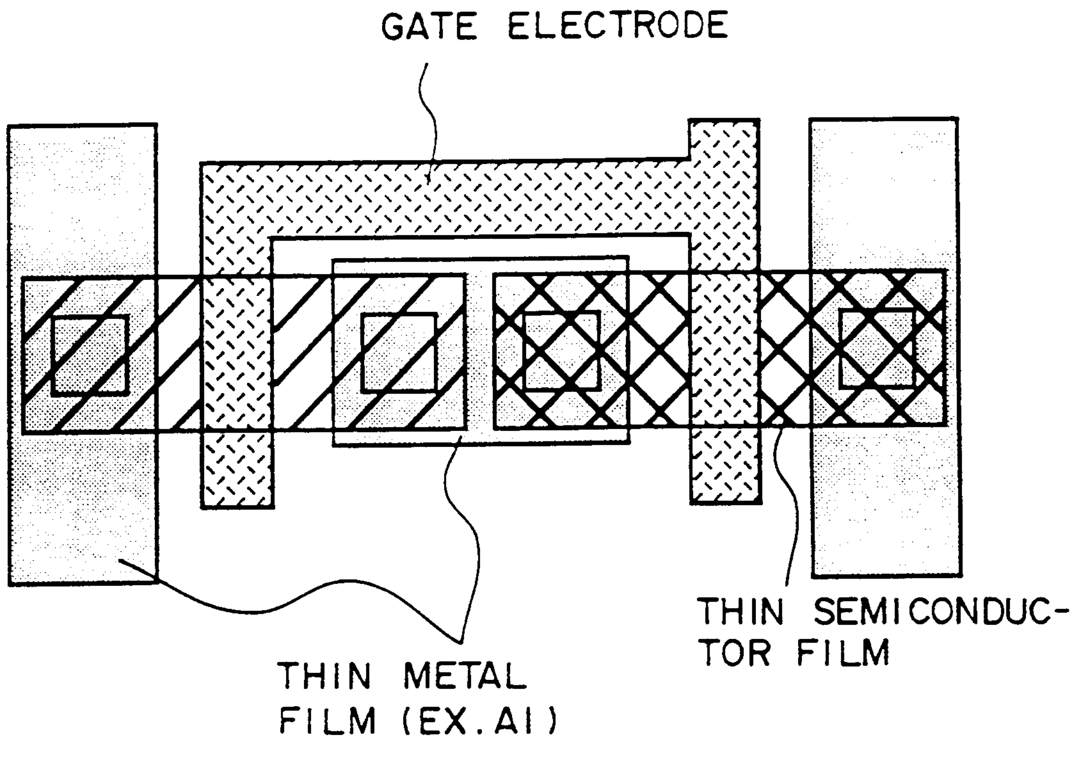
GATE ELECTRODE
THIN METAL FILM (EX.Al)
THIN SEMICONDUCTOR FILM

FIG. 35

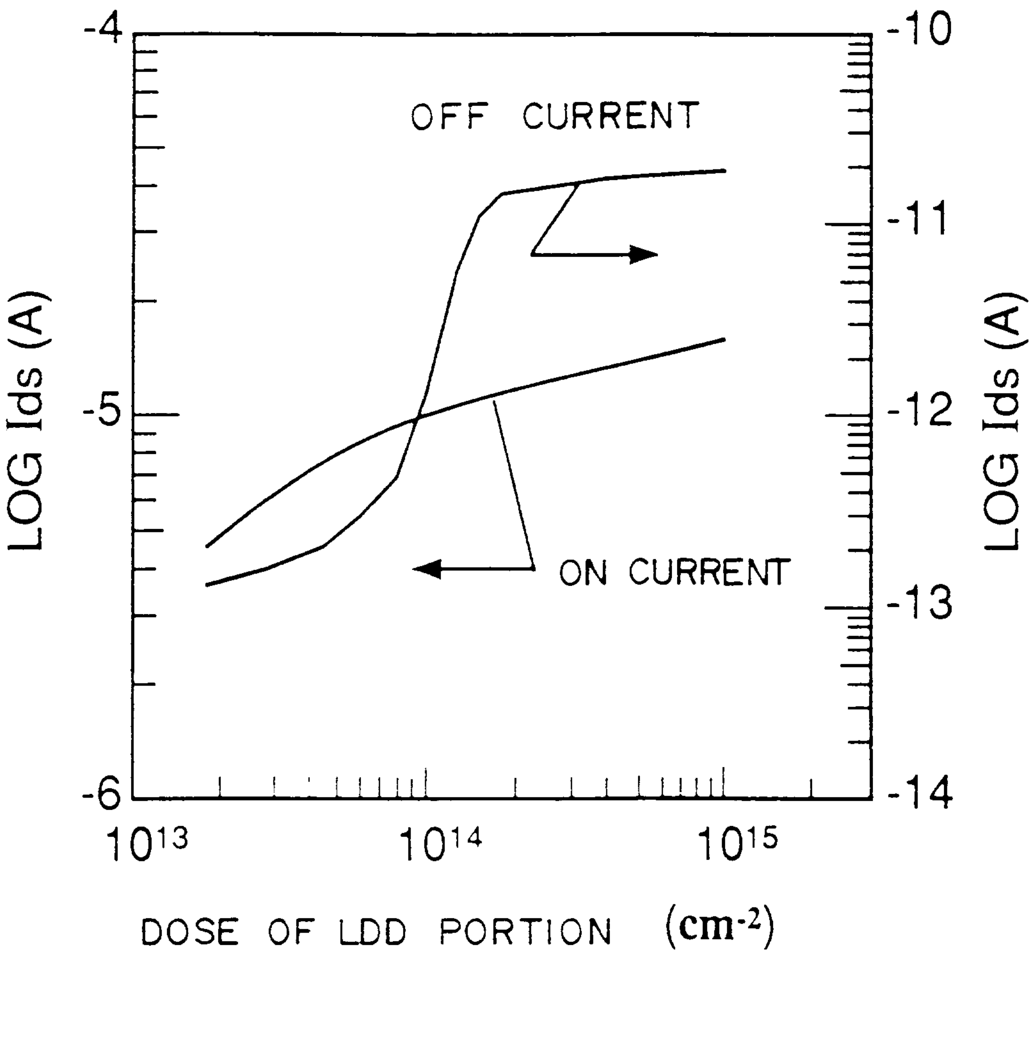
-4
-5
-6
-10
-11
-12
-13
-14
LOG Ids (A)
LOG Ids (A)
OFF CURRENT
ON CURRENT
$10^{13}$
$10^{14}$
$10^{15}$
DOSE OF LDD PORTION (cm$^{-2}$)

FIG. 36

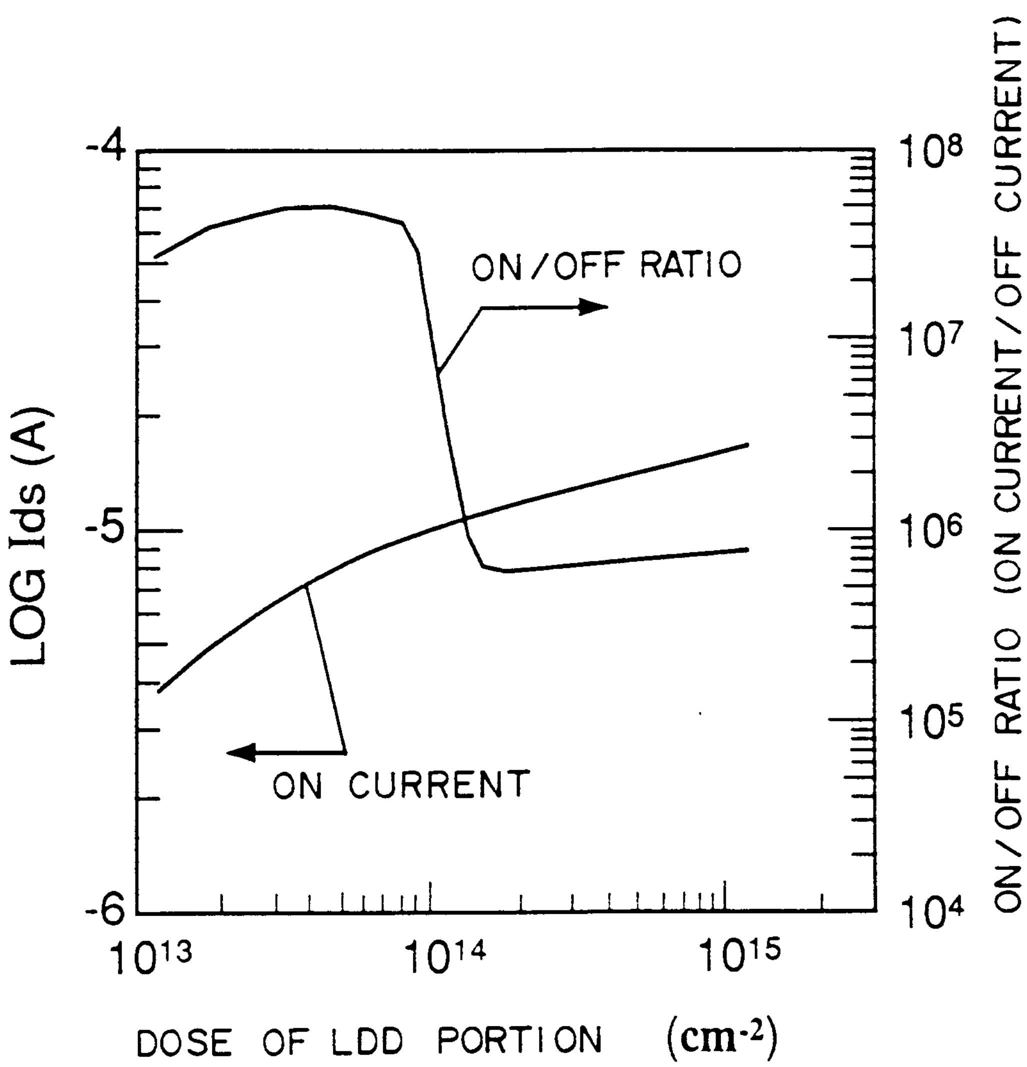
-4
-5
-6
LOG Ids (A)
ON/OFF RATIO
ON CURRENT
$10^{8}$
$10^{7}$
$10^{6}$
$10^{5}$
$10^{4}$
ON/OFF RATIO (ON CURRENT/OFF CURRENT)
$10^{13}$
$10^{14}$
$10^{15}$
DOSE OF LDD PORTION $(cm^{-2})$

FIG.37

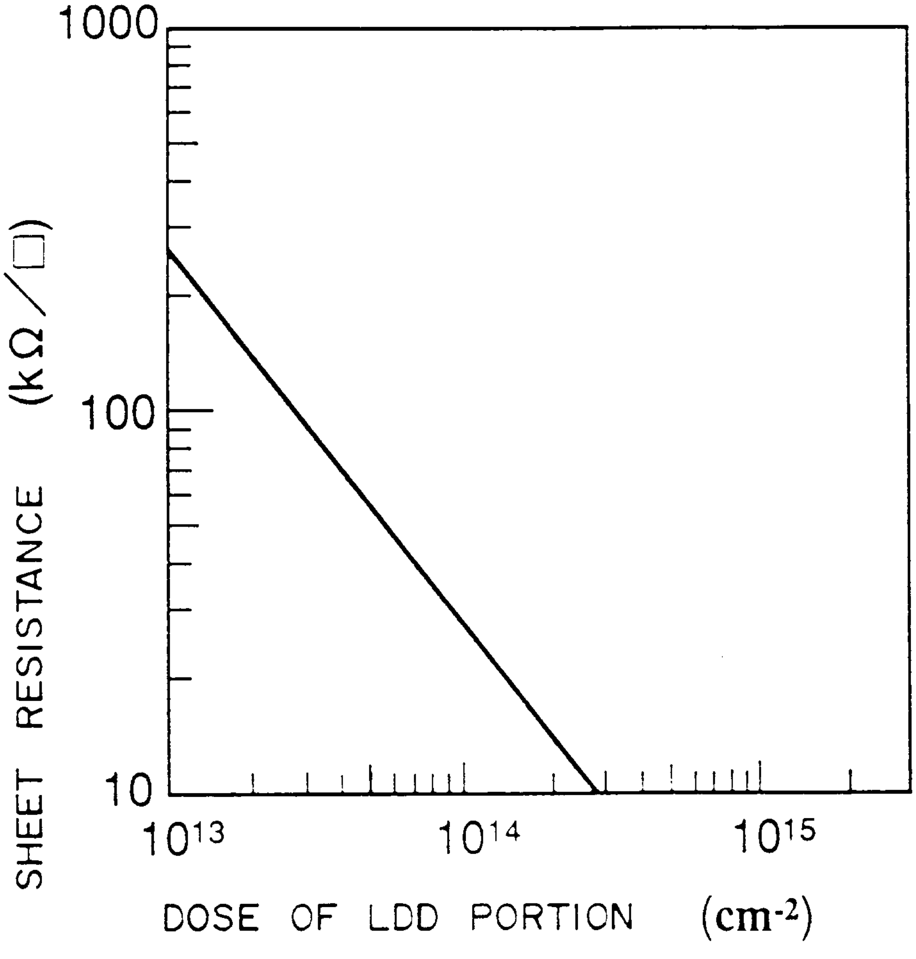
1000
100
10
SHEET RESISTANCE (kΩ/□)
10¹³
10¹⁴
10¹⁵
DOSE OF LDD PORTION (cm⁻²)

FIG. 38

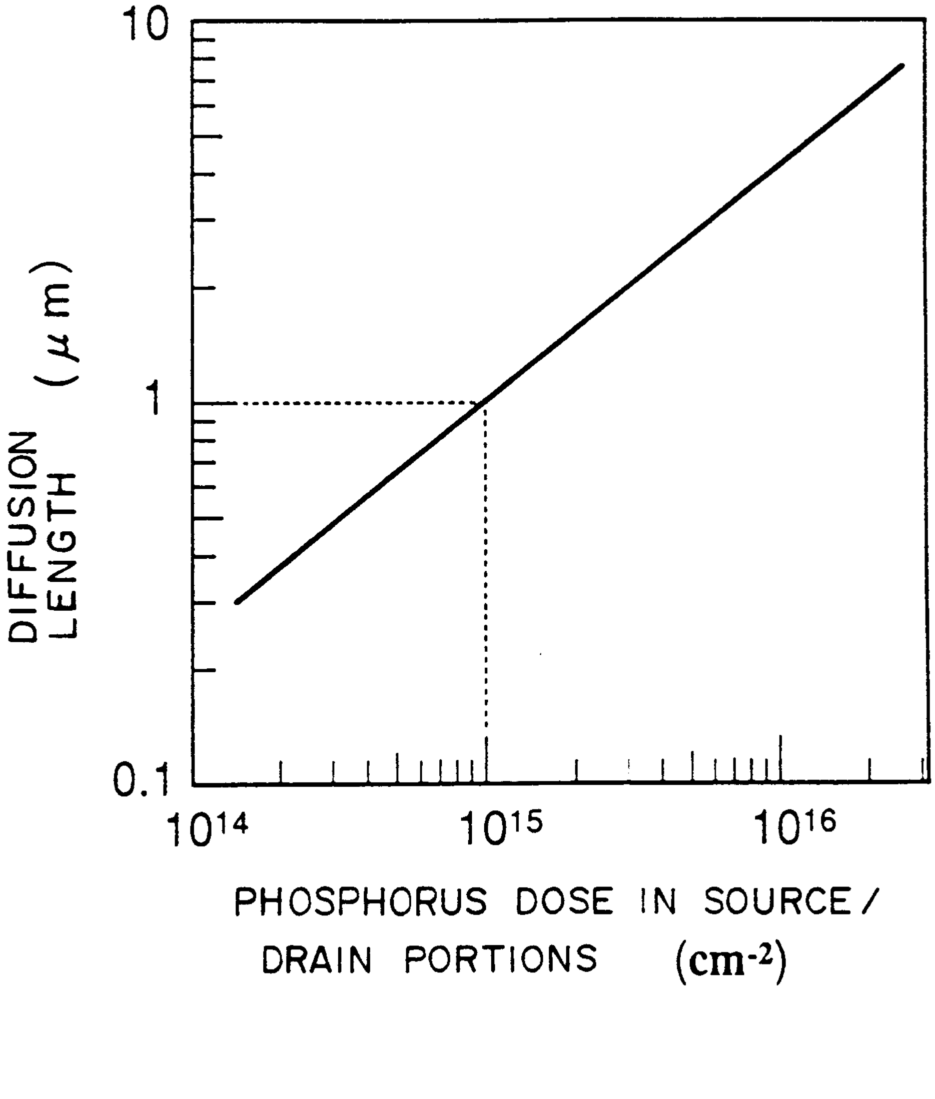
10
1
0.1
DIFFUSION LENGTH (μm)
$10^{14}$
$10^{15}$
$10^{16}$
PHOSPHORUS DOSE IN SOURCE/
DRAIN PORTIONS (cm-2)

FIG. 39

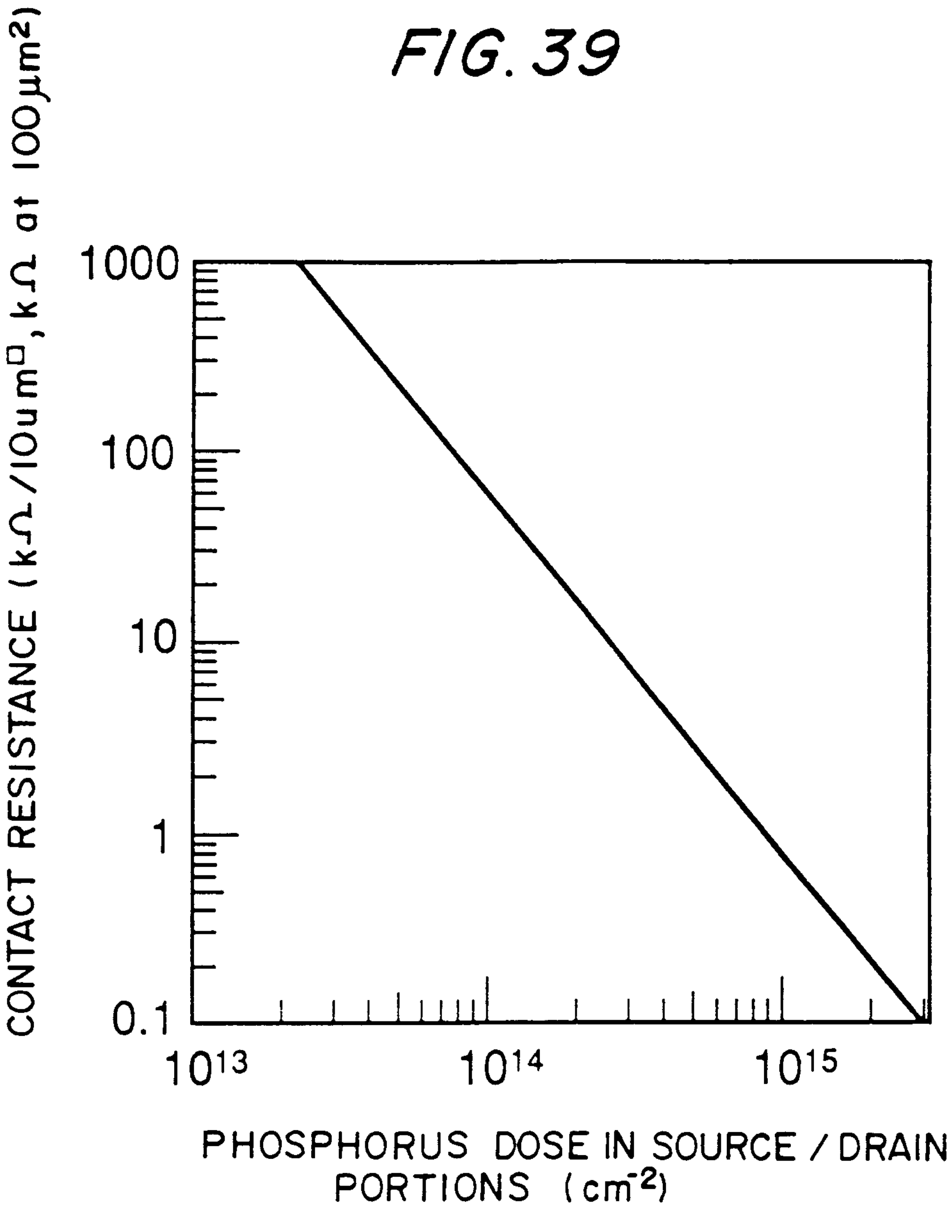
CONTACT RESISTANCE ( kΩ/10um□, kΩ at 100μm²)
1000
100
10
1
0.1
10^13
10^14
10^15
PHOSPHORUS DOSE IN SOURCE / DRAIN PORTIONS (cm⁻²)

FIG. 40

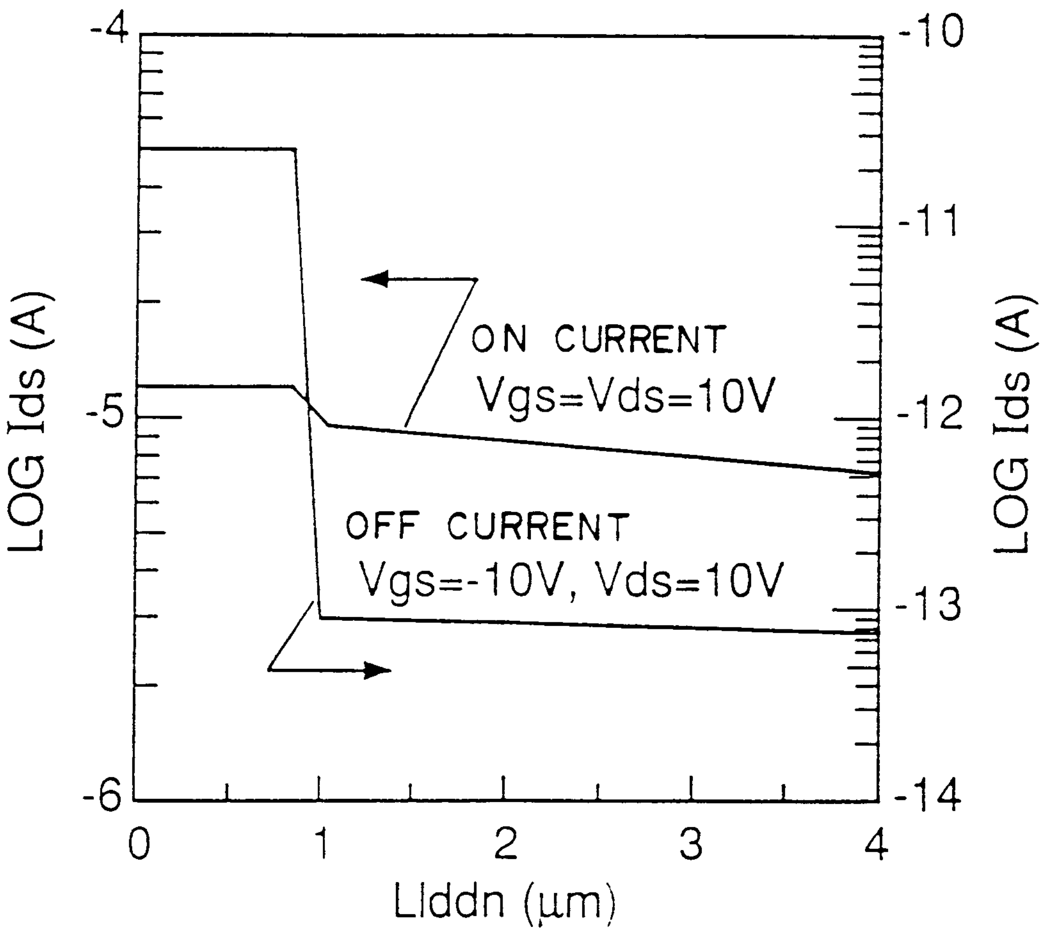
-4
-5
-6
-10
-11
-12
-13
-14
0
1
2
3
4
LOG Ids (A)
LOG Ids (A)
Llddn (μm)
ON CURRENT
Vgs=Vds=10V
OFF CURRENT
Vgs=-10V, Vds=10V

FIG. 4I

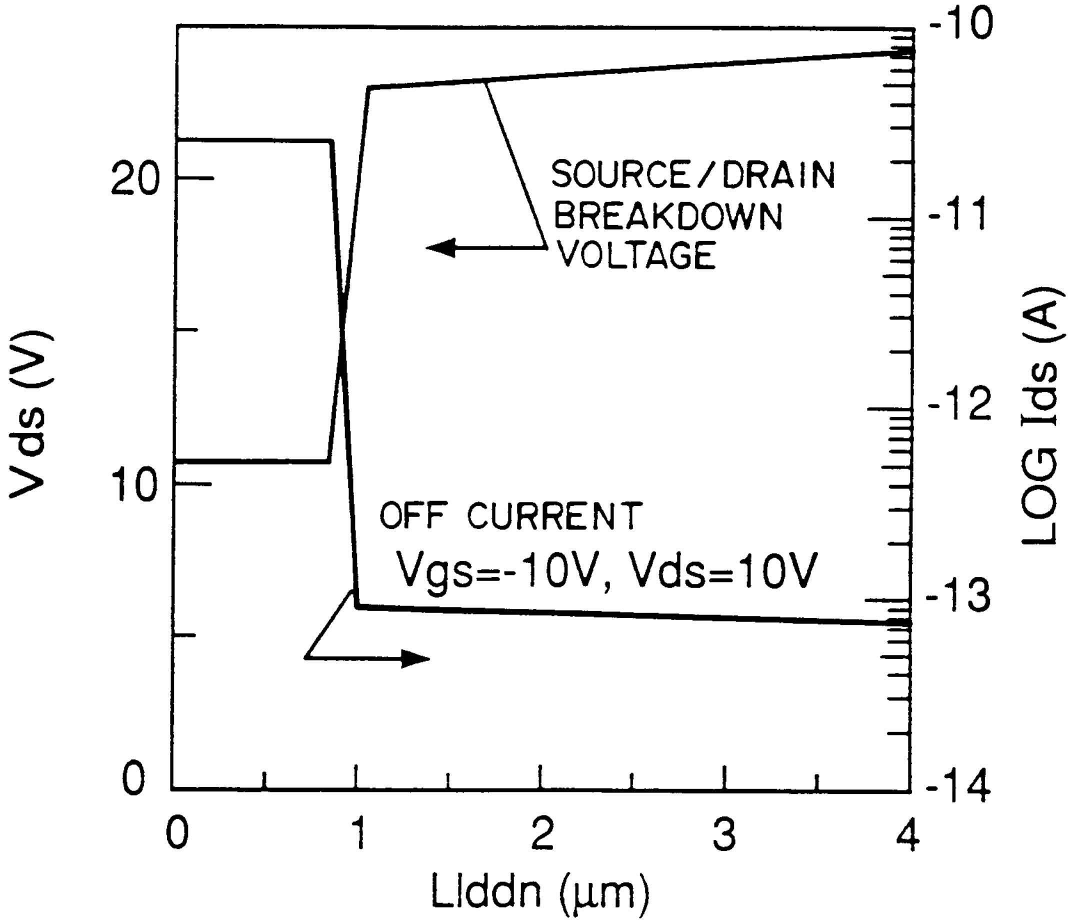
-10
20
SOURCE / DRAIN
BREAKDOWN
VOLTAGE
-11
Vds (V)
LOG Ids (A)
-12
10
OFF CURRENT
Vgs=-10V, Vds=10V
-13
0
-14
0
1
2
3
4
Llddn (μm)

FIG. 42A

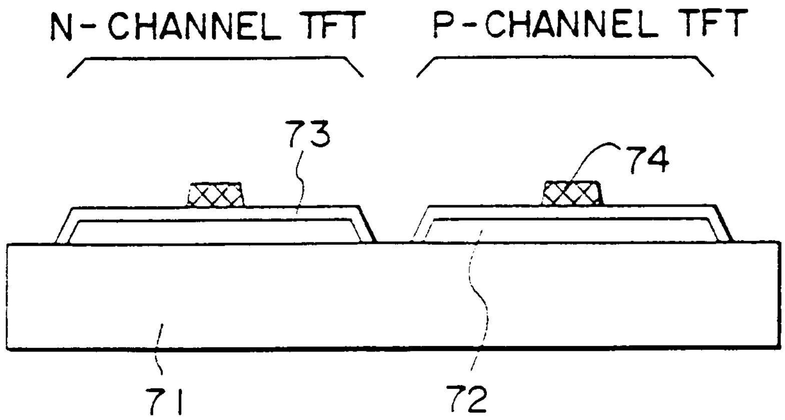


FIG. 42B

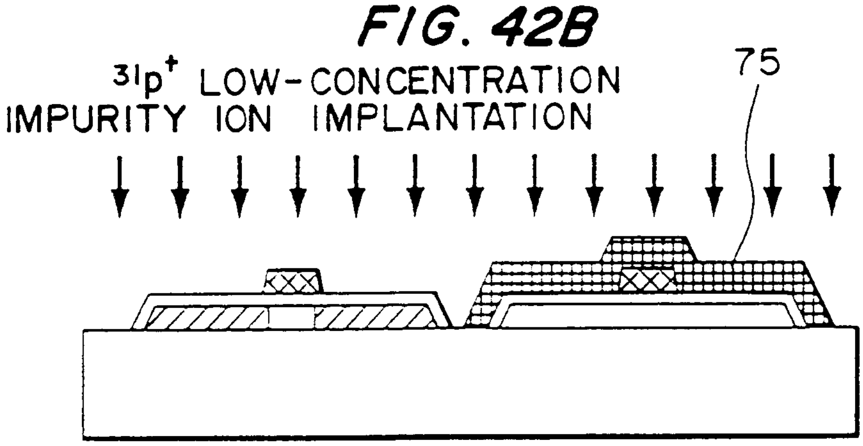


FIG. 42C

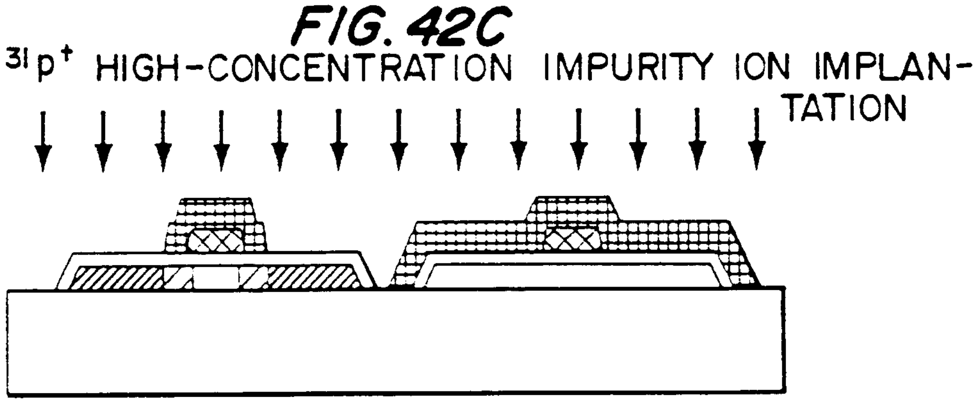


FIG. 42D

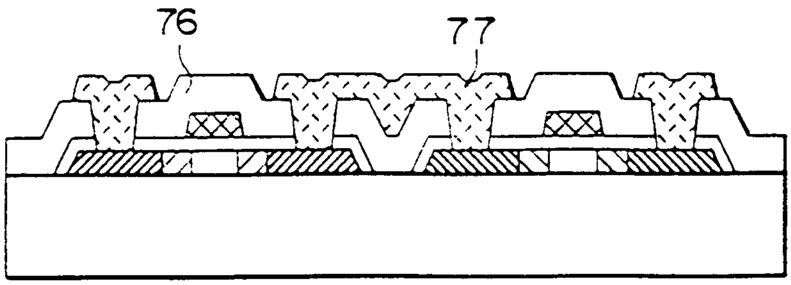

FIG. 43

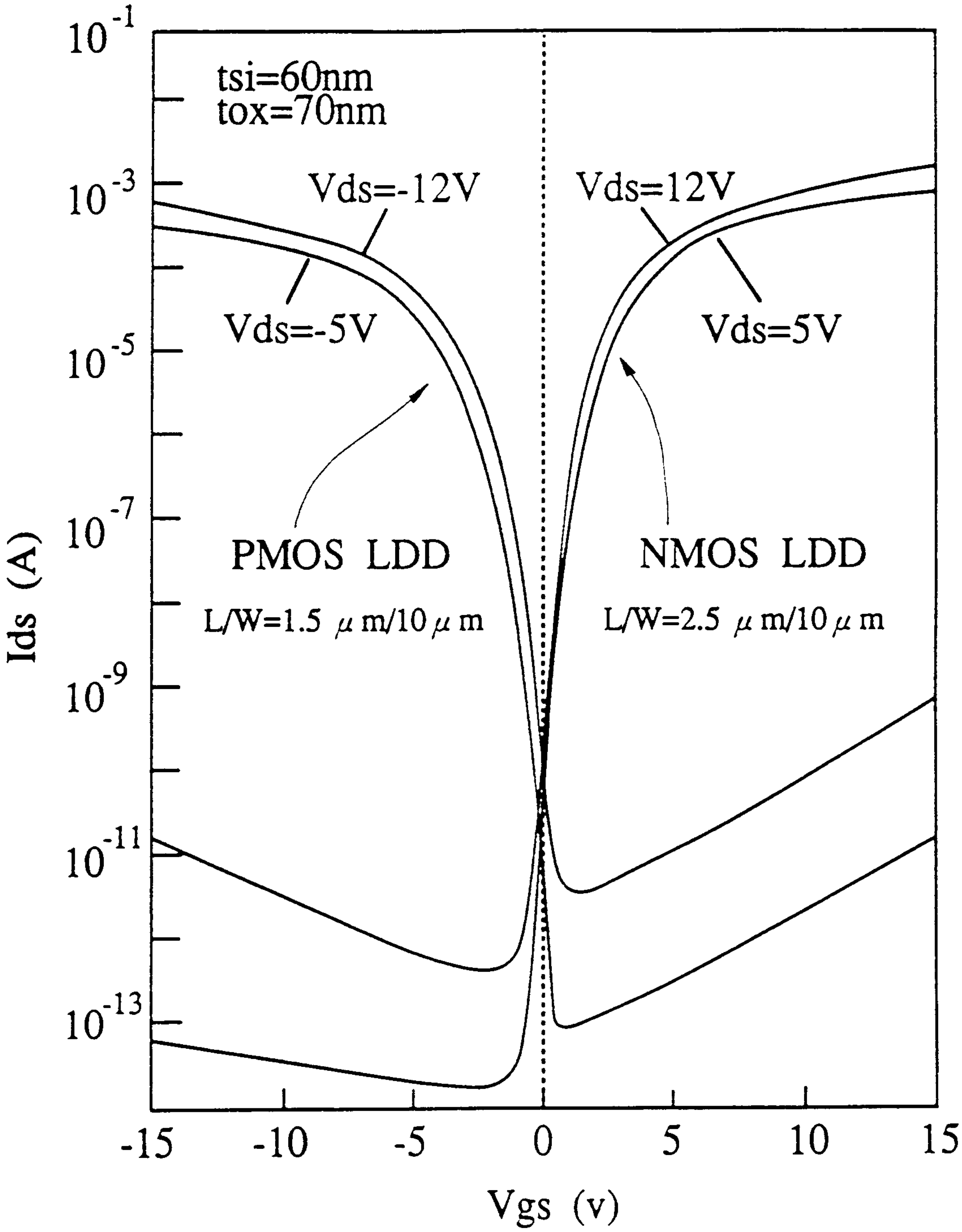
tsi=60nm
tox=70nm
Vds=-12V
Vds=-5V
Vds=12V
Vds=5V
PMOS LDD
L/W=1.5 μm/10μm
NMOS LDD
L/W=2.5 μm/10μm
Ids (A)
10^-1
10^-3
10^-5
10^-7
10^-9
10^-11
10^-13
-15
-10
-5
0
5
10
15
Vgs (v)

FIG. 44

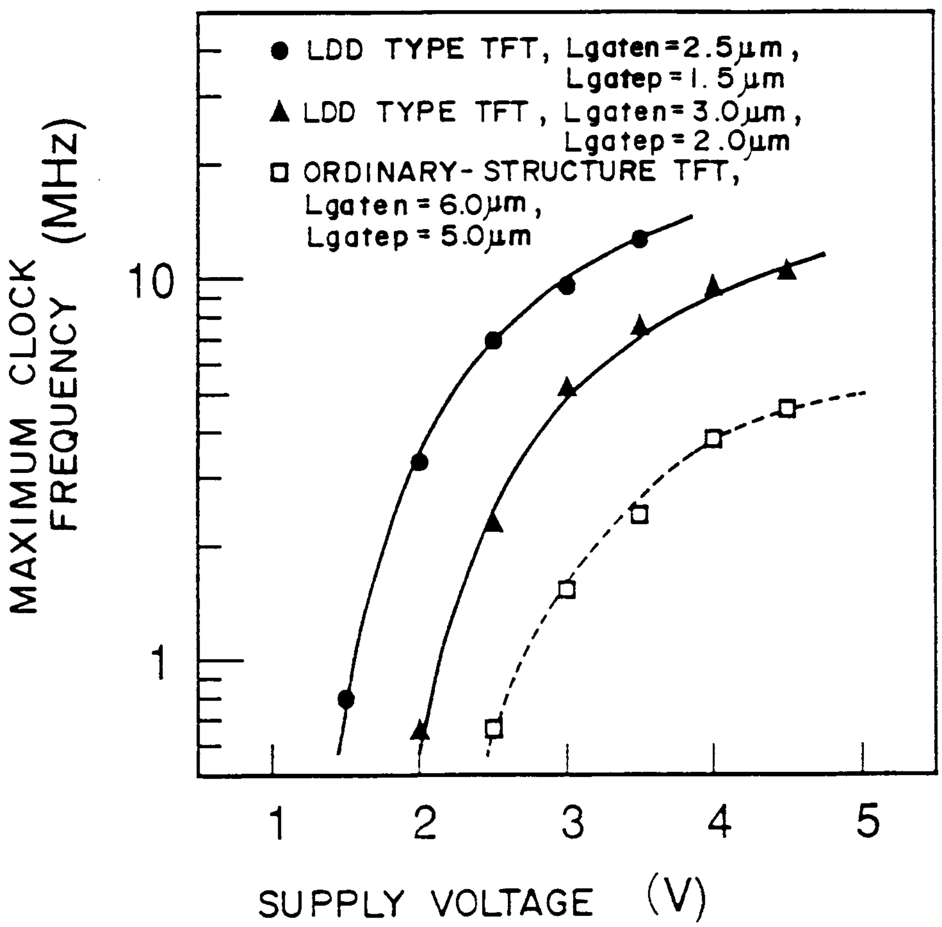
● LDD TYPE TFT, Lgaten=2.5μm, Lgatep=1.5μm
▲ LDD TYPE TFT, Lgaten=3.0μm, Lgatep=2.0μm
□ ORDINARY-STRUCTURE TFT, Lgaten=6.0μm, Lgatep=5.0μm
MAXIMUM CLOCK FREQUENCY (MHz)
10
1
1
2
3
4
5
SUPPLY VOLTAGE (V)

# FIG. 45

| | COMPARATIVE EXAMPLE | PRESENT EMBODIMENT |
|---|---|---|
| CONTACT RESISTANCE (PMOS) | 1.4kΩ at 10μm x 10μm (DOSE = $1 \times 10^{15} cm^{-2}$, Nmax = $1 \times 10^{20} cm^{-3}$) | 1.18kΩ at 10μm x 10μm (DOSE = $1 \times 10^{15} cm^{-2}$, Nmax = $1 \times 10^{20} cm^{-3}$) |
| CONTACT RESISTANCE (NMOS) | 1.4kΩ at 10μm x 10μm (DOSE = $1 \times 10^{15} cm^{-2}$, Nmax = $1 \times 10^{20} cm^{-3}$) | 1.2kΩ at 10μm x 10μm (DOSE = $1 \times 10^{15} cm^{-2}$, Nmax = $1 \times 10^{20} cm^{-3}$) |
| SOURCE/ DRAIN SHEET RESISTANCE (PMOS) | 2.6KΩ/□ (DOSE = $1 \times 10^{15} cm^{-2}$, Nmax = $1 \times 10^{20} cm^{-3}$) | 50Ω/□ (DOSE = $1 \times 10^{15} cm^{-2}$, Nmax = $1 \times 10^{20} cm^{-3}$) |
| SOURCE/ DRAIN SHEET RESISTANCE (NMOS) | 2.6KΩ/□ (DOSE = $1 \times 10^{15} cm^{-2}$, Nmax = $1 \times 10^{20} cm^{-3}$) | 530Ω/□ (DOSE = $1 \times 10^{15} cm^{-2}$, Nmax = $1 \times 10^{20} cm^{-3}$) |
| LDD SHEET RESISTANCE (PMOS) | 375KΩ/□ (DOSE = $1 \times 10^{13} cm^{-2}$, Nmax = $1 \times 10^{18} cm^{-3}$) | 13KΩ/□ (DOSE = $1 \times 10^{13} cm^{-2}$, Nmax = $1 \times 10^{18} cm^{-3}$) |
| LDD SHEET RESISTANCE (NMOS) | 360KΩ/□ (DOSE = $1 \times 10^{13} cm^{-2}$, Nmax = $1 \times 10^{18} cm^{-3}$) | 72KΩ/□ (DOSE = $1 \times 10^{13} cm^{-2}$, Nmax = $1 \times 10^{18} cm^{-3}$) |

FIG. 46

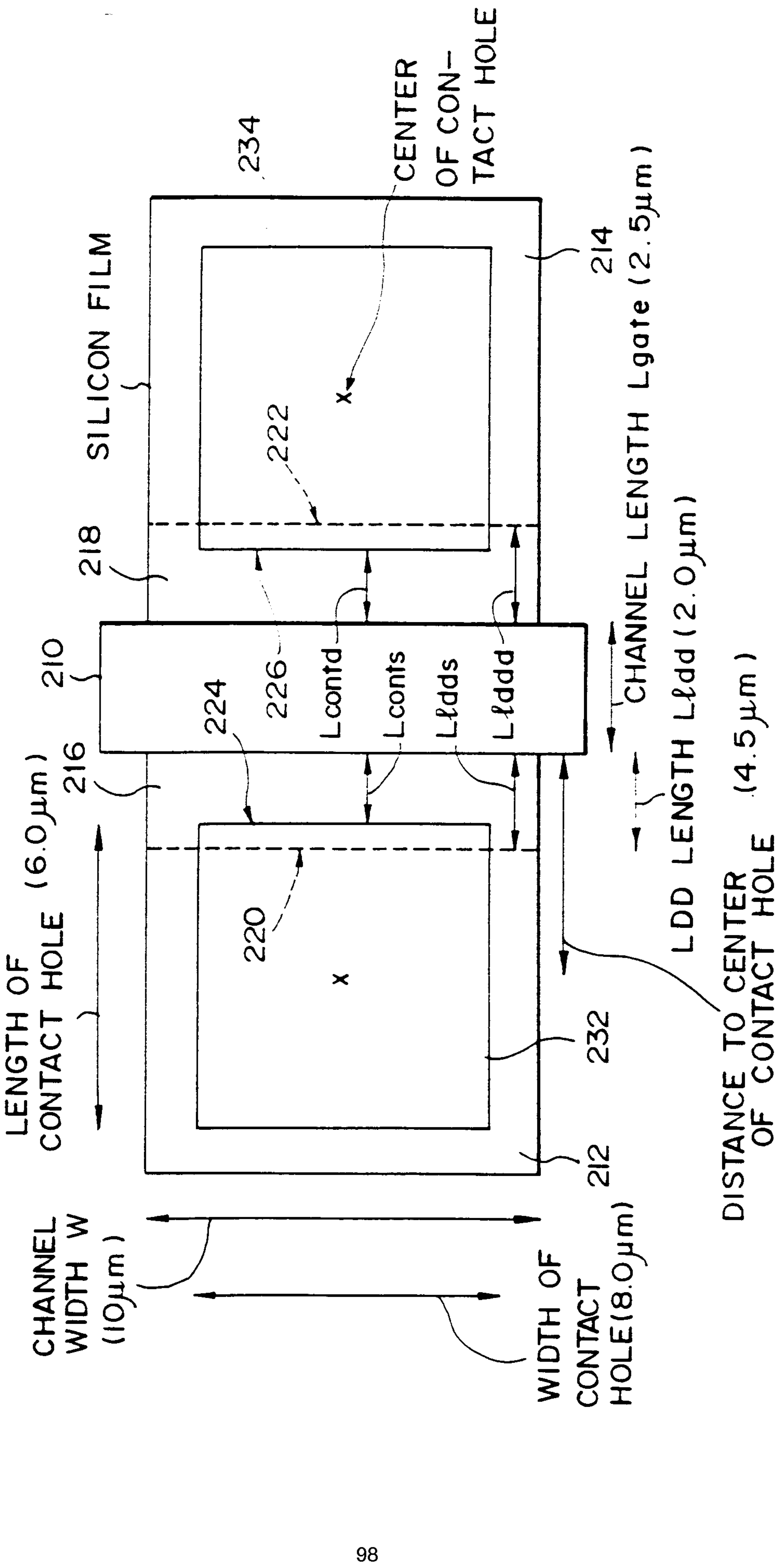
234
CENTER OF CONTACT HOLE
SILICON FILM
214
CHANNEL LENGTH Lgate (2.5μm)
222
218
210
226
Lcontd
Lconts
Llddd
Lldds
CHANNEL LENGTH Lgate (2.5μm)
LDD LENGTH Lldd (2.0μm)
(4.5μm)
224
216
LENGTH OF CONTACT HOLE (6.0μm)
220
232
212
DISTANCE TO CENTER OF CONTACT HOLE
CHANNEL WIDTH W (10μm)
WIDTH OF CONTACT HOLE(8.0μm)

FIG.47

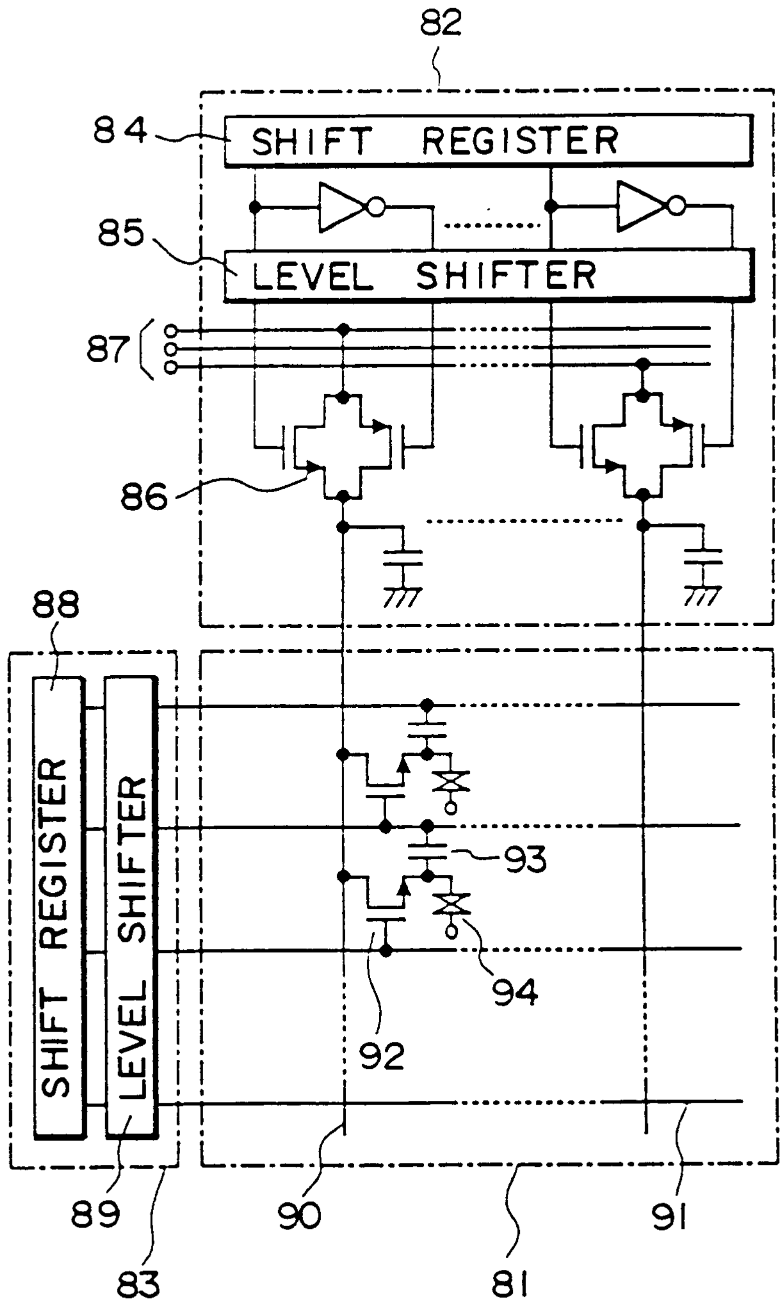
82
84
SHIFT REGISTER
85
LEVEL SHIFTER
87
86
88
SHIFT REGISTER
LEVEL SHIFTER
93
94
92
89
83
90
81
91

FIG. 48A

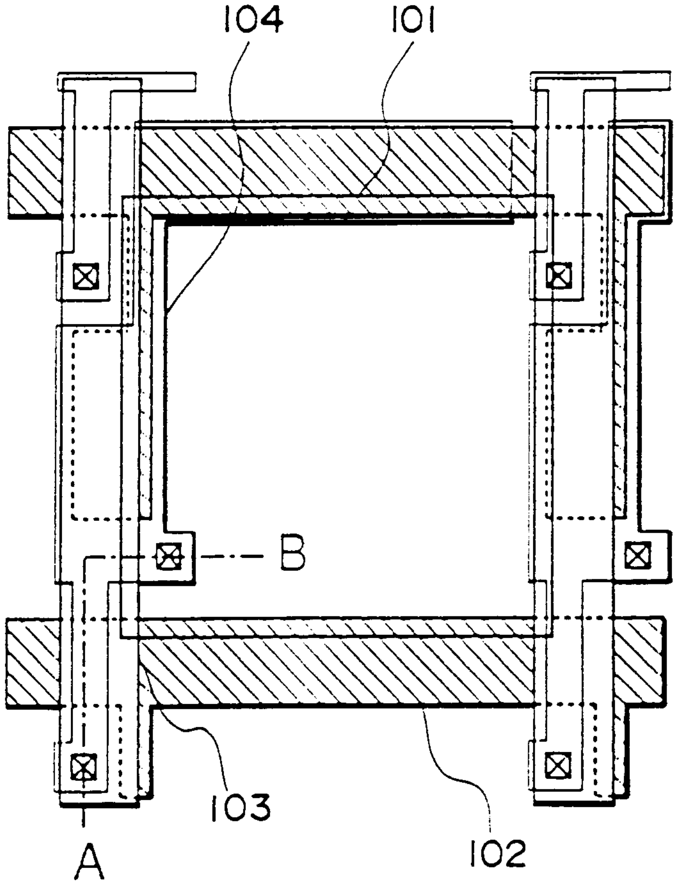


FIG. 48B

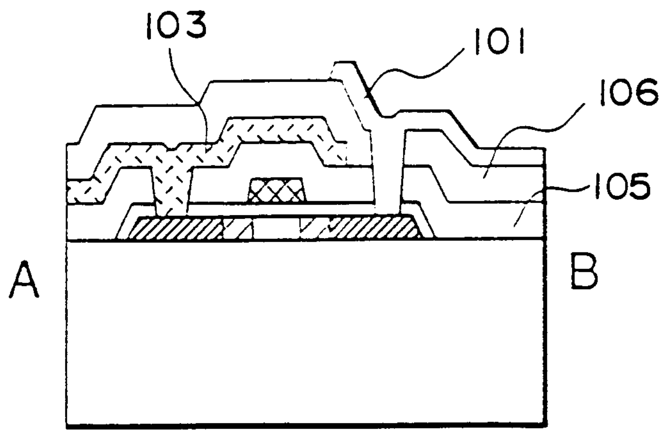

FIG. 49A

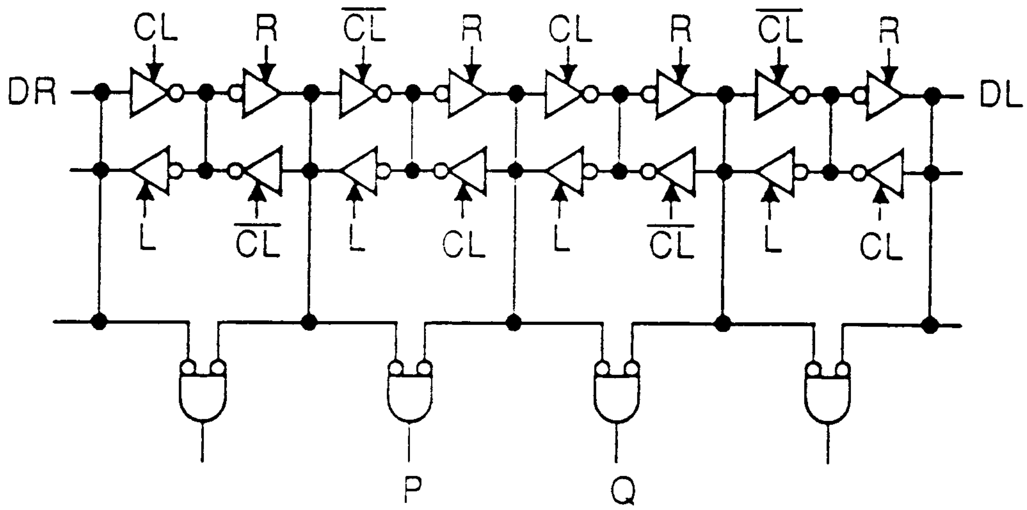


FIG. 49B

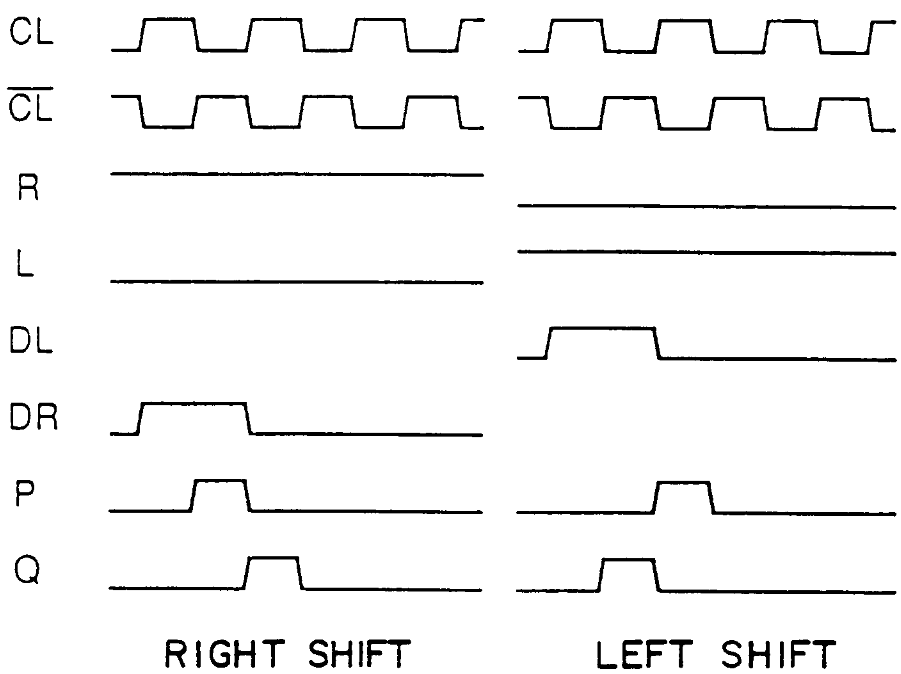

FIG. 50A

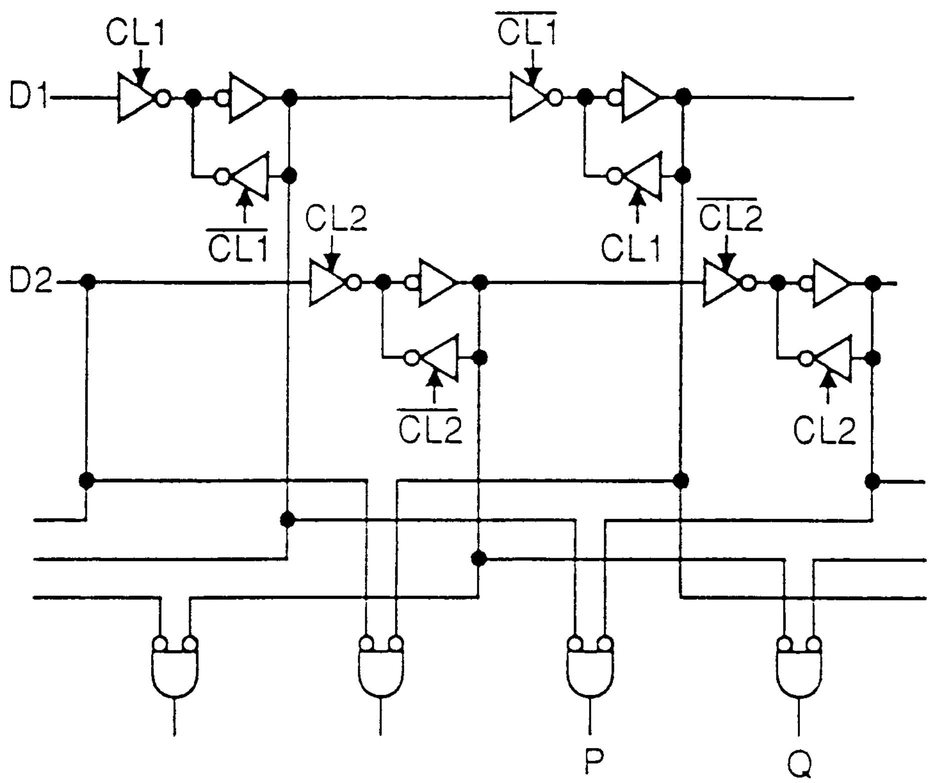


FIG. 50B

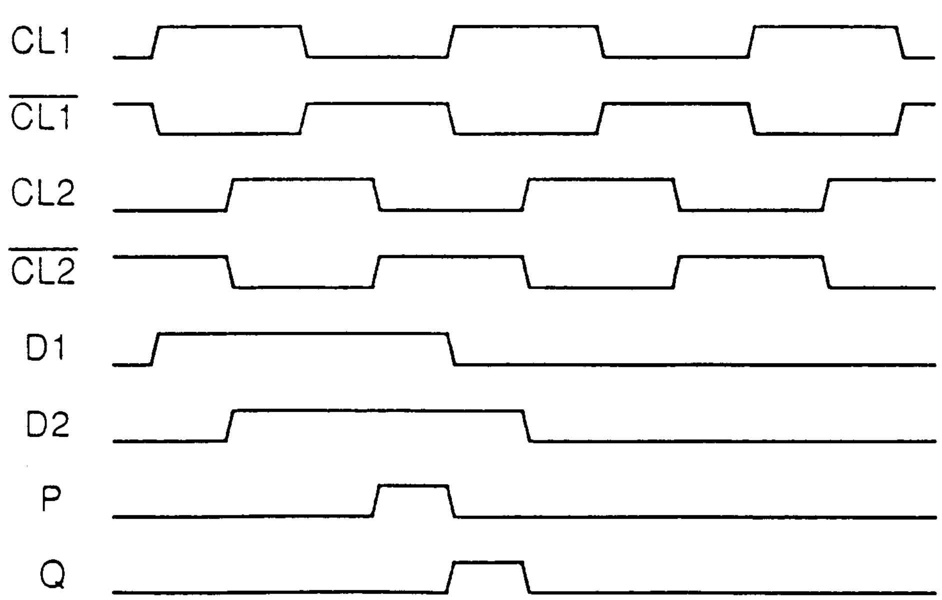

FIG. 51A

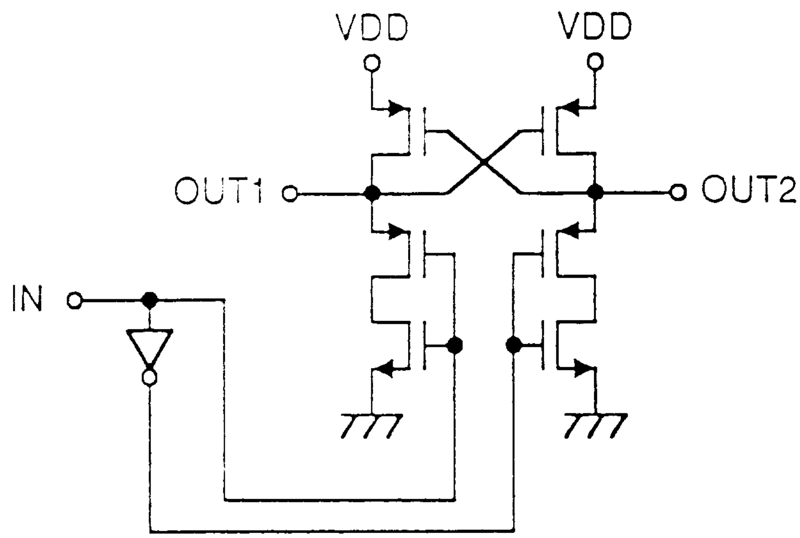


FIG. 51B

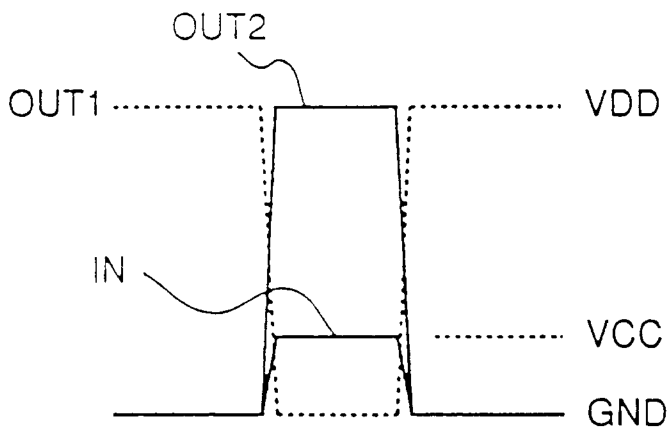

FIG. 52

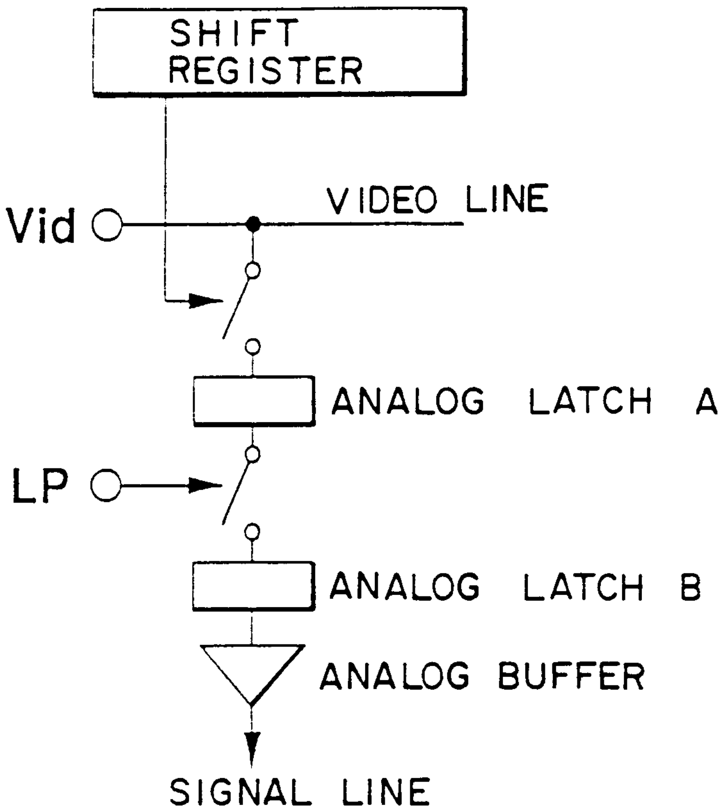
SHIFT
REGISTER
VIDEO LINE
Vid
ANALOG LATCH A
LP
ANALOG LATCH B
ANALOG BUFFER
SIGNAL LINE

FIG. 53

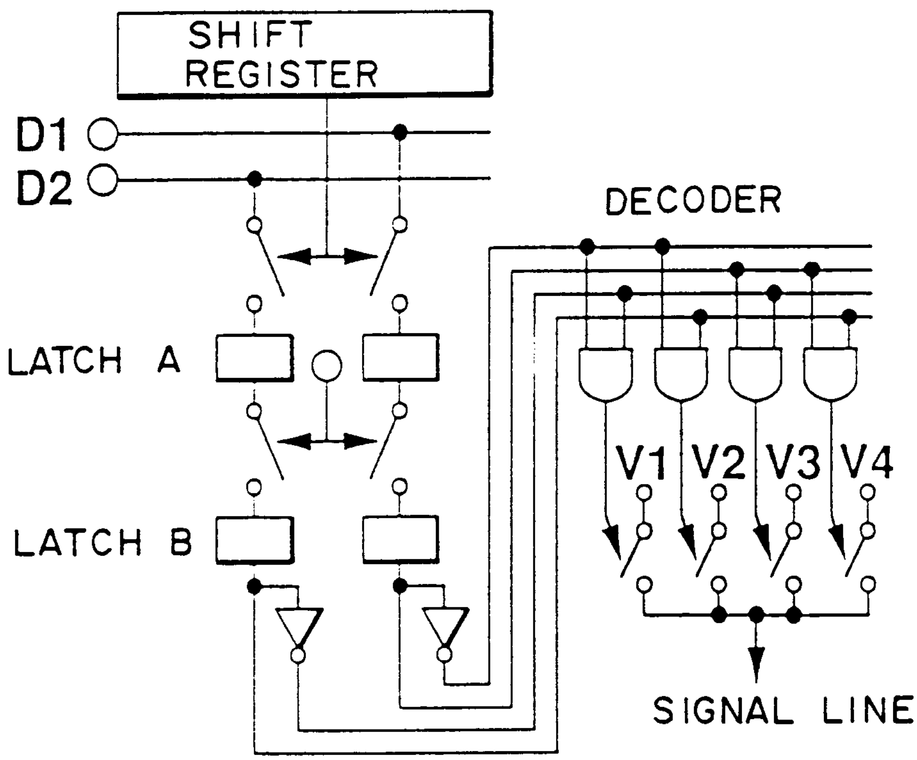
SHIFT REGISTER
D1
D2
DECODER
LATCH A
LATCH B
V1
V2
V3
V4
SIGNAL LINE

FIG. 54

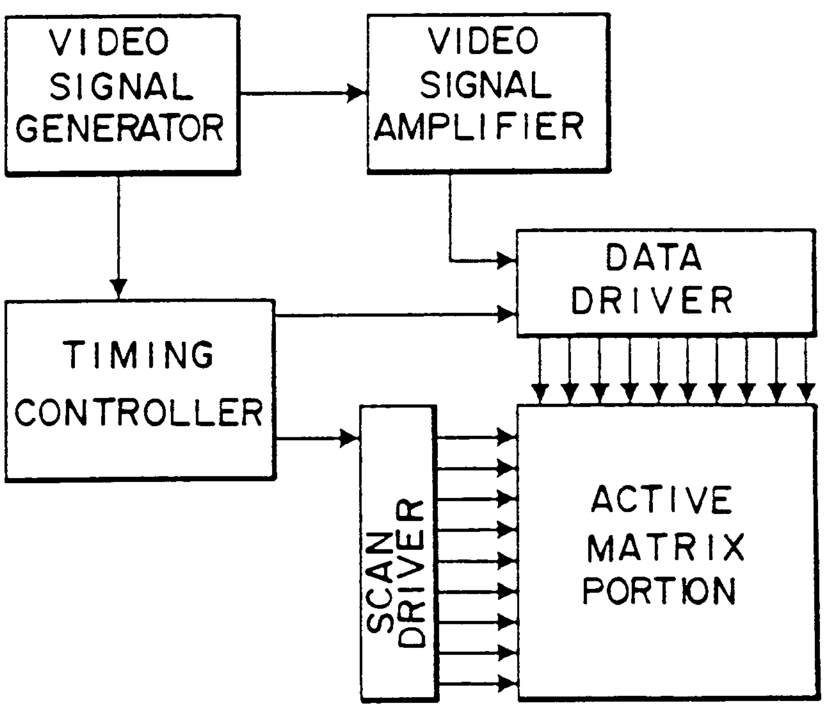
VIDEO SIGNAL GENERATOR
VIDEO SIGNAL AMPLIFIER
DATA DRIVER
TIMING CONTROLLER
SCAN DRIVER
ACTIVE MATRIX PORTION

FIG. 55

| | CARRIER MOBILITY $\mu$ ($cm^2/V \cdot sec$) | ON CURRENT I (A) \|Vds\|=4V, W=5$\mu$m \|Vgs\|=10V |
|---|---|---|
| AMORPHOUS TFT (ORDINARY STRUCTURE) | 0.1 ~ 1 | $10^{-7}$ (L=5$\mu$m) |
| POLYCRYSTALLINE TFT (ORDINARY STRUCTURE) | 10 ~ 20 | $1 \times 10^{-5}$ (L=5$\mu$m) |
| POLYCRYSTALLINE TFT (LDD STRUCTURE) | 10 ~ 20 | $2 \times 10^{-5}$ (L=2.5$\mu$m) |
| PRESENT EMBODIMENT (ORDINARY STRUCTURE) | 100 ~ 150 | $10^{-4}$ (L=5$\mu$m) |
| PRESENT EMBODIMENT (LDD STRUCTURE) | 200 ~ 300 | $2 \sim 3 \times 10^{-4}$ (L=2.5$\mu$m) |
| SINGLE-CRYSTAL MOSFET | 500~600 | $10^{-3}$ (L=2.5$\mu$m) |

FIG. 56A

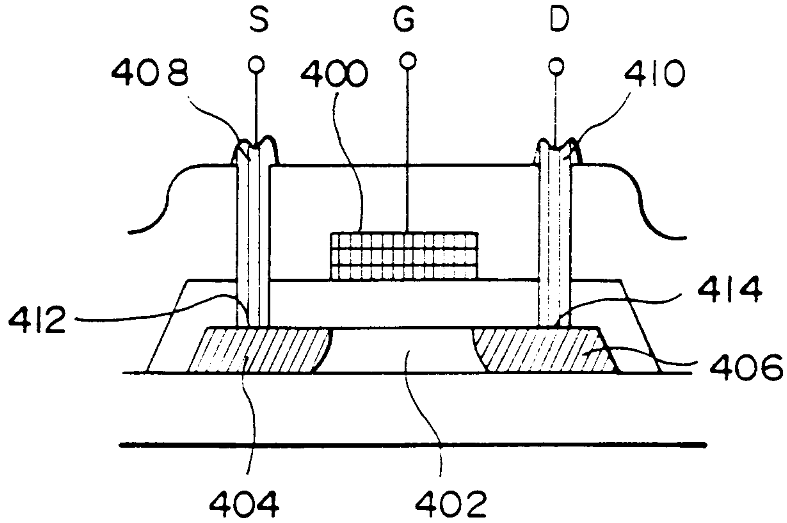


FIG. 56B

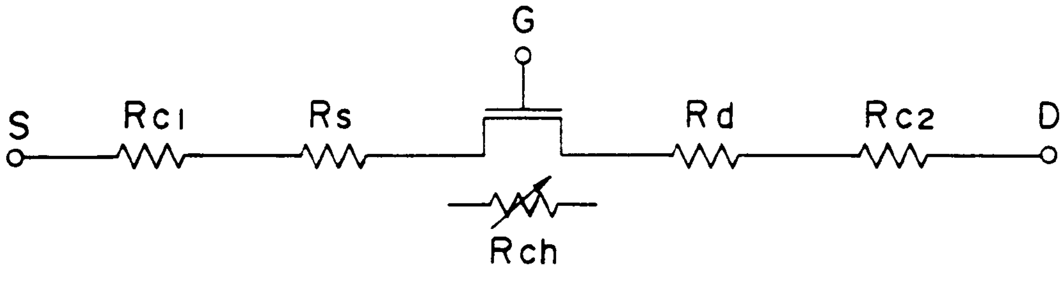

## INTERNATIONAL SEARCH REPORT

International application No. PCT/JP94/01229

**A. CLASSIFICATION OF SUBJECT MATTER**

Int. $Cl^6$ H01L29/786, H01L21/205, G02F1/136, 500

According to International Patent Classification (IPC) or to both national classification and IPC

**B. FIELDS SEARCHED**

Minimum documentation searched (classification system followed by classification symbols)

Int. $Cl^5$ H01L29/784, H01L21/205, G02F1/136, 500

Documentation searched other than minimum documentation to the extent that such documents are included in the fields searched

Jitsuyo Shinan Koho 1972 - 1994
Kokai Jitsuyo Shinan Koho 1972 - 1994

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP, A, 63-239936 (Canon Inc.), October 5, 1988 (05. 10. 88), Claim, (Family: none) | 19-21, 59-67 |
| A | | 1-18, 68-72 |
| Y | JP, A, 5-72555 (Seiko Epson Corp.), March 26, 1993 (26. 03. 93), Line 9, column 2 to line 33, column 4, (Family: none) | 22-29, 32-57, 59-67 |
| Y | JP, A, 63-66969 (Nippon Telegraph & Telephone Corp.), March 25, 1988 (25. 03. 88), Claim, (Family: none) | 22-29, 32-38, 42, 43, 61, 62 |
| Y | JP, A, 2-246277 (Matsushita Electronics Corp.), October 2, 1990 (02. 10. 90), Fig. 2, (Family: none) | 38, 40 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| October 5, 1994 (05. 10. 94) | October 25, 1994 (25. 10. 94) |
| Name and mailing address of the ISA/ Japanese Patent Office | Authorized officer |
| Facsimile No. | Telephone No. |

## INTERNATIONAL SEARCH REPORT

International application No.
PCT/JP94/01229

C (Continuation). DOCUMENTS CONSIDERED TO BE RELEVANT

| Category* | Citation of document, with indication, where appropriate, of the relevant passages | Relevant to claim No. |
|---|---|---|
| EX | JP, A, 5-275701 (Sony Corp.), October 22, 1993 (22. 10. 93), Line 40, column 4 to line 42, column 6, (Family: none) | 37 |
| A | JP, A, 3-243771 (Nippon Sheet Glass Co., Ltd.), October 30, 1991 (30. 10. 91), Claim, (Family: none) | 1-18, 68-72 |